# EUROPEAN PATENT SPECIFICATION

(11) **EP 3 425 689 B1**
(45) Date of publication and mention of the grant of the patent: **23.10.2019**
(21) Application number: 17759878.6
(22) Date of filing: 27.02.2017
(51) Int. Cl.: H01L 51/54, C07F 5/02

(54) **CHARGE-TRANSPORTING VARNISH**
LADUNGSTRANSPORTLACK
VERNIS À TRANSFERT DE CHARGE

(30) Priority: 03.03.2016 JP 2016041007
(43) Date of publication of application: 09.01.2019
(73) Proprietor: Nissan Chemical Corporation, Tokyo 103-6119 (JP)
(72) Inventor: NAKAIE Naoki, Funabashi-shi Chiba 274-0052 (JP); TAKAYAMA Yuki, Funabashi-shi Chiba 274-0052 (JP)
(74) Representative: Mewburn Ellis LLP
(86) International application number: PCT/JP2017/007356
(87) International publication number: WO 2017/150412

(56) References cited:
- EP-A1- 2 838 129
- WO-A1-2005/089024
- WO-A1-2013/052096
- WO-A1-2015/050253
- JP-A- 2005 314 682
- JP-A- 2005 336 314
- JP-A- 2014 205 624

## Description

### TECHNICAL FIELD

The present invention relates to a charge-transporting varnish.

### BACKGROUND ART

Charge-transporting thin films made of organic compounds are used as light-emitting layers or charge-injecting layers in organic electroluminescent (EL) devices. In particular, a hole-injecting layer is responsible for transferring charge between an anode and a hole-transporting layer or a light-emitting layer, and thus serves an important function in achieving low-voltage driving and high brightness in organic EL devices.

Processes for forming hole-injecting layers are broadly divided into dry processes such as vapor deposition and wet processes such as spin coating. On comparing these types of processes, wet processes are better able to efficiently produce thin films having a high flatness over a large surface area. Therefore, as organic EL displays of increasingly large surface area are being developed, there exists a desire today for hole-injecting layers that can be formed by wet processes.

In light of such circumstances, the inventors have developed charge-transporting materials which are applicable to various wet processes and moreover provide thin films that, when used as a hole-injecting layer in an organic EL device, enable excellent EL device characteristics to be attained. The inventors have also developed compounds which have a good solubility in the organic solvents used in such materials (see, for example, Patent Documents 1 to 5).

Charge transporting varnishes comprising an electron-accepting compound, a borate salt and an organic solvent are disclosed in Patent Documents 6 and 7.

However, improvements in wet process materials for hole-injecting layers are constantly being sought. In particular, there is a desire for a wet process material that gives thin films of excellent charge transportability.

### PRIOR ART DOCUMENTS

### PATENT DOCUMENTS

Patent Document 1: WO 2008/032616
Patent Document 2: WO 2008/129947
Patent Document 3: WO 2006/025342
Patent Document 4: WO 2010/058777
Patent Document 5: JP-A 2014-205624
Patent Document 6: EP 2 838 129 A1
Patent Document 7: WO 2013/052096 A1

### SUMMARY OF INVENTION

### TECHNICAL PROBLEM

It is therefore an object of the invention to provide a charge-transporting varnish which reproducibly gives charge-transporting thin films of excellent charge transportability, flatness and uniformity.

### SOLUTION TO PROBLEM

The inventors have conducted extensive investigations in order to achieve the above object. As a result, they have discovered that charge-transporting thin films of excellent charge transportability, flatness and uniformity can be reproducibly obtained from a varnish prepared by dissolving a charge-transporting substance and a specific onium borate salt in an organic solvent, and that organic EL devices of excellent brightness characteristics can be obtained by using such a thin film as a hole-injecting layer.

Accordingly, the invention provides:
1. A charge-transporting varnish comprising a charge-transporting substance, an onium borate salt and an organic solvent, wherein the onium borate salt includes an onium borate salt consisting of an anion of formula (a1) and a countercation 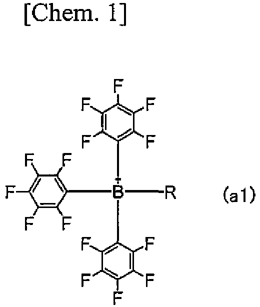 (wherein R is an alkyl group of 1 to 10 carbon atoms, a fluoroalkyl group of 1 to 10 carbon atoms, an aralkyl group of 7 to 10 carbon atoms or a fluoroaralkyl group of 7 to 10 carbon atoms);
2. The charge-transporting varnish of 1 above, wherein the charge-transporting substance is at least one compound selected from the group consisting of aniline derivatives and thiophene derivatives;
3. The charge-transporting varnish of 2 above, wherein the charge-transporting substance is an aniline derivative;
4. A charge-transporting thin film produced using the charge-transporting varnish of any of 1 to 3 above;
5. An organic electroluminescent device comprising the charge-transporting thin film of 4 above; and
6. A method for producing a charge-transporting thin film, comprising the steps of applying the charge-transporting varnish of any of 1 to 3 above onto a substrate, and evaporating off the solvent.

### ADVANTAGEOUS EFFECTS OF INVENTION

By using the charge-transporting varnish of the invention, a charge-transporting thin film of excellent charge transportability, flatness and uniformity can be obtained.

Also, charge-transporting thin films having such properties can be advantageously used as thin films for organic EL devices and other electronic devices. In particular, by employing this thin film as the hole-injecting layer in an organic EL device, it is possible to obtain an organic EL device having a low driving voltage.

In addition, the charge-transporting varnish of the invention can reproducibly form thin films of excellent charge transportability even when using various wet processes capable of forming a film over a large surface area, such as spin coating or slit coating, and thus is capable of fully accommodating also recent advances in the field of organic EL devices.

Furthermore, because the thin film obtained from the charge-transporting varnish of the invention has an excellent charge transportability, use as, for example, an anode buffer layer in organic thin-film solar cells and as an antistatic film is also anticipated.

### DESCRIPTION OF EMBODIMENTS

The invention is described below in greater detail.

The charge-transporting varnish of the invention includes a charge-transporting substance, an onium borate salt and an organic solvent. The onium borate salt includes an onium borate salt consisting of an anion of formula (a1) and a countercation.

As used herein, "charge transportability" is synonymous with electrical conductivity, and is also synonymous with hole transportability. The charge-transporting varnish of the invention may itself have charge transportability, or a solid film obtained using the varnish may have charge transportability.

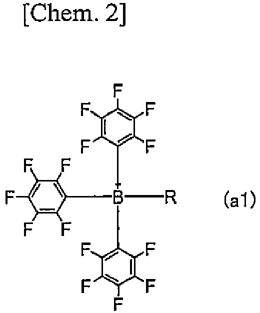

In formula (a1), R is an alkyl group of 1 to 10 carbon atoms, a fluoroalkyl group of 1 to 10 carbon atoms, an aralkyl group of 7 to 10 carbon atoms or a fluoroaralkyl group of 7 to 10 carbon atoms.

The alkyl group of 1 to 10 carbon atoms may be linear, branched or cyclic. Examples include linear or branched alkyl groups of 1 to 10 carbon atoms, such as methyl, ethyl, n-propyl, isopropyl, n-butyl, isobutyl, s-butyl, t-butyl, n-pentyl, n-hexyl, n-heptyl, n-octyl, n-nonyl and n-decyl groups; and cyclic alkyl groups of 3 to 10 carbon atoms, such as cyclopropyl, cyclobutyl, cyclopentyl, cyclohexyl, cycloheptyl, cyclooctyl, cyclononyl, cyclodecyl, bicyclobutyl, bicyclopentyl, bicyclohexyl, bicycloheptyl, bicyclooctyl, bicyclononyl and bicyclodecyl groups. An alkyl group of 1 to 8 carbon atoms is preferred, and an alkyl group of 1 to 6 carbon atoms is more preferred.

The aralkyl group of 7 to 10 carbon atoms is exemplified by alkyl groups in which at least one hydrogen atom is substituted with an aryl group. Examples include benzyl, 1-naphthylmethylene, 2-naphthylmethylene, phenylethylene, 1-naphthylethylene and 2-naphthylmethylene groups. An aralkyl group of 7 to 9 carbon atoms is preferred.

The fluoroalkyl groups of 1 to 10 carbon atoms is exemplified by alkyl groups of 1 to 10 carbon atoms in which at least one hydrogen atom is substituted with a fluorine atom.

Examples include fluoromethyl, difluoromethyl, trifluoromethyl, pentafluoroethyl, 2,2,2-trifluoroethyl, heptafluoropropyl, 2,2,3,3,3-pentafluoropropyl, 2,2,3,3-tetrafluoropropyl, 2,2,2-trifluoro-1-(trifluoromethyl)ethyl, nonafluorobutyl, 4,4,4-trifluorobutyl, undecafluoropentyl, 2,2,3,3,4,4,5,5,5-nonafluoropentyl, 2,2,3,3,4,4,5,5-octafluoropentyl, tridecafluorohexyl, 2,2,3,3,4,4,5,5,6,6,6-undecafluorohexyl, 2,2,3,3,4,4,5,5,6,6-decafluorohexyl and 3,3,4,4,5,5,6,6,6-nonafluorohexyl groups.

The fluoroaralkyl group of 7 to 10 carbon atoms is exemplified by aralkyl groups of 7 to 10 carbon atoms in which at least one hydrogen atom is substituted with a fluorine atom.

Examples include perfluorobenzyl, pentafluorophenylmethylene, heptafluoro-1-naphthylmethylene, heptafluoro-2-naphthylmethylene, heptafluoro-1-naphthylethylene and heptafluoro-2-naphthylethylene groups.

Alkylaryl borates that may be suitably used in the invention include, but are not limited to, that of the following formula.

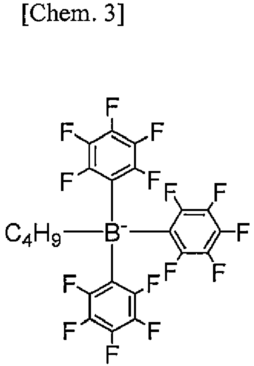

The countercation, although not particularly limited, is preferably a cation of formula (c1).

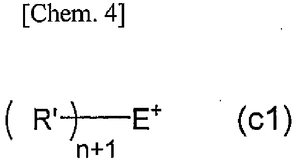

E in formula (c1) is a Group 15 to 17 element having a valence of n. Therefore, n represents an integer from 1 to 3 that corresponds to the valence of E.

The R' groups, n+1 of which bond to E, are each independently monovalent organic groups. Two or more R' groups may bond directly to each other or through -O-, -S-, -SO-, -SO₂-, -NH-, -CO-, -COO-, -CONH-, an alkylene group or a phenylene group to form a ring structure together with the element E.

The monovalent organic group, although not particularly limited, is preferably an alkyl group of 1 to 20 carbon atoms, an alkenyl group of 2 to 20 carbon atoms, an alkynyl group of 2 to 20 carbon atoms, or an aryl group of 6 to 20 carbons which may be substituted with Z; and more preferably an aryl group of 6 to 14 carbon atoms which may be substituted with Z.

The alkyl group of 1 to 20 carbon atoms may be linear, branched or cyclic. Examples include, in addition to the above-mentioned alkyl groups of 1 to 10 carbon atoms, n-undecyl, n-dodecyl, n-tridecyl, n-tetradecyl, n-pentadecyl, n-hexadecyl, n-heptadecyl, n-octadecyl, n-nonadecyl, and n-eicosanyl groups. Alkyl groups of 1 to 18 carbon atoms are preferred, and alkyl groups of 1 to 8 carbon atoms are more preferred.

Examples of alkenyl groups of 2 to 20 carbon atoms include ethenyl, n-1-propenyl, n-2-propenyl, 1-methylethenyl, n-1-butenyl, n-2-butenyl, n-3-butenyl, 2-methyl-1-propenyl, 2-methyl-2-propenyl, 1-ethylethenyl, 1-methyl-1-propenyl, 1-methyl-2-propenyl, n-1-pentenyl, n-1-decenyl and n-1-eicosenyl groups.

Examples of alkynyl groups of 2 to 20 carbon atoms include ethynyl, n-1-propynyl, n-2-propynyl, n-1-butynyl, n-2-butynyl, n-3-butynyl, 1-methyl-2-propynyl, n-1-pentynyl, n-2-pentynyl, n-3-penynyl, n-4-pentynyl, 1-methyl-n-butynyl, 2-methyl-n-butynyl, 3-methyl-n-butynyl, 1,1-dimethyl-n-propynyl, n-1-hexynyl, n-1-decynyl, n-1-pentadecynyl and n-1-eicosynyl groups.

Examples of aryl groups of 6 to 20 carbon atoms include phenyl, 1-naphthyl, 2-naphthyl, 1-anthryl, 2-anthryl, 9-anthry, 1-phenanthryl, 2-phenanthryl, 3-phenanthryl, 4-phenanthryl and 9-phenanthryl groups. An aryl group of 6 to 14 carbons is preferred.

Z represents an alkyl group of 1 to 20 carbon atoms, a haloalkyl group of 1 to 8 carbon atoms, an alkenyl group of 2 to 20 carbon atoms, an alkynyl group of 2 to 20 carbon atoms, an aryl group of 6 to 20 carbon atoms, a heteroaryl group of 2 to 20 carbon atoms, a nitro group, a hydroxyl group, a cyano group, an alkoxy group of 1 to 8 carbon atoms, an aryloxy group of 6 to 20 carbon atoms, an acyl group of 1 to 20 carbon atoms, an acyloxy group of 1 to 20 carbon atoms, an alkylthio group of 1 to 8 carbon atoms, an arylthio group of 6 to 20 carbon atoms, a di-C₁₋₈ alkylamino group, a di-C₆₋₂₀ arylamino group, an amino group or a halogen atom.

These alkyl, alkenyl, alkynyl and aryl groups are exemplified in the same way as above.

Examples of the halogen atom include fluorine, chlorine, bromine and iodine atoms. A fluorine atom is preferred.

Examples of heteroaryl groups of 2 to 20 carbon atoms include oxygen-containing heteroaryl groups such as 2-thienyl, 3-thienyl, 2-furanyl, 3-furanyl, 2-oxazolyl, 4-oxazolyl, 5-oxazolyl, 3-isooxazolyl, 4-isooxazolyl and 5-isooxazolyl groups; sulfur-containing heteroaryl groups such as 2-thiazolyl, 4-thiazolyl, 5-thiazolyl, 3-isothiazolyl, 4-isothiazolyl and 5-isothiazolyl groups; and nitrogen-containing heteroaryl groups such as 2-imidazolyl, 4-imidazolyl, 2-pyridyl, 3-pyridyl, 4-pyridyl, 2-pyrazyl, 3-pyrazyl, 5-pyrazyl, 6-pyrazyl, 2-pyrimidyl, 4-pyrimidyl, 5-pyrimidyl, 6-pyrimidyl, 3-pyridazyl, 4-pyridazyl, 5-pyridazyl, 6-pyridazyl, 1,2,3-triazin-4-yl, 1,2,3-triazin-5-yl, 1,2,4-triazin-3-yl, 1,2,4-triazin-5-yl, 1,2,4-triazin-6-yl, 1,3,5-triazin-2-yl, 1,2,4,5-tetrazin-3-yl, 1,2,3,4-tetrazin-5-yl, 2-quinolinyl, 3-quinolinyl, 4-quinolinyl, 5-quinolinyl, 6-quinolinyl, 7-quinolinyl, 8-quinolinyl, 1-isoquinolinyl, 3-isoquinolinyl, 4-isoquinolinyl, 5-isoquinolinyl, 6-isoquinolinyl, 7-isoquinolinyl, 8-isoquinolinyl, 2-quinoxanyl, 5-quinoxanyl, 6-quinoxanyl, 2-quinazolinyl, 4-quinazolinyl, 5-quinazolinyl, 6-quinazolinyl, 7-quinazolinyl, 8-quinazolinyl, 3-cinnolinyl, 4-cinnolinyl, 5-cinnolinyl, 6-cinnolinyl, 7-cinnolinyl and 8-cinnolinyl groups.

Examples of haloalkyl groups of 1 to 8 carbon atoms include, of the above-mentioned alkyl groups, those groups in which at least one hydrogen atom on an alkyl group of 1 to 8 carbon atoms is substituted with a halogen atom. The halogen atom may be a chlorine, bromine, iodine or fluorine atom. Fluoroalkyl groups are preferred, and perfluoroalkyl groups are more preferred.

The fluoroalkyl groups are exemplified in the same way as above.

Examples of alkoxy groups of 1 to 8 carbon atoms include methoxy, ethoxy, n-propoxy, i-propoxy, c-propoxy, n-butoxy, i-butoxy, s-butoxy, t-butoxy, n-pentoxy, n-hexoxy, n-heptyloxy and n-octyloxy groups.

Examples of aryloxy groups of 6 to 20 carbon atoms include phenoxy, 1-naphthyloxy, 2-naphthyloxy, 1-anthryloxy, 2-anthryloxy, 9-anthryloxy, 1-phenanthryloxy, 2-phenanthryloxy, 3-phenanthryloxy, 4-phenanthryloxy and 9-phenanthryloxy groups.

Examples of acyl groups of 1 to 20 carbon atoms include formyl, acetyl, propionyl, butyryl, isobutyryl, valeryl, isovaleryl and benzoyl groups.

Examples of acyloxy groups of 1 to 20 carbon atoms include formyloxy, acetoxy, propionyloxy, butyryloxy, isobutyryloxy, valeryloxy, isovaleryloxy and benzoyloxy groups.

Examples of alkylthio groups of 1 to 8 carbon atoms include methylthio, ethylthio, n-propylthio, isopropylthio, n-butylthio, isobutylthio, s-butylthio, t-butylthio, n-pentylthio, n-hexylthio, n-heptylthio and n-octylthio groups.

Examples of arylthio groups of 6 to 20 carbons include phenylthio, 1-naphthylthio, 2-naphthylthio, 1-anthrylthio, 2-anthrylthio, 9-anthrylthio, 1-phenanthrylthio, 2-phenanthrylthio, 3-phenanthrylthio, 4-phenanthrylthio and 9-phenanthrylthio groups.

Examples of di-C₁₋₈ alkylamino groups include dimethylamino, diethylamino, di-n-propylamino, di-i-propylamino, di-n-butylamino, di-i-butylamino, di-n-pentylamino, di-n-hexylamino, di-n-heptylamino, di-n-octylamino and methylethylamino groups.

Examples of di-C₆₋₂₀ arylamino groups include diphenylamino, 1-naphthylphenylamino, di(1-naphthyl)amino, 1-naphthyl-2-naphthylamino and di(2-naphthyl)amino groups.

As for E above, of the Group 15 to 17 elements, O (oxygen), N (nitrogen), P (phosphorus), S (sulfur) and I (iodine) are preferred. S, I, N and P, which give onium ions that are stable and easy to handle, are more preferred; and S and I are even more preferred. The corresponding onium ions are oxonium, ammonium, phosphonium, sulfonium and iodonium.

The onium ion represented by (R')ₙ₊₁-E⁺ above is exemplified by, but not limited to, the following.

Exemplary oxonium ions include oxonium ions such as trimethyloxonium, diethylmethyloxonium, triethyloxonium and tetramethylenemethyloxonium; pyridinium ions such as 4-methylpyridinium, 2,4,6-trimethylpyridinium, 2,6-di-t-butylpyridinium and 2,6-diphenylpyridinium; and chromenium and isochromenium ions such as 2,4-dimethylchromium and 1,3-dimethylisochromenium.

Examples of ammonium ions include tetraalkylammonium ions such as tetramethylammonium, ethyltrimethylammonium, diethyldimethylammonium, triethylmethylammonium and tetraethylammonium; pyrrolidinium ions such as N,N-dimethylpyrrolidinium, N-ethyl-N-methylpyrrolidinium and N,N-diethylpyrrolidinium; imidazolinium ions such as N,N'-dimethylimidazolinium, N,N'-diethylimidazolinium, N-ethyl-N'-methylimidazolinium, 1,3,4-trimethylimidazolinium and 1,2,3,4-tetramethylimidazolinium; tetrahydropyrimidinium ions such as N,N'-dimethyltetrahydropyrimidinium; morpholinium ions such as N,N'-dimethylmorpholinium; piperidinium ions such as N,N'-diethylpiperidinium; pyridinium ions such as N-methylpyridinium, N-benzylpyridinium and N-phenacylpyridinium; imidazolium ions such as N,N'-dimethylimidazolium; quinolium ions such as N-methylquinolium, N-benzylquinolium and N-phenacylquinolium; isoquinolium ions such as N-methylisoquinolium; thiazonium ions such as benzylbenzothiazonium and phenacylbenzothiazonium; and acridinium ions such as benzylacridinium and phenacylacridinium.

Examples of phosphonium ions include tetraarylphosphonium ions such as tetraphenylphosphonium, tetra-p-tolylphosphonium, tetrakis(2-methoxyphenyl)phosphonium, tetrakis(3-methoxyphenyl)phosphonium and tetrakis(4-methoxyphenyl)phosphonium; triarylphosphonium ions such as triphenylbenzylphosphonium, triphenylphenacylphosphonium, triphenylmethylphosphonium and triphenylbutylphosphonium; and tetraalkylphosphonium ions such as triethylbenzylphosphonium, tributylbenzylphosphonium, tetraethylphosphonium, tetrabutylphosphonium, tetrahexylphosphonium, triethylphenacylphosphonium and tributylphenacylphosphonium.

Examples of sulfonium ions include triarylsulfonium ions such as triphenylsulfonium, tri-p-tolylsulfonium, tri-o-tolylsulfonium, tris(4-methoxyphenyl)sulfonium, 1-naphthyldiphenylsulfonium, 2-napthyldiphenylsulfonium, tris(4-fluorophenyl)sulfonium, tri-1-naphthylsulfonium, tri-2-naphthylsulfonium, tris(4-hydroxyphenyl)sulfonium, 4-(phenylthio)phenyldiphenylsulfonium, 4-(p-tolylthio)phenyldi-p-tolylsulfonium, 4-(4-methoxyphenylthio)phenylbis(4-methoxyphenyl)sulfonium, 4-(phenylthio)phenylbis(4-fluorophenyl)sulfonium, 4-(phenylthio)phenylbis(4-methoxyphenyl)sulfonium, 4-(phenylthio)phenyldi-p-tolylsulfonium, [4-(4-biphenylylthio)phenyl]-4-biphenylylphenylsulfonium, [4-(2-thioxanthonylthio)phenyl]diphenylsulfonium, bis [4-(diphenylsulfonio)phenyl]sulfide, bis[4-{bis[4-(2-hydroxyethoxy)phenyl]sulfoniolphenyllsulfide, bis{4-[bis(4-fluorophenyl)sulfonio]phenyl}sulfide, bis{4-[bis(4-methylphenyl)sulfonio]phenyl}sulfide, bis{4-[bis(4-methoxyphenyl)sulfonio]phenyl}sulfide, 4-(4-benzoyl-2-chlorophenylthio)phenylbis(4-fluorophenyl)sulfonium, 4-(4-benzoyl-2-chlorophenylthio)phenyldiphenylsulfonium, 4-(4-benzoylphenylthio)phenylbis(4-fluorophenyl)sulfonium, 4-(4-benzoylphenylthio)phenyldiphenylsulfonium, 7-isopropyl-9-oxo-10-thia-9,10-dihydroanthracen-2-yldi-p-tolylsulfonium, 7-isopropyl-9-oxo-10-thia-9,10-dihydroanthracen-2-yldiphenylsulfonium, 2-[(di-p-tolyl)sulfonio]thioxanthone, 2-[(diphenyl)sulfonio]thioxanthone, 4-(9-oxo-9H-thioxanthen-2-yl)thiophenyl-9-oxo-9H-thioxanthen-2-ylphenylsulfonium, 4-[4-(4-t-butylbenzoyl)phenylthio]phenyldi-p-tolylsulfonium, 4-[4-(4-t-butylbenzoyl)phenylthio]phenyldiphenylsulfonium, 4-[4-(benzoylphenylthio)]phenyldi-p-tolylsulfonium, 4-[4-(benzoylphenylthio)]phenyldiphenylsulfonium, 5-(4-methoxyphenyl)thianthrenium, 5-phenylthianthrenium, 5-tolylthianthrenium, 5-(4-ethoxyphenyl)thianthrenium and 5-(2,4,6-trimethylphenyl)thianthrenium; diarylsulfonium ions such as diphenylphenacylsulfonium, diphenyl-4-nitrophenacylsulfonium, diphenylbenzylsulfonium and diphenylmethylsulfonium; monoarylsulfonium ions such as phenylmethylbenzylsulfonium, 4-hydroxyphenylmethylbenzylsulfonium, 4-methoxyphenylmethylbenzylsulfonium, 4-acetocarbonyloxyphenylmethylbenzylsulfonium, 4-hydroxyphenyl(2-naphthylmethyl)methylsulfonium, 2-naphthylmethylbenzylsulfonium, 2-naphthylmethyl(1-ethoxycarbonyl)ethylsulfonium, phenylmethylphenacrylsulfonium, 4-hydroxyphenylmethylphenancylsulfonium, 4-methoxyphenylmethylphenacylsulfonium, 4-acetocarbonyloxyphenylmethylphenacylsulfonium, 2-naphthylmethylphenacylsulfonium, 2-naphthyloctadecylphenacylsulfonium and 9-anthracenylmethylphenacylsulfonium; and trialkylsulfonium ions such as dimethylphenacylsulfonium, phenacyltetrahydrothiophenium, dimethylbenzylsulfonium, benzyltetrahydrothiophenium and octadccylmethylphenacylsulfonium.

Examples of iodonium ions include diphenyliodonium, di-p-tolyliodonium, bis(4-dodecylphenyl)iodonium, bis(4-methoxyphenyl)iodonium, (4-octyloxyphenyl)phenyliodonium, bis(4-decyloxy)phenyliodonium, 4-(2-hydroxytetradecyloxy)phenylphenyliodonium, 4-isopropylphenyl(p-tolyl)iodonium and 4-isobutylphenyl(p-tolyl)iodonium.

In this invention, the onium borate salt may be of one type used alone or two or more may be used in combination.

Also, where necessary, other known onium borate salts may be concomitantly used.

The onium borate salt may be synthesized by a known method such as that described in, for example, JP-A 2014-205624.

To facilitate dissolution in the charge-transporting varnish, the onium borate salt may first be dissolved in an organic solvent.

Examples of such organic solvents include carbonates such as propylene carbonate, ethylene carbonate, 1,2-butylene carbonate, dimethyl carbonate and diethyl carbonate; ketones such as acetone, methyl ethyl ketone, cyclohexanone, methyl isoamyl ketone and 2-heptanone; polyhydric alcohols and derivatives thereof, such as ethylene glycol, ethylene glycol monoacetate, diethylene glycol, diethylene glycol monoacetate, propylene glycol, propylene glycol monoacetate, dipropylene glycol, dipropylene glycol monoacetate and the monomethyl, monoethyl, monopropyl, monobutyl and monophenyl ethers thereof; cyclic ethers such as dioxane; esters such as ethyl formate, methyl lactate, ethyl lactate, methyl acetate, ethyl acetate, butyl acetate, methyl pyruvate, methyl acetoacetate, ethyl acetoacetate, ethyl pyruvate, ethyl ethoxyacetate, methyl methoxypropionate, ethyl ethoxypropionate, methyl 2-hydroxypropionate, ethyl 2-hydroxypropionate, ethyl 2-hydroxy-2-methylpropionate, methyl 2-hydroxy-3-methylbutanoate, 3-methoxybutyl acetate and 3-methyl-3-methoxybutyl acetate; and aromatic hydrocarbons such as toluene and xylene. These may be used singly or two or more may be used in admixture.

When an organic solvent is used, the amount of use thereof per 100 parts by weight of the onium borate salt is preferably from 15 to 1,000 parts by weight, and more preferably from 30 to 500 parts by weight.

The charge-transporting substance used in the invention is not particularly limited and may be suitably selected from among hitherto known charge-transporting substances in the field of organic EL devices and the like.

Examples include the following types of hole-transporting substances: arylamine derivatives such as oligoaniline derivatives, N,N'-diarylbenzidine derivatives and N,N,N',N'-tetraarylbenzidine derivatives; thiophene derivatives such as oligothiophene derivatives, thienothiophene derivatives and thienobenzothiophene derivatives; and pyrrole derivatives such as oligopyrrol. Of these, arylamine derivatives and thiophene derivatives are preferred, arylamine derivatives are more preferred, and aniline derivatives of formula (1) or (2) below are even more preferred.

The molecular weight of the charge-transporting substance is not particularly limited. From the standpoint of preparing a uniform varnish that gives thin films of high flatness, the molecular weight is preferably from 200 to 9,000. From the standpoint of obtaining a charge-transportability that has a high solvent resistance, the molecular weight is more preferably at least 300, and even more preferably at least 400. From the standpoint of preparing a uniform varnish that reproducibly gives thin films having a high flatness, the molecular weight is preferably not more than 8,000, more preferably not more than 7,000, even more preferably not more than 6,000, and still more preferably not more than 5,000.

To prevent separation of the charge-transporting substance when forming a thin film, it is preferable for the charge-transporting substance to have no molecular weight distribution (a polydispersity of 1); that is, it is preferable for the charge-transporting substance to have a single molecular weight.

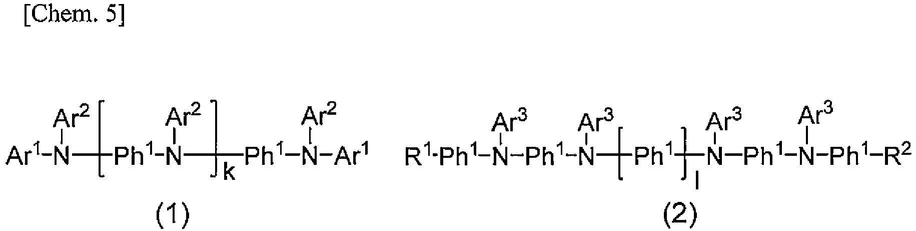

In formula (2), R¹ and R² are each independently a hydrogen atom, a halogen atom, a nitro group, a cyano group, or an alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom. These are exemplified in the same way as the groups described above for formula (c1).

Of these, R¹ and R² are preferably hydrogen atoms, fluorine atoms, cyano groups, alkyl groups of 1 to 20 carbon atoms that may be substituted with a halogen atom, aryl groups of 6 to 20 carbon atoms that may be substituted with a halogen atom, or heteroaryl groups of 2 to 20 carbon atoms that may be substituted with a halogen atom; more preferably hydrogen atoms, fluorine atoms, cyano groups, alkyl groups of 1 to 10 carbon atoms that may be substituted with a halogen atom, or phenyl groups that may be substituted with a halogen atom; even more preferably hydrogen atoms, fluorine atoms, methyl groups or trifluoromethyl groups; and most preferably hydrogen atoms.

Ph¹ in above formulas (1) and (2) represents a group of the formula (P1).

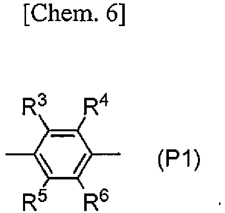

Here, R³ to R⁶ are each independently a hydrogen atom, a halogen atom, a nitro group, a cyano group, or an alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom. These are exemplified in the same way as the groups described above for formula (c1).

In particular, R³ to R⁶ are preferably hydrogen atoms, fluorine atoms, cyano groups, alkyl groups of 1 to 20 carbon atoms which may be substituted with a halogen atom, aryl groups of 6 to 20 carbon atoms which may be substituted with a halogen atom, or heteroaryl groups of 2 to 20 carbon atoms which may be substituted with a halogen atom; more preferably hydrogen atoms, fluorine atoms, cyano groups, alkyl groups of 1 to 10 carbon atoms which may be substituted with a halogen atom, or phenyl groups which may be substituted with a halogen atom; even more preferably hydrogen atoms, fluorine atoms, methyl groups or trifluoromethyl groups, and most preferably hydrogen atoms.

Preferred examples of Ph¹ include, but are not limited to, the following.

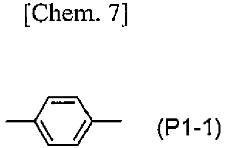

The Ar¹ groups in formula (1) are each independently a group of any of formulas (B1) to (B11), and preferably a group of any of formulas (B1') to (B11').

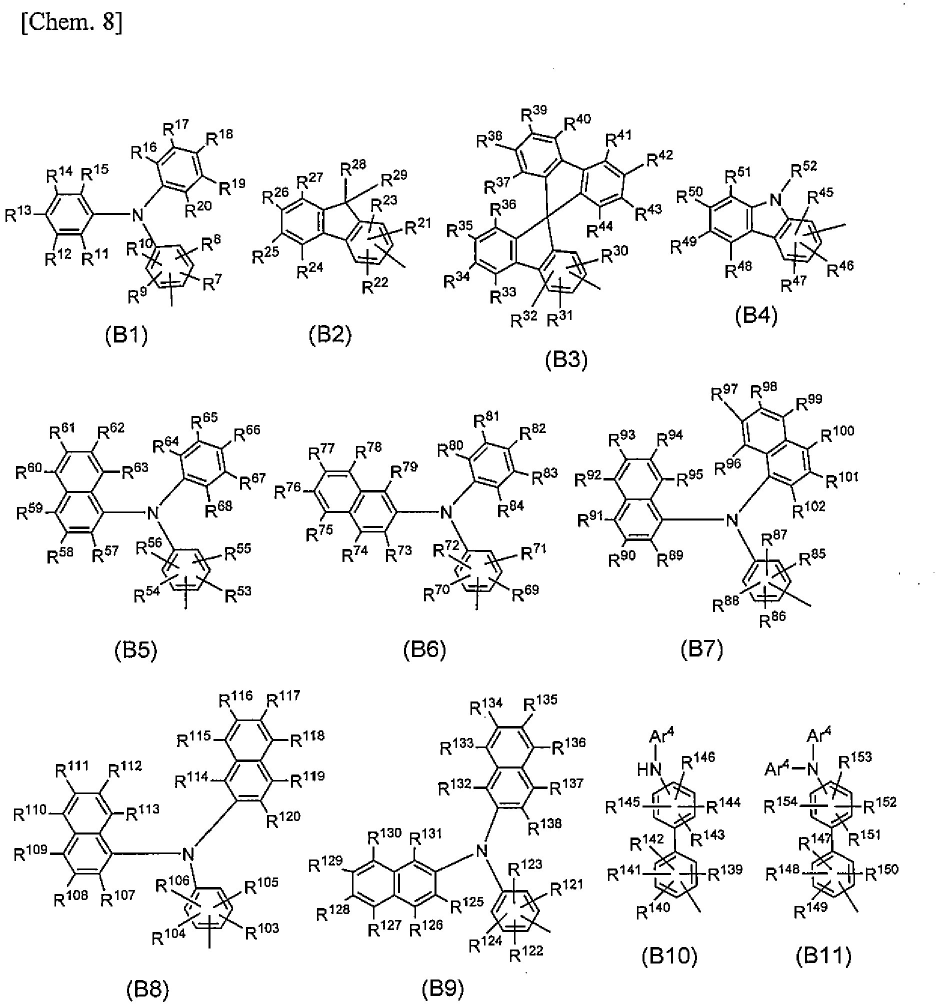

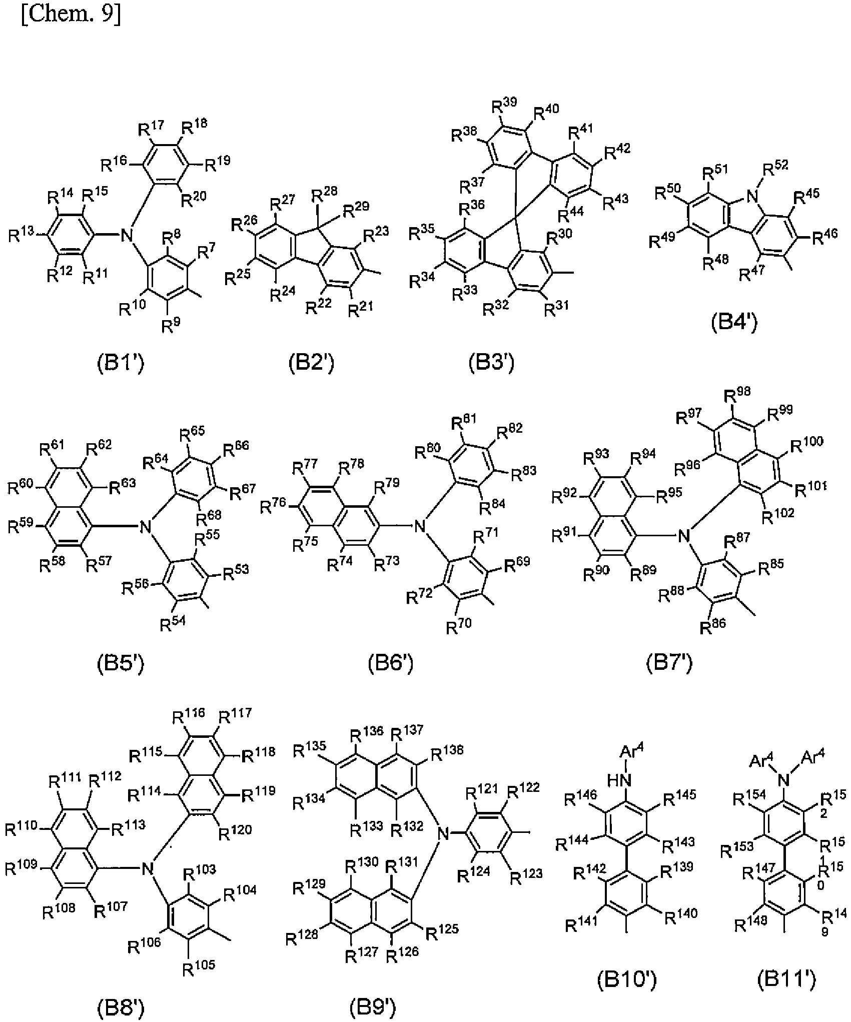

Here, R⁷ to R²⁷, R³⁰ to R⁵¹ and R⁵³ to R¹⁵⁴ are each independently a hydrogen atom, a halogen atom, a nitro group, a cyano group, or a diphenylamino group, alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms that may be substituted with a halogen atom. R²⁸ to R²⁹ are each independently an aryl group of 6 to 20 carbon atoms or heteroaryl group of 2 to 20 carbon atoms which may be substituted with Z¹; R⁵² is a hydrogen atom, an alkyl group of 1 to 20 carbon atoms, alkenyl group of 2 to 20 carbon atoms or alkynyl group of 2 to 20 carbon atoms which may be substituted with Z⁴, or an aryl group of 6 to 20 carbon atoms or heteroaryl group of 2 to 20 carbon atoms which may be substituted with Z¹; Z¹ is a halogen atom, a nitro group, a cyano group, or an alkyl group of 1 to 20 carbon atoms, alkenyl group of 2 to 20 carbon atoms or alkynyl group of 2 to 20 carbon atoms which may be substituted with Z²; Z² is a halogen atom, a nitro group, a cyano group, or an aryl group of 6 to 20 carbon atoms or heteroaryl group of 2 to 20 carbon atoms which may be substituted with Z³; Z³ is a halogen atom, a nitro group or a cyano group; Z⁴ is a halogen atom, a nitro group, a cyano group, or an aryl group of 6 to 20 carbon atoms or heteroaryl group of 2 to 20 carbon atoms which may be substituted with Z⁵; and Z⁵ is a halogen atom, a nitro group, a cyano group, or an alkyl group of 1 to 20 carbon atoms, alkenyl group of 2 to 20 carbon atoms or alkynyl group of 2 to 20 carbon atoms which may be substituted with Z³. These halogen atoms, alkyl groups of 1 to 20 carbon atoms, alkenyl groups of 2 to 20 carbon atoms, alkynyl groups of 2 to 20 carbon atoms, aryl groups of 6 to 20 carbon atoms and heteroaryl groups of 2 to 20 carbon atoms are exemplified in the same way as the groups described above for formula (c1).

In particular, R⁷ to R²⁷, R³⁰ to R⁵¹ and R⁵³ to R¹⁵⁴ are preferably hydrogen atoms, fluorine atoms, cyano groups, diphenylamino groups which may be substituted with halogen atoms, alkyl groups of 1 to 20 carbon atoms which may be substituted with halogen atoms, aryl groups of 6 to 20 carbon atoms which may be substituted with halogen groups, or heteroaryl groups of 2 to 20 carbon atoms which may be substituted with halogen atoms; more preferably hydrogen atoms, fluorine atoms, cyano groups, alkyl groups of 1 to 10 carbon atoms which may be substituted with halogen atoms, or phenyl groups which may be substituted with halogen atoms; even more preferably hydrogen atoms, fluorine atoms, methyl groups or trifluoromethyl groups; and most preferably hydrogen atoms.

R²⁸ and R²⁹ are preferably aryl groups of 6 to 14 carbon atoms which may be substituted with Z¹ or heteroaryl groups of 2 to 14 carbon atoms which may be substituted with Z¹; more preferably aryl groups of 6 to 14 carbon atoms which may be substituted with Z¹; and even more preferably phenyl groups which may be substituted with Z¹, 1-naphthyl groups which may be substituted with Z¹, or 2-naphthyl groups which may be substituted with Z¹.

R⁵² is preferably a hydrogen atom, an aryl group of 6 to 20 carbon atoms which may be substituted with Z¹, a heteroaryl group of 2 to 20 carbon atoms which may be substituted with Z¹, or an alkyl group of 1 to 20 carbon atoms which may be substituted with Z⁴; more preferably a hydrogen atom, an aryl group of 6 to 14 carbon atoms which may be substituted with Z¹, a heteroaryl group of 2 to 14 carbon atoms which may be substituted with Z¹, or an alkyl group of 1 to 10 carbon atoms which may be substituted with Z⁴; even more preferably a hydrogen atom, an aryl group of 6 to 14 carbon atoms which may be substituted with Z¹, a nitrogen-containing heteroaryl group of 2 to 14 carbon atoms which may be substituted with Z¹, or an alkyl group of 1 to 10 carbon atoms which may be substituted with Z⁴; and still more preferably a hydrogen atom, a phenyl group which may be substituted with Z¹, a 1-naphthyl group which may be substituted with Z¹, a 2-naphthyl group which may be substituted with Z¹, a 2-pyridyl group which may be substituted with Z¹, a 3-pyridyl group which may be substituted with Z¹, a 4-pyridyl group which may be substituted with Z¹, or a methyl group which may be substituted with Z⁴.

The Ar⁴ groups are each independently an aryl group of 6 to 20 carbon atoms which may be substituted with a di-C₆₋₂₀ arylamino group.

The aryl groups of 6 to 20 carbon atoms and di-C₆₋₂₀ arylamino groups are exemplified in the same way as the groups described above for formula (c1).

The Ar⁴ groups are preferably phenyl, 1-naphthyl, 2-naphthyl, 1-anthryl, 2-anthryl, 9-anthryl, 1-phenanthryl, 2-phenanthryl, 3-phenanthryl 4-phenanthryl, 9-phenanthryl, p-diphenylamino)phenyl, p-(1-naphthylphenylamino)phenyl, p-(di(1-naphthyl)amino)phenyl, p-(1-naphthyl-2-naphthylamino)phenyl or p-(di(2-naphthyl)amino)phenyl groups; and more preferably p-(diphenylamino)phenyl groups.

Preferred examples of Ar¹ groups include, but are not limited to, the following. 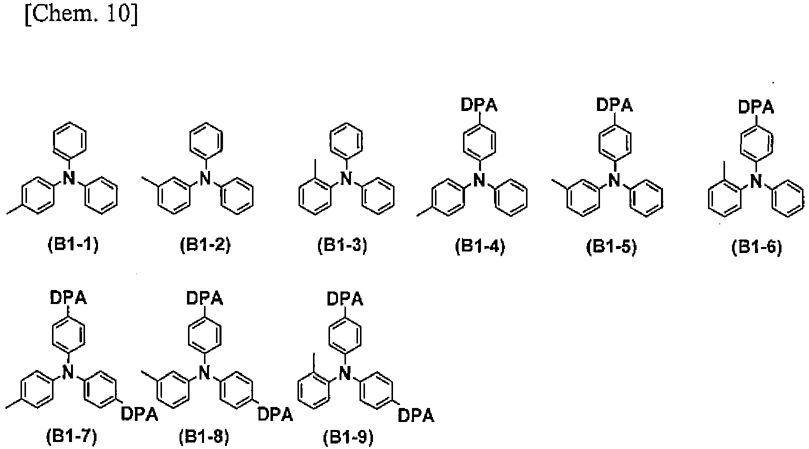 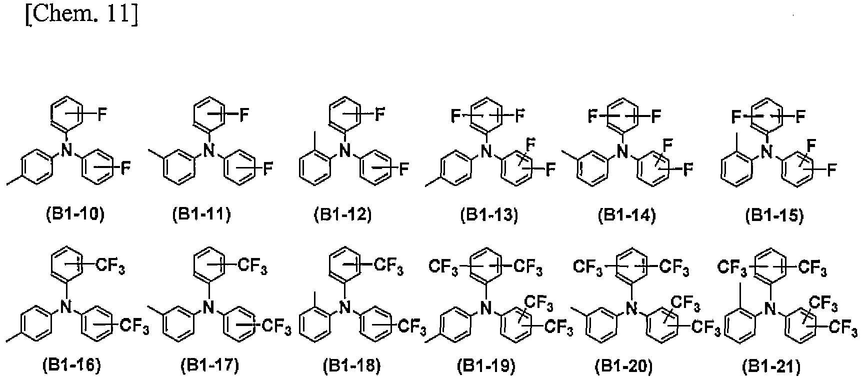 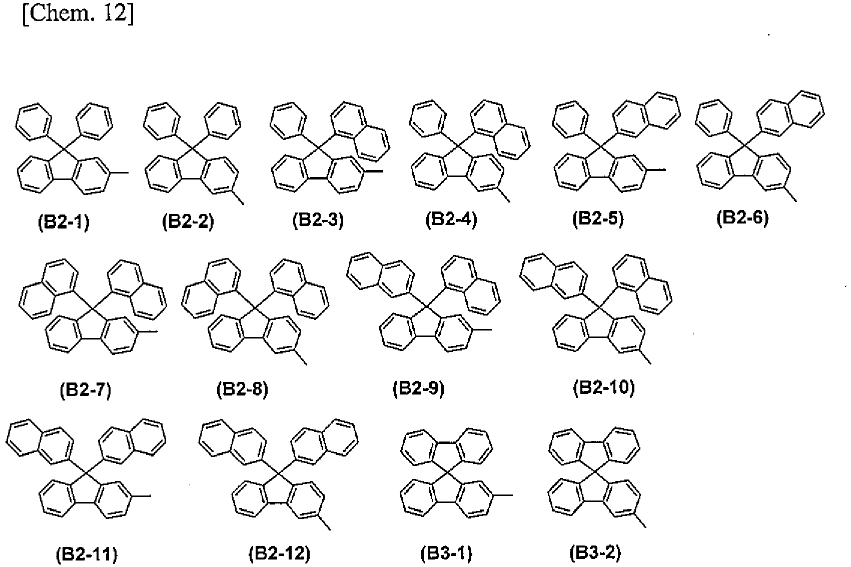 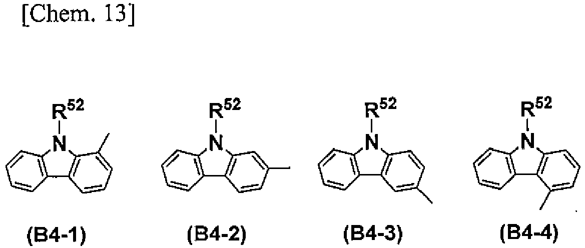 (wherein R⁵² is as defined above)

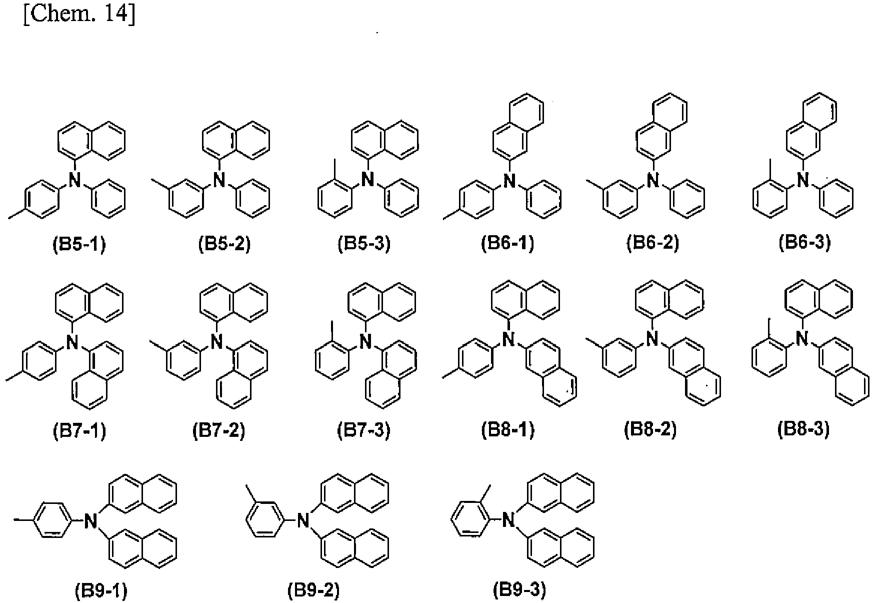

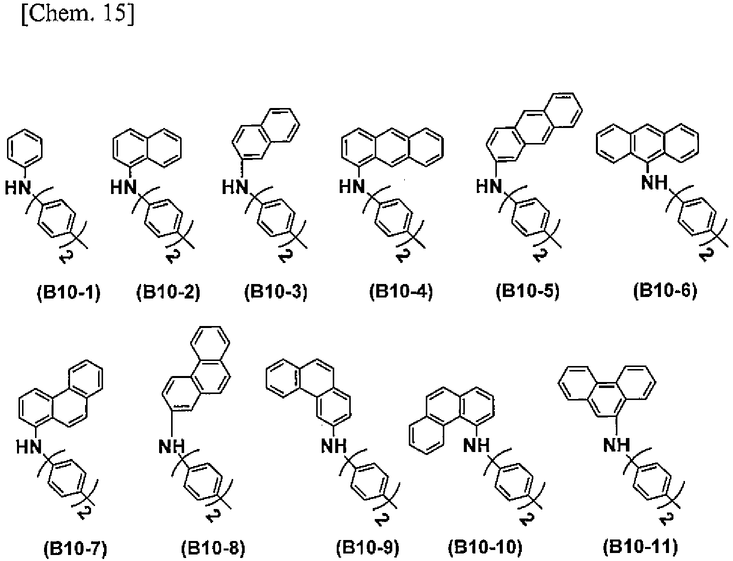

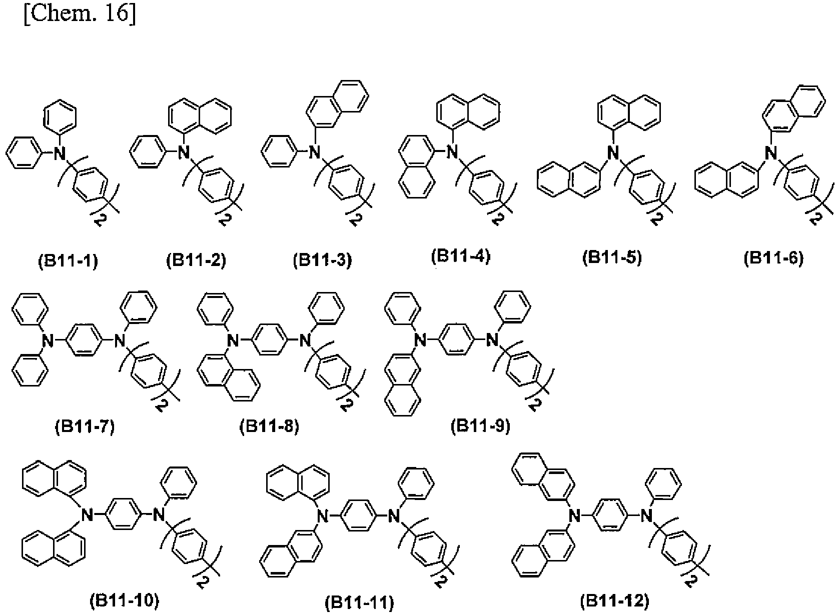

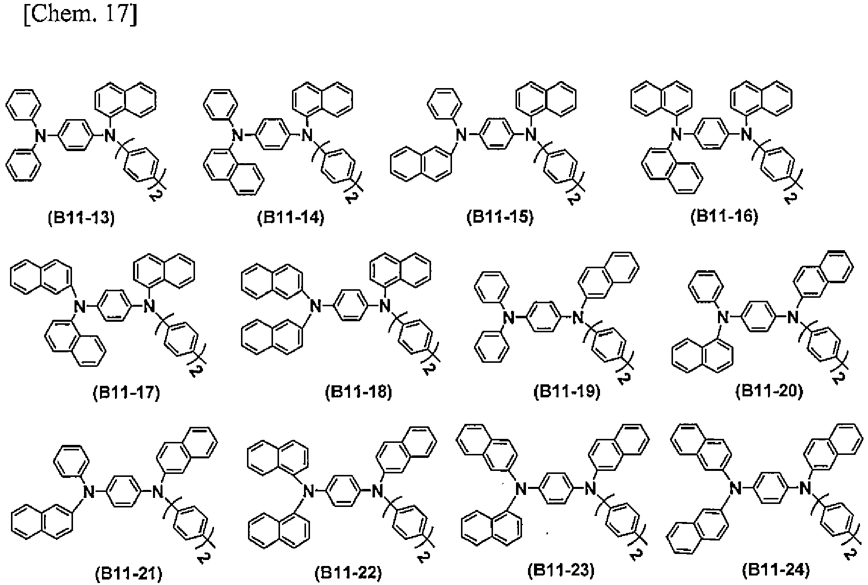

Each Ar² in above formula (1) is independently a group of any of formulas (A1) to (A18).

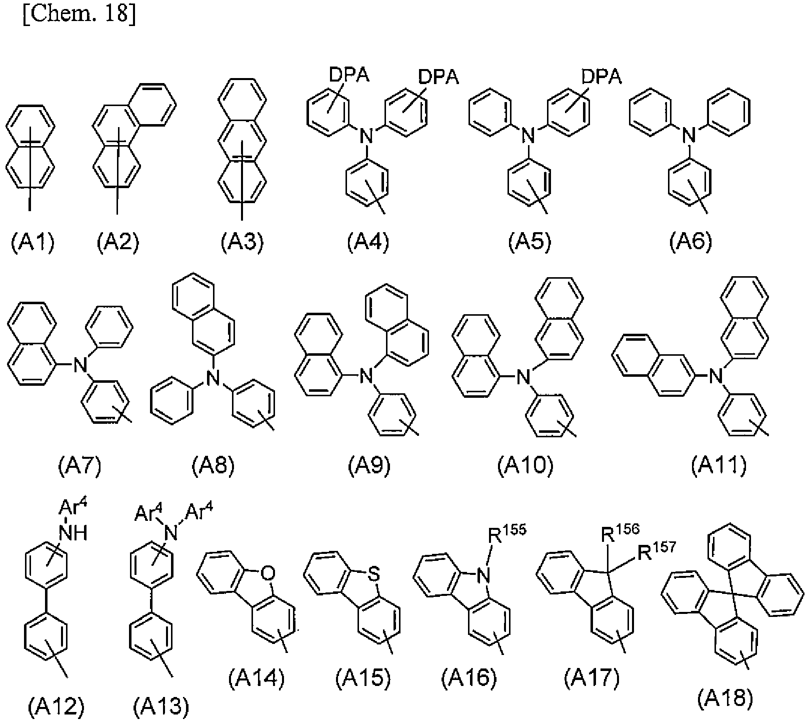

Here, R¹⁵⁵ is a hydrogen atom, an alkyl group of 1 to 20 carbon atoms, alkenyl group of 2 to 20 carbon atoms or alkynyl group of 2 to 20 carbon atoms which may be substituted with Z⁴, or an aryl group of 6 to 20 carbon atoms or heteroaryl group of 2 to 20 carbon atoms which may be substituted with Z¹; R¹⁵⁶ and R¹⁵⁷ are each independently an aryl group of 6 to 20 carbon atoms or heteroaryl group of 2 to 20 carbon atoms which may be substituted with Z¹; DPA is a diphenylamino group; and Ar⁴, Z¹ and Z⁴ are as defined above. These halogen atoms, alkyl groups of 1 to 20 carbon atoms, alkenyl groups of 2 to 20 carbon atoms, alkynyl groups of 2 to 20 carbon atoms, aryl groups of 6 to 20 carbon atoms and heteroaryl groups of 2 to 20 carbon atoms are exemplified in the same way as the groups described above for formula (c1).

In particular, R¹⁵⁵ is preferably a hydrogen atom, an aryl group of 6 to 20 carbon atoms that may be substituted with Z¹, a heteroaryl group of 2 to 20 carbon atoms that may be substituted with Z¹, or an alkyl group of 1 to 20 carbon atoms that may be substituted with Z⁴; more preferably a hydrogen atom, an aryl group of 6 to 14 carbon atoms that may be substituted with Z¹, a heteroaryl group of 2 to 14 carbon atoms that may be substituted with Z¹, or an alkyl group of 1 to 10 carbon atoms that may be substituted with Z⁴; even more preferably a hydrogen atom, an aryl group of 6 to 14 carbon atoms that may be substituted with Z¹, a nitrogen-containing heteroaryl group of 2 to 14 carbon atoms that may be substituted with Z¹, or an alkyl group of 1 to 10 carbon atoms that may be substituted with Z⁴; and still more preferably a hydrogen atom, a phenyl group that may be substituted with Z¹, a 1-naphthyl group that may be substituted with Z¹, a 2-naphthyl group that may be substituted with Z¹, a 2-pyridyl group that may be substituted with Z¹, a 3-pyridyl group that may be substituted with Z¹, a 4-pyridyl group that may be substituted with Z¹ or a methyl group that may be substituted with Z⁴.

Also, R¹⁵⁶ and R¹⁵⁷ are preferably an aryl group of 6 to 14 carbon atoms that may be substituted with Z¹ or a heteroaryl group of 2 to 14 carbon atoms that may be substituted with Z¹; more preferably an aryl group of 6 to 14 carbon atoms that may be substituted with Z¹; and even more preferably a phenyl group that may be substituted with Z¹, a 1-naphthyl group that may be substituted with Z¹ or a 2-naphthyl group that may be substituted with Z¹.

Preferred examples of Ar² groups include, but are not limited to, the following. 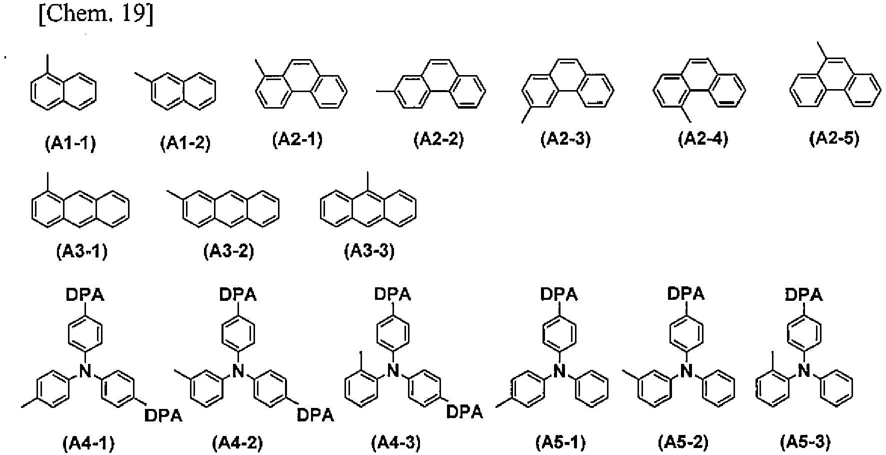 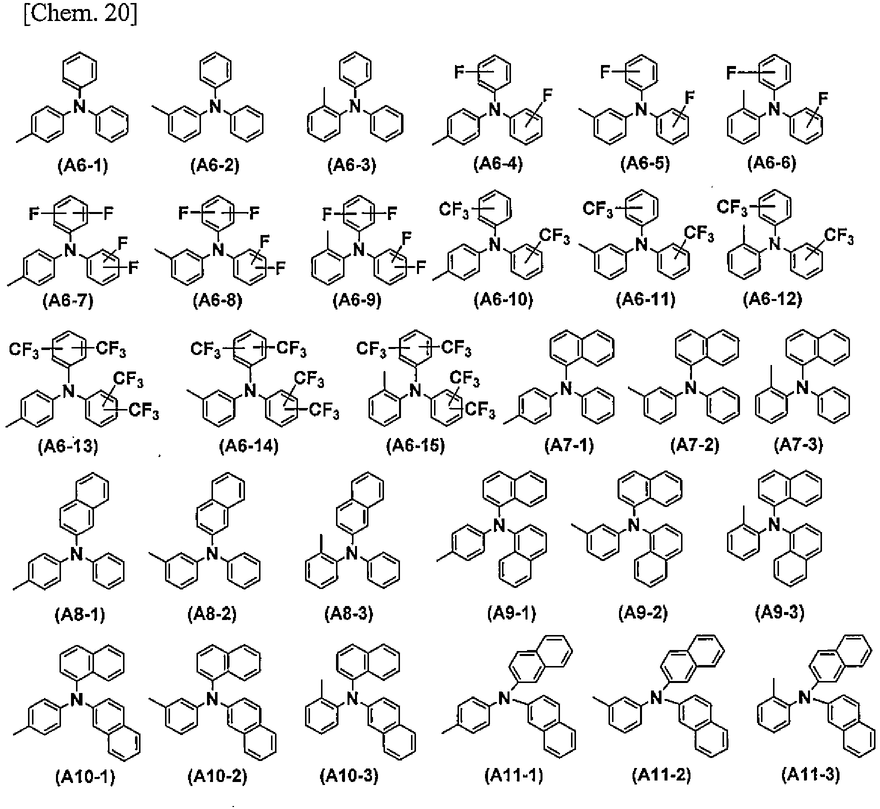 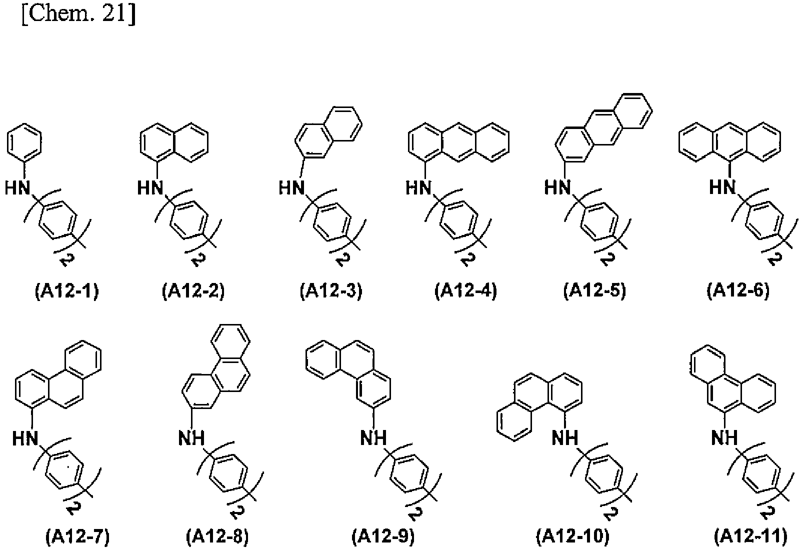 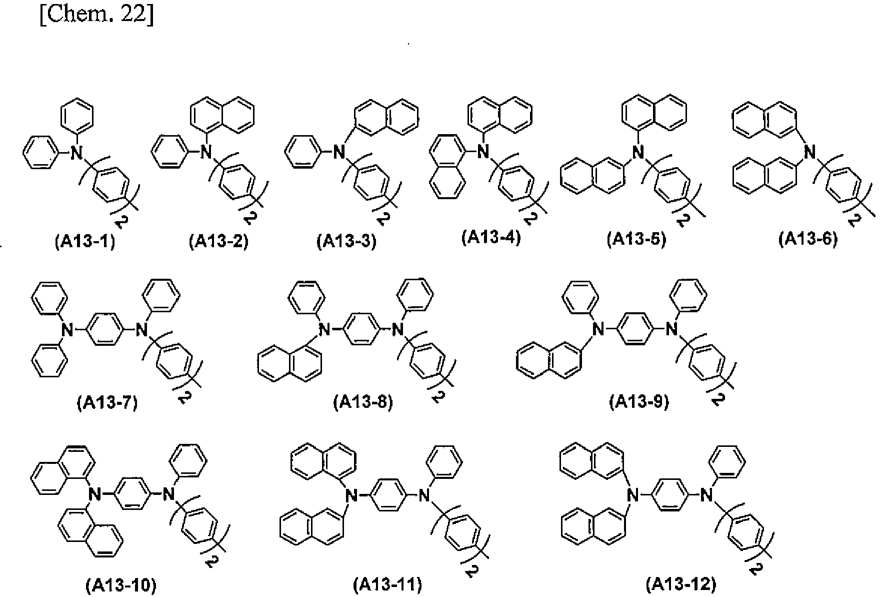 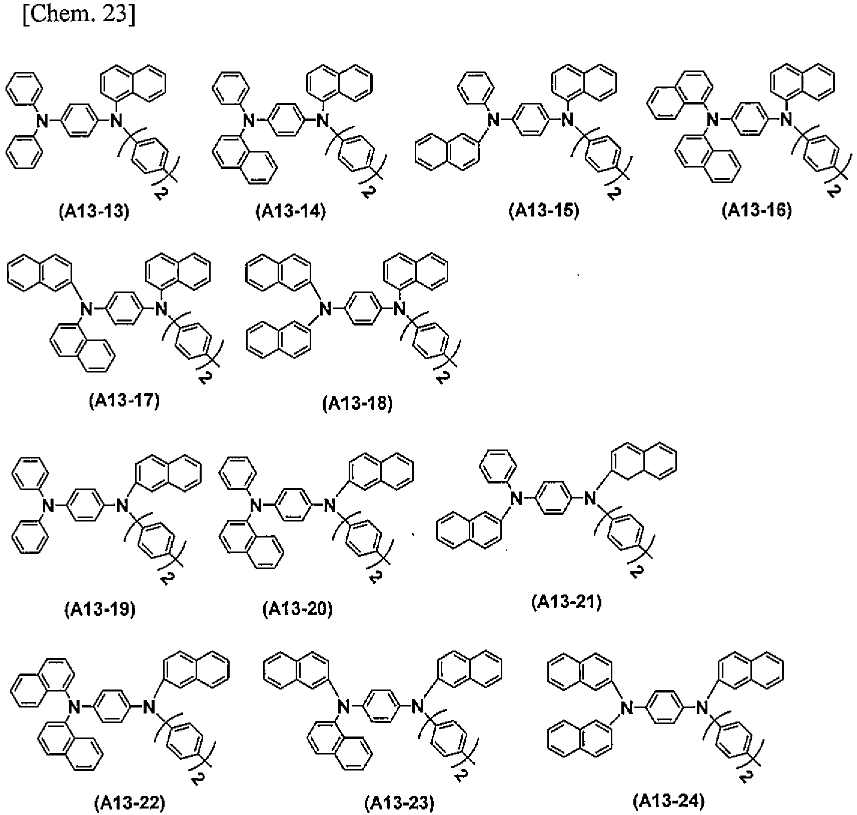 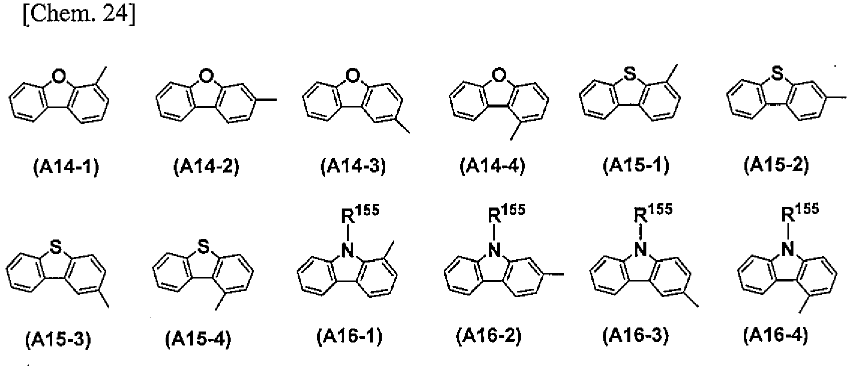 (wherein R¹⁵⁵ is as defined above)

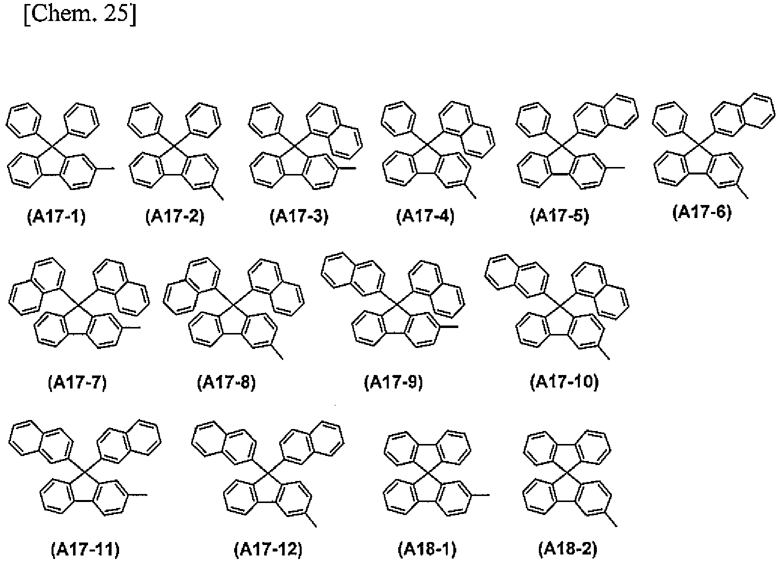

In formula (1), taking into consideration the ease of synthesizing the aniline derivative to be obtained, it is preferable for all Ar¹ groups to be the same and for all Ar² groups to be the same, and more preferable for all Ar¹ and Ar² groups to be the same. That is, the aniline derivative of formula (1) is more preferably an aniline derivative of formula (1-1).

In addition, the aniline derivative of formula (1) is preferably an aniline derivative of formula (1-1) because, as subsequently described, synthesis can be carried out with relative ease using as the starting compound bis(4-aminophenyl)amine, which is relatively inexpensive, and also because the solubility in the organic solvent is excellent.

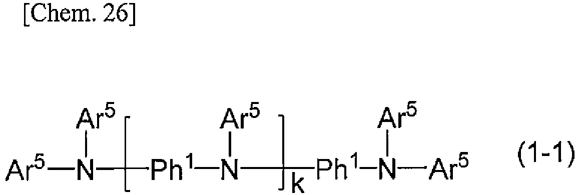

In formula (1-1), Ph¹ and k are as defined above, and Ar⁵ is at the same time a group of any of formulas (D1) to (D13), and preferably a group of any of formulas (D1') to (D13').

The Ar⁵ groups are exemplified by the same groups mentioned above as preferred examples of Ar¹. 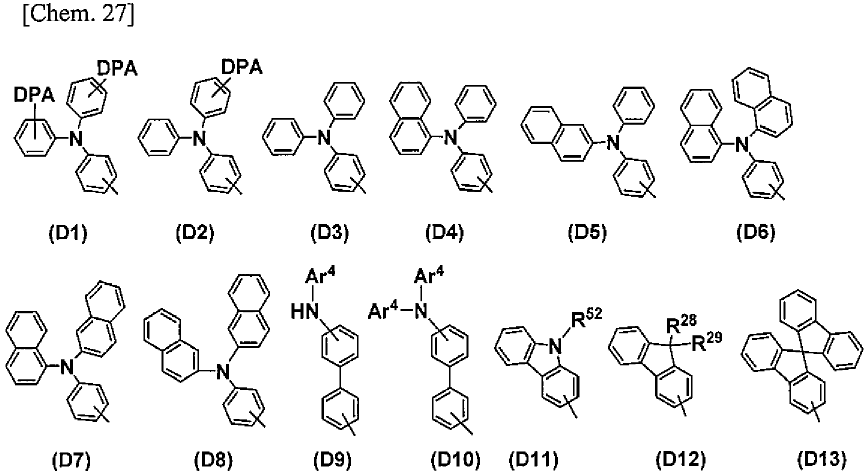 Here, R²⁸, R²⁹, R⁵², Ar⁴ and DPA are as defined above. 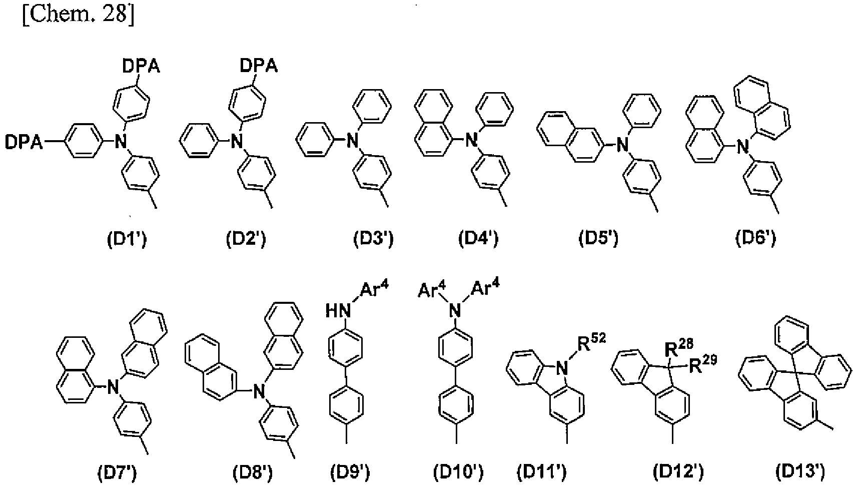 Here, R²⁸, R²⁹, R⁵², Ar⁴ and DPA are as defined above.

Also, the aniline derivative of formula (1) is preferably an aniline derivative of formula (1-2) because, as subsequently described, synthesis can be carried out with relative ease using as the starting compound bis(4-aminophenyl)amine, which is relatively inexpensive, and moreover because the solubility of the resulting aniline derivative in the organic solvent is excellent.

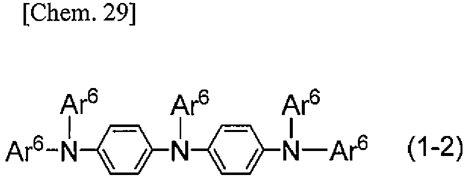

The Ar⁶ groups are all groups of any of formula (E1) to (E14). 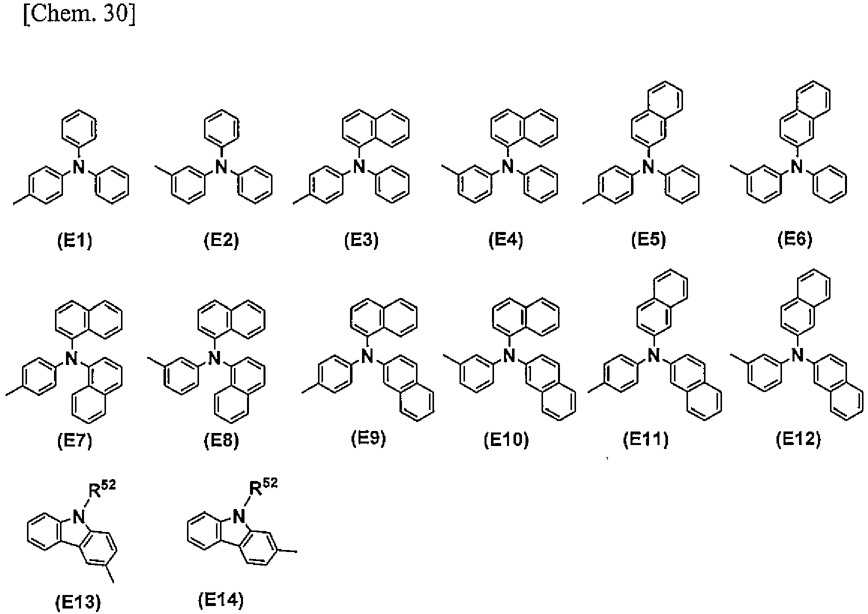 Here, R⁵² is as defined above.

Ar³ in formula (2) above is a group of any of formulas (C1) to (C8), and is preferably a group of any of formulas (C1') to (C8').

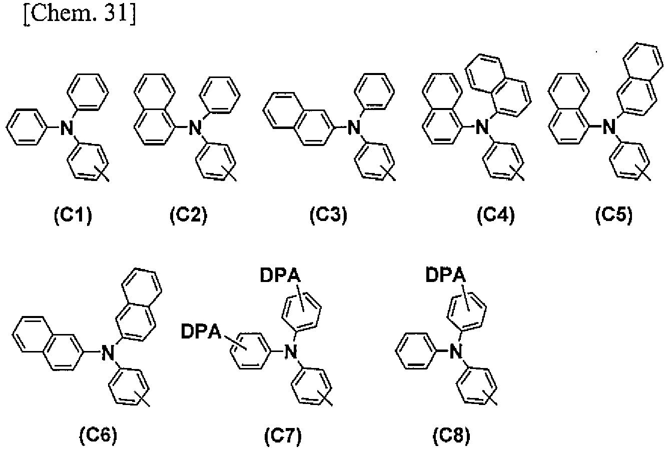

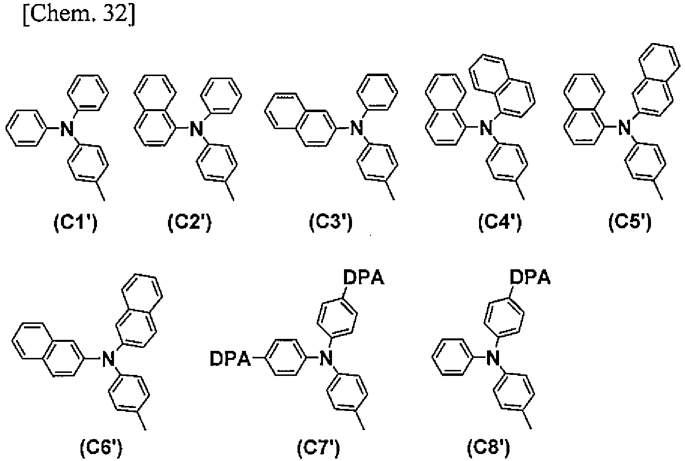

The subscript k in formula (1) is an integer from 1 to 10. From the standpoint of increasing the solubility of the compound in the organic solvent, it is preferably from 1 to 5, more preferably from 1 to 3, even more preferably 1 or 2, and most preferably 1.

The subscript 1 in formula (2) is 1 or 2.

In R²⁸, R²⁹, R⁵² and R¹⁵⁵ to R¹⁵⁷, Z¹ is preferably a halogen atom, a nitro group, a cyano group, an alkyl group of 1 to 10 carbon atoms which may be substituted with Z², an alkenyl group of 2 to 10 carbon atoms which may be substituted with Z², or an alkynyl group of 2 to 10 carbon atoms which may be substituted with Z²; more preferably a halogen atom, a nitro group, a cyano group, an alkyl group of 1 to 3 carbon atoms which may be substituted with Z², an alkenyl group of 2 or 3 carbon atoms which may be substituted with Z², or an alkynyl group of 2 or 3 carbon atoms which may be substituted with Z²; and more preferably a fluorine atom, an alkyl group of 1 to 3 carbon atoms which may be substituted with Z², an alkenyl group of 2 or 3 carbon atoms which may be substituted with Z², or an alkynyl group of 2 or 3 carbon atoms which may be substituted with Z².

In R²⁸, R²⁹, R⁵² and R¹⁵⁵ to R¹⁵⁷, Z⁴ is preferably a halogen atom, a nitro group, a cyano group, or an aryl group of 6 to 14 carbon atoms which may be substituted with Z⁵; more preferably a halogen atom, a nitro group, a cyano group, or an aryl group of 6 to 10 carbon atoms which may be substituted with Z⁵; even more preferably a fluorine atom or an aryl group of 6 to 10 carbon atoms which may be substituted with Z⁵; and still more preferably a fluorine atom or a phenyl group which may be substituted with Z⁵.

In R²⁸, R²⁹, R⁵² and R¹⁵⁵ to R¹⁵⁷, Z² is preferably a halogen atom, a nitro group, a cyano group, or an aryl group of 6 to 14 carbon atoms which may be substituted with Z³; more preferably a halogen atom, a nitro group, a cyano group, or an aryl group of 6 to 10 carbon atoms which may be substituted with Z³; even more preferably a fluorine atom or an aryl group of 6 to 10 carbon atoms which may be substituted with Z³; and still more preferably a fluorine atom or a phenyl group which may be substituted with Z³.

In R²⁸, R²⁹, R⁵² and R¹⁵⁵ to R¹⁵⁷, Z⁵ is preferably a halogen atom, a nitro group, a cyano group, an alkyl group of 1 to 10 carbon atoms which may be substituted with Z³, an alkenyl group of 2 to 10 carbon atoms which may be substituted with Z³, or an alkynyl group of 2 to 10 carbon atoms which may be substituted with Z³; more preferably a halogen atom, a nitro group, a cyano group, an alkyl group of 1 to 3 carbon atoms which may be substituted with Z³, an alkenyl group of 2 or 3 carbon atoms which may be substituted with Z³, or an alkynyl group of 2 or 3 carbon atoms which may be substituted with Z³; and even more preferably a fluorine atom, an alkyl group of 1 to 3 carbon atoms which may be substituted with Z³, an alkenyl group of 2 or 3 carbon atoms which may be substituted with Z³, or an alkynyl group of 2 or 3 carbon atoms which may be substituted with Z³.

In R²⁸, R²⁹, R⁵² and R¹⁵⁵ to R¹⁵⁷, Z³ is preferably a halogen atom, and more preferably a fluorine atom.

In R⁷ to R²⁷, R³⁰ to R⁵¹ and R⁵³ to R¹⁵⁴, Z¹ is preferably a halogen atom, a nitro group, a cyano group, an alkyl group of 1 to 3 carbon atoms which may be substituted with Z², an alkenyl group of 2 or 3 carbon atoms which may be substituted with Z², or an alkynyl group of 2 or 3 carbon atoms which may be substituted with Z²; more preferably a halogen atom or an alkyl group of 1 to 3 carbon atoms which may be substituted with Z²; and still more preferably a fluorine atom or a methyl group which may be substituted with Z².

In R⁷ to R²⁷, R³⁰ to R⁵¹ and R⁵³ to R¹⁵⁴, Z⁴ is preferably a halogen atom, a nitro group, a cyano group, or an aryl group of 6 to 10 carbon atoms which may be substituted with Z⁵; more preferably a halogen atom or an aryl group of 6 to 10 carbon atoms which may be substituted with Z⁵; and still more preferably a fluorine atom or a phenyl group which may be substituted with Z⁵.

In R⁷ to R²⁷, R³⁰ to R⁵¹ and R⁵³ to R¹⁵⁴, Z² is preferably a halogen atom, a nitro group, a cyano group, or an aryl group of 6 to 10 carbon atoms which may be substituted with Z³; more preferably a halogen atom or an aryl group of 6 to 10 carbon atoms which may be substituted with Z³; and still more preferably a fluorine atom or a phenyl group which may be substituted with Z³.

In R⁷ to R²⁷, R³⁰ to R⁵¹ and R⁵³ to R¹⁵⁴, Z⁵ is preferably a halogen atom, a nitro group, a cyano group, an alkyl group of 1 to 3 carbon atoms which may be substituted with Z³, an alkenyl group of 2 or 3 carbon atoms which may be substituted with Z³, or an alkynyl group of 2 or 3 carbon atoms which may be substituted with Z³; more preferably a halogen atom or an alkyl group of 1 to 3 carbon atoms which may be substituted with Z³; and even more preferably a fluorine atom or a methyl group which may be substituted with Z³.

In R⁷ to R²⁷, R³⁰ to R⁵¹ and R⁵³ to R¹⁵⁴, Z³ is preferably a halogen atom, and more preferably a fluorine atom.

Examples of groups that are preferred as R⁵² and R¹⁵⁵ above include, but are not limited to, the following groups.

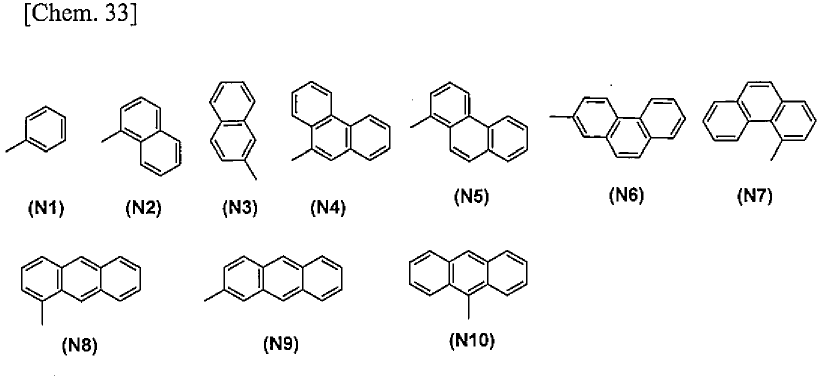

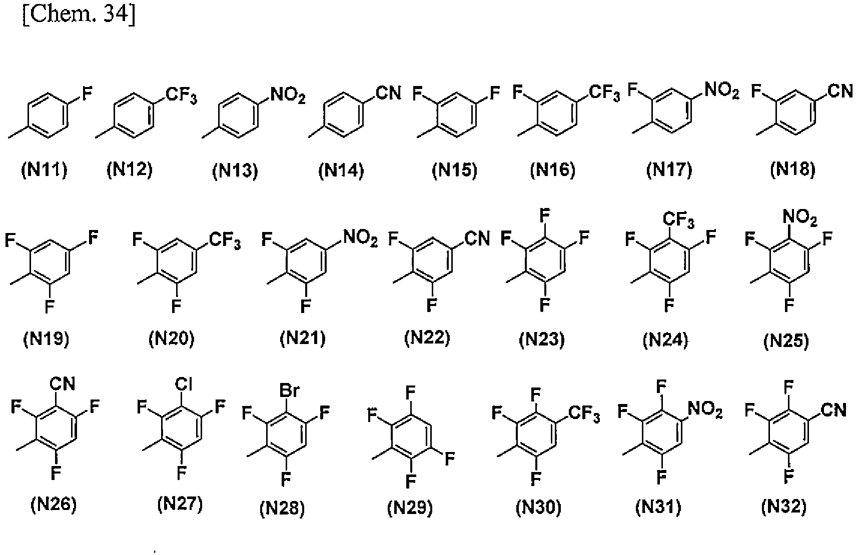

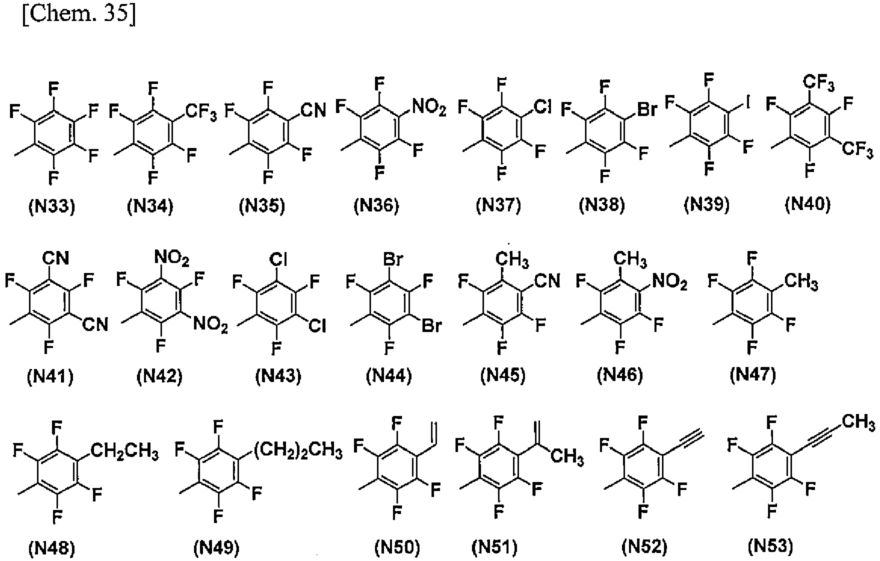

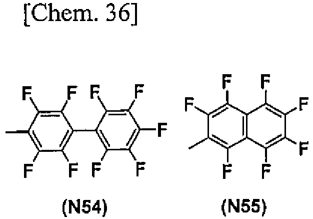

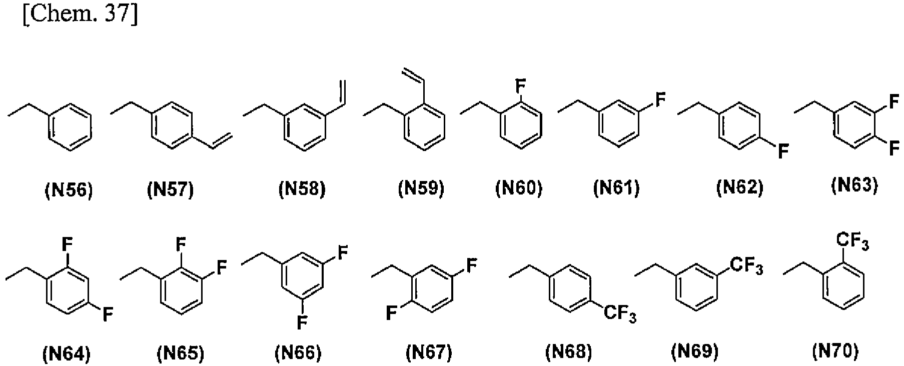

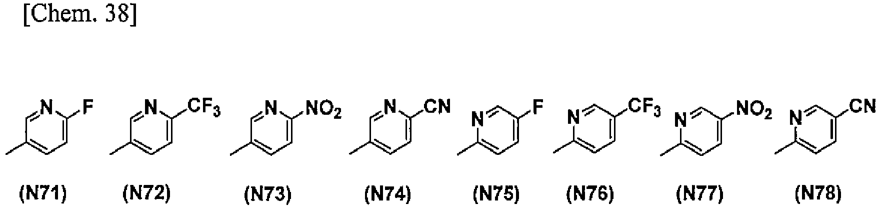

The number of carbon atoms in the above alkyl, alkenyl and alkynyl groups is preferably 10 or less, more preferably 6 or less, and even more preferably 4 or less.

The number of carbon atoms in the above aryl and heteroaryl groups is preferably 14 or less, more preferably 10 or less, and even more preferably 6 or less.

The aniline derivative of formula (1) above can be prepared by reacting an amine compound of formula (3) with an aryl compound of formula (4) in the presence of a catalyst. 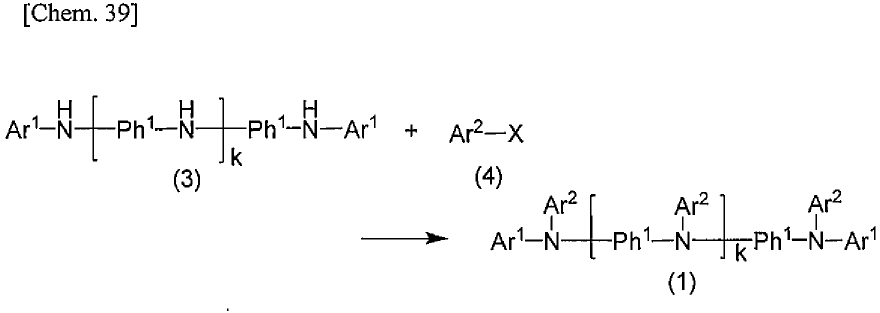 Here, X is a halogen atom or a pseudo-halogen group, and Ar¹, Ar², Ph¹ and k are as defined above.

In particular, the aniline derivative of formula (1-1) can be prepared by reacting an amine compound of formula (5) with an aryl compound of formula (6) in the presence of a catalyst. 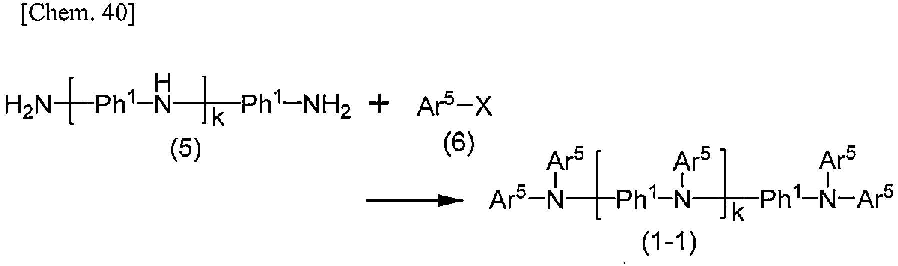 Here, X, Ar⁵, Ph¹ and k are as defined above.

The aniline derivative of formula (1-2) can be prepared by reacting bis(4-aminophenyl)amine with an aryl compound of formula (7) in the presence of a catalyst. 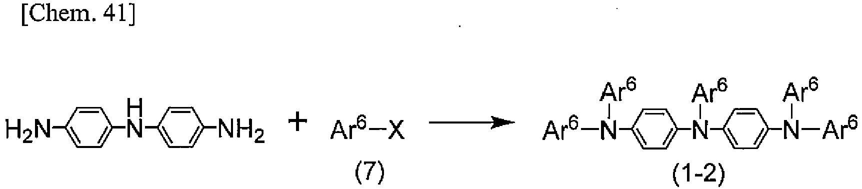 Here, X and Ar⁶ are as defined above.

Also, the aniline derivative of formula (2) above can be prepared by reacting an amine compound of formula (8) with an aryl compound of formula (9) in the presence of a catalyst. 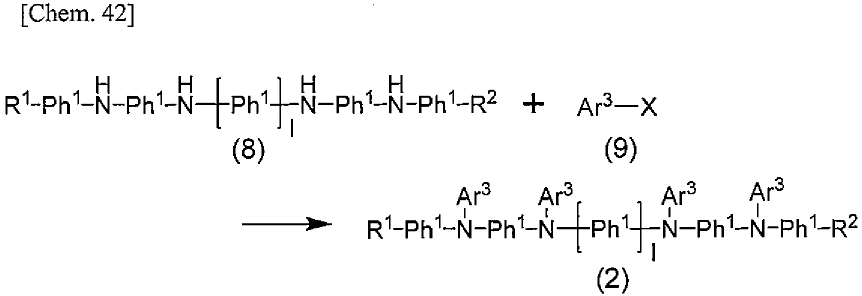 Here, X, R¹, R², Ar³, Ph¹ and the subscript 1 are as defined above.

The halogen atom is exemplified in the same way as above.

The pseudo-halogen group is exemplified by (fluoro)alkylsulfonyloxy groups such as methanesulfonyloxy, trifluoromethanesulfonyloxy and nonafluorobutanesulfonyloxy groups; and aromatic sulfonyloxy groups such as benzenesulfonyloxy and toluenesulfonyloxy groups.

The charging ratio between the amine compound of formula (3), (5) or (8) or bis(4-aminophenyl)amine and the aryl compound of formula (4), (6), (7) or (9) may be set so as to make the amount of aryl compound at least 1 equivalent, and preferably from about 1 to about 1.2 equivalents, relative to the molar amount of all NH groups on the amine compound or bis(4-aminophenyl)amine.

The catalyst that may be used in the reaction is exemplified by copper catalysts such as copper chloride, copper bromide and copper iodide; and palladium catalysts such as tetrakis(triphenylphosphine)palladium (Pd(PPh₃)₄), bis(triphenylphosphine)dichloropalladium (Pd(PPh₃)₂Cl₂), bis(benzylideneacetone)palladium (Pd(dba)₂), tris(dibenzylideneacetone)dipalladium (Pd₂(dba)₃), bis(tri(t-butylphosphine))palladium (Pd(P-t-Bu₃)₂) and palladium acetate (Pd(OAc)₂). These catalysts may be used singly, or two or more may be used in combination. Also, these catalysts may be used together with suitable known ligands.

Examples of such ligands include tertiary phosphines such as triphenylphosphine, tri-o-tolylphosphine, diphenylmethylphosphine, phenyldimethylphosphine, trimethylphosphine, triethylphosphine, tributylphosphine, tri-tert-butylphosphine, di-t-butyl(phenyl)phosphine, di-tert-butyl(4-dimethylaminophenyl)phosphine, 1,2-bis(diphenylphosphino)ethane, 1,3-bis(diphenylphosphino)propane, 1,4-bis(diphenylphosphino)butane and 1,1'-bis(diphenylphosphino)ferrocene; and tertiary phosphites such as trimethylphosphite, triethylphosphite and triphenylphosphite.

The amount of catalyst used may be set to about 0.2 mole per mole of the aryl compound of formula (4), (6), (7) or (9), and is preferably about 0.15 mole.

When ligands are used, the amount thereof may be set to from 0.1 to 5 equivalents, and is preferably from 1 to 2 equivalents, with respect to the metal complex used.

In cases where the starting compounds are all solids, or in order to efficiently obtain the target aniline derivative, each of the above reactions is carried out in a solvent. When a solvent is used, the type thereof is not particularly limited, provided that it does not have an adverse influence on the reaction. Illustrative examples include aliphatic hydrocarbons (pentane, n-hexane, n-octane, n-decane, decalin, etc.), halogenated aliphatic hydrocarbons (chloroform, dichloromethane, dichloroethane, carbon tetrachloride, etc.), aromatic hydrocarbons (benzene, nitrobenzene, toluene, o-xylene, m-xylene, p-xylene, mesitylene, etc.), halogenated aromatic hydrocarbons (chlorobenzene, bromobenzene, o-dichlorobenzene, m-dichlorobenzene, p-dichlorobenzene, etc.), ethers (diethyl ether, diisopropyl ether, t-butyl methyl ether, tetrahydrofuran, dioxane, 1,2-dimethoxyethane, 1,2-diethoxyethane, etc.), ketones (acetone, methyl ethyl ketone, methyl isobutyl ketone, di-n-butyl ketone, cyclohexanone, etc.), amides (N,N-dimethylformamide, N,N-dimethylacetamide, etc.), lactams and lactones (N-methylpyrrolidone, γ-butyrolactone, etc.), ureas (N,N-dimethylimidazolidinone, tetramethylurea, etc.), sulfoxides (dimethylsulfoxide, sulfolane, etc.), and nitriles (acetonitrile, propionitrile, butyronitrile, etc.). These solvents may be used singly, or two or more may be used in admixture.

The reaction temperature may be suitably set in the range of the melting point to the boiling point of the solvent used, with a temperature of from about 0°C to about 200°C being preferred, and a temperature of from 20°C to 150°C being more preferred.

Following reaction completion, the target aniline derivative can be obtained by work-up in the usual manner.

In the above-described method for preparing the aniline derivative of formula (1), the amine compound of formula (3') which may be used as a starting material can be efficiently prepared by reacting an amine compound of formula (10) with an aryl compound of formula (11) in the presence of a catalyst. 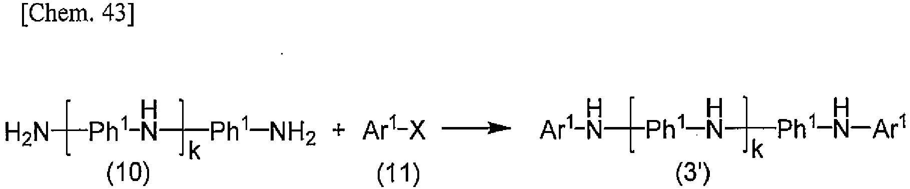 Here, X, Ar¹, Ph¹ and k are as defined above, provided that the two Ar¹ moieties are not both groups of formula (B1).

The method for preparing the amine compound of formula (3') is to induce a coupling reaction between the amine compound of formula (10) and the aryl compound of formula (11). The amine compound of formula (10) and the aryl compound of formula (11) are charged in a molar ratio of preferably about 2 to 2.4 of the aryl compound relative to unity (1) for the amine compound.

Conditions relating to, for example, the catalyst, ligands, solvents and reaction temperature in the coupling reaction are the same as the conditions described above for the method of preparing the aniline derivative of formula (1).

When preparing an aniline derivative wherein, in formula (1), Ar¹ is a group of formula (B4) in which R⁵² is a hydrogen atom or a group of formula (B10), or Ar² is a group of formula (A12) or a group of formula (A16) in which R¹⁵⁵ (including R⁵² in formula (1-1)) is a hydrogen atom, an aryl compound having a known protecting group on the amino group may be used in the above reaction.

Illustrative examples of the aniline derivative of formula (1) or (2) include, but are not limited to, those shown below. In the formulas and tables, "Me" stands for a methyl group, "Et" stands for an ethyl group, "Prⁿ" stands for an n-propyl group, "Prⁱ" stands for an i-propyl group, "Buⁿ" stands for an n-butyl group, "Buⁱ" stands for an i-butyl group, "Bu^{s}" stands for an s-butyl group, "Bu^{t}" stands for a t-butyl group, "DPA" stands for a diphenylamino group, and "SBF" stands for a 9,9'-spirobi[9H-fluoren]-2-yl group.

**[Table 1]**

| | | | | | | | |
|---|---|---|---|---|---|---|---|
| 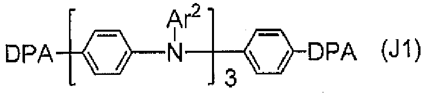 | | | | | | | |

| **Compound** | Ar² | **Compound** | Ar² | **Compound** | Ar² | **Compound** | Ar² |
|---|---|---|---|---|---|---|---|
| (J1-1) | (A1-1) | (J1-27) | (A6-11) | (J1-53) | (A12-7) | (J1-79) | (A13-22) |
| (J1-2) | (A1-2) | (J1-28) | (A6-12) | (J1-54) | (A12-8) | (J1-B0) | (A13-23) |
| (J1-3) | (A2-1) | (J1-29) | (A6-13) | (J1-55) | (A12-9) | (J1-81) | (A13-24) |
| (J1-4) | (A2-2) | (J1-30) | (A6-14) | (J1-56) | (A12-10) | (J1-82) | (A14-1) |
| (J1-5) | (A2-3) | (J1-31) | (A6-15) | (J1-57) | (A12-11) | (J1-83) | (A14-2) |
| (J1-6) | (A2-4) | (J1-32) | (A7-1) | (J1-58) | (A13-1) | (J1-84) | (A14-3) |
| (J1-7) | (A2-5) | (J1-33) | (A7-2) | (J1-59) | (A13-2) | (J1-85) | (A14-4) |
| (J1-8) | (A3-1) | (J1-34) | (A7-3) | (J1-60) | (A13-3) | (J1-86) | (A15-1) |
| (J1-9) | (A3-2) | (J1-35) | (A8-1) | (J1-61) | (A13-4) | (J1-87) | (A15-2) |
| (J1-10) | (A3-3) | (J1-36) | (A8-2) | (J1-62) | (A13-5) | (J1-88) | (A15-3) |
| (J1-11) | (A4-1) | (J1-37) | (A8-3) | (J1-63) | (A13-6) | (J1-89) | (A15-4) |
| (J1-12) | (A4-2) | (J1-38) | (A9-1) | (J1-64) | (A13-7) | (J1-90) | (A17-1) |
| (J1-13) | (A4-3) | (J1-39) | (A9-2) | (J1-65) | (A13-8) | (J1-91) | (A17-2) |
| (J1-14) | (A5-1) | (J1-40) | (A9-3) | (J1-66) | (A13-9) | (J1-92) | (A17-3) |
| (J1-15) | (A5-2) | (J1-41) | (A10-1) | (J1-67) | (A13-10) | (J1-93) | (A17-4) |
| (J1-16) | (A5-3) | (J1-42) | (A10-2) | (J1-68) | (A13-11) | (J1-94) | (A17-5) |
| (J1-17) | (A6-1) | (J1-43) | (A10-3) | (J1-69) | (A13-12) | (J1-95) | (A17-6) |
| (J1-18) | (A6-2) | (J1-44) | (A11-1) | (J1-70) | (A13-13) | (J1-96) | (A17-7) |
| (J1-19) | (A6-3) | (J1-45) | (A11-2) | (J1-71) | (A13-14) | (J1-97) | (A17-8) |
| (J1-20) | (A6-4) | (J1-46) | (A11-3) | (J1-72) | (A13-15) | (J1-98) | (A17-9) |
| (J1-21) | (A6-5) | (J1-47) | (A12-1) | (J1-73) | (A13-16) | (J1-99) | (A17-10) |
| (J1-22) | (A6-6) | (J1-48) | (A12-2) | (J1-74) | (A13-17) | (J1-100) | (A17-11) |
| (J1-23) | (A6-7) | (J1-49) | (A12-3) | (J1-75) | (A13-18) | (J1-101) | (A17-12) |
| (J1-24) | (A6-8) | (J1-50) | (A12-4) | (J1-76) | (A13-19) | (J1-102) | (A18-1) |
| (J1-25) | (A6-9) | (J1-51) | (A12-5) | (J1-77) | (A13-20) | (J1-103) | (A18-2) |
| (J1-26) | (A6-10) | (J1-52) | (A12-6) | (J1-78) | (A13-21) | | |

**[Table 2]**

| | | | | | | | |
|---|---|---|---|---|---|---|---|
| 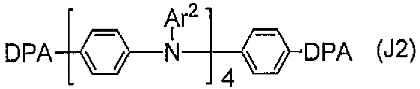 | | | | | | | |

| **Compound** | Ar² | **Compound** | Ar² | **Compound** | Ar² | **Compound** | Ar² |
|---|---|---|---|---|---|---|---|
| (J2-1) | (A1-1) | (J2-27) | (A6-11) | (J2-53) | (A12-7) | (J2-79) | (A13-22) |
| (J2-2) | (A1-2) | (J2-28) | (A6-12) | (J2-54) | (A12-8) | (J2-80) | (A13-23) |
| (J2-3) | (A2-1) | (J2-29) | (A6-13) | (J2-55) | (A12-9) | (J2-81) | (A13-24) |
| (J2-4) | (A2-2) | (J2-30) | (A6-14) | (J2-56) | (A12-10) | (J2-82) | (A14-1) |
| (J2-5) | (A2-3) | (J2-31) | (A6-15) | (J2-57) | (A12-11) | (J2-83) | (A14-2) |
| (J2-6) | (A2-4) | (J2-32) | (A7-1) | (J2-58) | (A13-1) | (J2-84) | (A14-3) |
| (J2-7) | (A2-5) | (J2-33) | (A7-2) | (J2-59) | (A13-2) | (J2-85) | (A14-4) |
| (J2-8) | (A3-1) | (J2-34) | (A7-3) | (J2-60) | (A13-3) | (J2-86) | (A15-1) |
| (J2-9) | (A3-2) | (J2-35) | (A8-1) | (J2-61) | (A13-4) | (J2-87) | (A15-2) |
| (J2-10) | (A3-3) | (J2-36) | (A8-2) | (J2-62) | (A13-5) | (J2-88) | (A15-3) |
| (J2-11) | (A4-1) | (J2-37) | (A8-3) | (J2-63) | (A13-6) | (J2-89) | (A15-4) |
| (J2-12) | (A4-2) | (J2-38) | (A9-1) | (J2-64) | (A13-7) | (J2-90) | (A17-1) |
| (J2-13) | (A4-3) | (J2-39) | (A9-2) | (J2-65) | (A13-8) | (J2-91) | (A17-2) |
| (J2-14) | (A5-1) | (J2-40) | (A9-3) | (J2-66) | (A13-9) | (J2-92) | (A17-3) |
| (J2-15) | (A5-2) | (J2-41) | (A10-1) | (J2-67) | (A13-10) | (J2-93) | (A17-4) |
| (J2-16) | (A5-3) | (J2-42) | (A10-2) | (J2-68) | (A13-11) | (J2-94) | (A17-5) |
| (J2-17) | (A6-1) | (J2-43) | (A10-3) | (J2-69) | (A13-12) | (J2-95) | (A17-6) |
| (J2-18) | (A6-2) | (J2-44) | (A11-1) | (J2-70) | (A13-13) | (J2-96) | (A17-7) |
| (J2-19) | (A6-3) | (J2-45) | (A11-2) | (J2-71) | (A13-14) | (J2-97) | (A17-8) |
| (J2-20) | (A6-4) | (J2-46) | (A11-3) | (J2-72) | (A13-15) | (J2-98) | (A17-9) |
| (J2-21) | (A6-5) | (J2-47) | (A12-1) | (J2-73) | (A13-16) | (J2-99) | (A17-10) |
| (J2-22) | (A6-6) | (J2-48) | (A12-2) | (J2-74) | (A13-17) | (J2-100) | (A17-11) |
| (J2-23) | (A6-7) | (J2-49) | (A12-3) | (J2-75) | (A13-18) | (J2-101) | (A17-12) |
| (J2-24) | (A6-8) | (J2-50) | (A12-4) | (J2-76) | (A13-19) | (J2-102) | (A18-1) |
| (J2-25) | (A6-9) | (J2-51) | (A12-5) | (J2-77) | (A13-20) | (J2-103) | (A18-2) |
| (J2-26) | (A6-10) | (J2-52) | (A12-6) | (J2-78) | (A13-21) | | |

**[Table 3]**

| | | | | | | | |
|---|---|---|---|---|---|---|---|
| 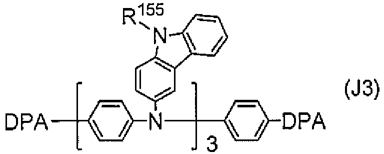 | | | | | | | |

| **Compound** | R¹⁵⁵ | **Compound** | R¹⁵⁵ | **Compound** | R¹⁵⁵ | **Compound** | R¹⁵⁵ |
|---|---|---|---|---|---|---|---|
| (J3-1) | (N1) | (J3-27) | (N27) | (J3-53) | (N53) | (J3-79) | -H |
| (J3-2) | (N2) | (J3-28) | (N28) | (J3-54) | (N54) | (J3-80) | -Me |
| (J3-3) | (N3) | (J3-29) | (N29) | (J3-55) | (N55) | (J3-81) | -Et |
| (J3-4) | (N4) | (J3-30) | (N30) | (J3-56) | (N56) | (J3-82) | -Prⁿ |
| (J3-5) | (N5) | (J3-31) | (N31) | (J3-57) | (N57) | (J3-83) | -Pr^{l} |
| (J3-6) | (N6) | (J3⁻32) | (N32) | (J3-58) | (N58) | (J3-84) | -Buⁿ |
| (J3-7) | (N7) | (J3-33) | (N33) | (J3-59) | (N59) | (J3-85) | -Bu^{l} |
| (J3-8) | (N8) | (J3-34) | (N34) | (J3-60) | (N60) | (J3-86) | -Bu^{s} |
| (J3-9) | (N9) | (J3-35) | (N35) | (J3-61) | (N61) | (J3-87) | -Bu^{t} |
| (J3-10) | (N10) | (J3-36) | (N36) | (J3-62) | (N62) | | |
| (J3-11) | (N11) | (J3-37) | (N37) | (J3-63) | (N63) | | |
| (J3-12) | (N12) | (J3-38) | (N38) | (J3-64) | (N64) | | |
| (J3-13) | (N13) | (J3-39) | (N39) | (J3-65) | (N65) | | |
| (J3-14) | (N14) | (J3-40) | (N40) | (J3-66) | (N66) | | |
| (J3-15) | (N15) | (J3-41) | (N41) | (J3-67) | (N67) | | |
| (J3-16) | (N16) | (J3-42) | (N42) | (J3-68) | (N68) | | |
| (J3-17) | (N17) | (J3-43) | (N43) | (J3-69) | (N69) | | |
| (J3-18) | (N18) | (J3-44) | (N44) | (J3-70) | (N70) | | |
| (J3-19) | (N19) | (J3-45) | (N45) | (J3-71) | (N71) | | |
| (J3-20) | (N20) | (J3-46) | (N46) | (J3-72) | (N72) | | |
| (J3-21) | (N21) | (J3-47) | (N47) | (J3-73) | (N73) | | |
| (J3-22) | (N22) | (J3-48) | (N48) | (J3-74) | (N74) | | |
| (J3-23) | (N23) | (J3-49) | (N49) | (J3-75) | (N75) | | |
| (J3-24) | (N24) | (J3-50) | (N50) | (J3-76) | (N76) | | |
| (J3-25) | (N25) | (J3-51) | (N51) | (J3-77) | (N77) | | |
| (J3-26) | (N26) | (J3-52) | (N52) | (J3-78) | (N78) | | |

**[Table 4]**

| | | | | | | | |
|---|---|---|---|---|---|---|---|
| 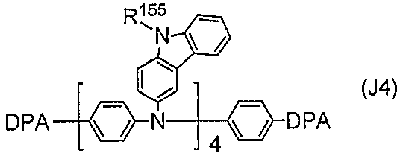 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J4-1) | (N1) | (J4-27) | (N27) | (J4-53) | (N53) | (J4-79) | -H |
| (J4-2) | (N2) | (J4-28) | (N28) | (J4-54) | (N54) | (J4-80) | -Me |
| (J4-3) | (N3) | (J4-29) | (N29) | (J4-55) | (N55) | (J4-81) | -Et |
| (J4-4) | (N4) | (J4-30) | (N30) | (J4-56) | (N56) | (J4-82) | -Prⁿ |
| (J4-5) | (N5) | (J4-31) | (N31) | (J4-57) | (N57) | (J4-83) | -Prⁱ |
| (J4-6) | (N6) | (J4-32) | (N32) | (J4-58) | (N58) | (J4-84) | -Buⁿ |
| (J4-7) | (N7) | (J4-33) | (N33) | (J4-59) | (N59) | (J4-85) | -Buⁱ |
| (J4-8) | (N8) | (J4-34) | (N34) | (J4-60) | (N60) | (J4-86) | -Bu^{s} |
| (J4-9) | (N9) | (J4-35) | (N35) | (J4-61) | (N61) | (J4-87) | -Bu^{t} |
| (J4-10) | (N10) | (J4-36) | (N36) | (J4-62) | (N62) | | |
| (J4-11) | (N11) | (J4-37) | (N37) | (J4-63) | (N63) | | |
| (J4-12) | (N12) | (J4-38) | (N38) | (J4-64) | (N64) | | |
| (J4-13) | (N13) | (J4-39) | (N39) | (J4-65) | (N65) | | |
| (J4-14) | (N14) | (J4-40) | (N40) | (J4-66) | (N66) | | |
| (J4-15) | (N15) | (J4-41) | (N41) | (J4-67) | (N67) | | |
| (J4-16) | (N16) | (J4-42) | (N42) | (J4-68) | (N68) | | |
| (J4-17) | (N17) | (J4-43) | (N43) | (J4-69) | (N69) | | |
| (J4-18) | (N18) | (J4-44) | (N44) | (J4-70) | (N70) | | |
| (J4-19) | (N19) | (J4-45) | (N45) | (J4-71) | (N71) | | |
| (J4-20) | (N20) | (J4-46) | (N46) | (J4-72) | (N72) | | |
| (J4-21) | (N21) | (J4-47) | (N47) | (J4-73) | (N73) | | |
| (J4-22) | (N22) | (J4-48) | (N48) | (J4-74) | (N74) | | |
| (J4-23) | (N23) | (J4-49) | (N49) | (J4-75) | (N75) | | |
| (J4-24) | (N24) | (J4-50) | (N50) | (J4-76) | (N76) | | |
| (J4-25) | (N25) | (J4-51) | (N51) | (J4-77) | (N77) | | |
| (J4-26) | (N26) | (J4-52) | (N52) | (J4-78) | (N78) | | |

**[Table 5]**

| | | | | | | | |
|---|---|---|---|---|---|---|---|
| 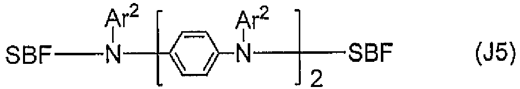 | | | | | | | |

| Compound | Ar² | Compound | Ar² | Compound | Ar² | Compound | Ar² |
|---|---|---|---|---|---|---|---|
| (J5-1) | (A1-1) | (J5-27) | (A6-11) | (J5-53) | (A12-7) | (J5-79) | (A13-22) |
| (J5-2) | (A1-2) | (J5-28) | (A6-12) | (J5-54) | (A12-8) | (J5-80) | (A13-23) |
| (J5-3) | (A2-1) | (J5-29) | (A6-13) | (J5-55) | (A12-9) | (J5-81) | (A13-24) |
| (J5-4) | (A2-2) | (J5-30) | (A6-14) | (J5-56) | (A12-10) | (J5-82) | (A14-1) |
| (J5-5) | (A2-3) | (J5-31) | (A6-15) | (J5-57) | (A12-11) | (J5-83) | (A14-2) |
| (J5-6) | (A2-4) | (J5-32) | (A7-1) | (J5-58) | (A13-1) | (J5-84) | (A14-3) |
| (J5-7) | (A2-5) | (J5-33) | (A7-2) | (J5-59) | (A13-2) | (J5-85) | (A14-4) |
| (J5-8) | (A3-1) | (J5-34) | (A7-3) | (J5-60) | (A13-3) | (J5-86) | (A15-1) |
| (J5-9) | (A3-2) | (J5-35) | (A8-1) | (J5-61) | (A 13-4) | (J5-87) | (A15-2) |
| (J5-10) | (A3-3) | (J5-36) | (A8-2) | (J5-62) | (A13-5) | (J5-88) | (A15-3) |
| (J5-H) | (A4-1) | (J5-37) | (A8-3) | (05-63) | (A13-6) | (J5-89) | (A15-4) |
| (J5-12) | (A4-2) | (J5-38) | (A9-1) | (J5-64) | (A13-7) | (J5-90) | (A17-1) |
| (J5-13) | (A4-3) | (J5-39) | (A9-2) | (J5-65) | (A13-8) | (J5-91) | (A17-2) |
| (J5-14) | (A5-1) | (J5-40) | (A9-3) | (J5-66) | (A13-9) | (J5-92) | (A17-3) |
| (J5-15) | (A5-2) | (J5-41) | (A10-1) | (J5-67) | (A13-10) | (J5-93) | (A17-4) |
| (J5-16) | (A5-3) | (J5-42) | (A10-2) | (J5-68) | (A13-11) | (J5-94) | (A17-5) |
| (J5-17) | (A6-1) | (J5-43) | (A10-3) | (J5-69) | (A13-12) | (J5-95) | (A17-6) |
| (J5-18) | (A6-2) | (J5-44) | (A11-1) | (J5-70) | (A13-13) | (J5-96) | (A17-7) |
| (J5-19) | (A6-3) | (J5-45) | (A11-2) | (J5-71) | (A13-14) | (J5-97) | (A17-8) |
| (J5-20) | (A6-4) | (J5-46) | (A11-3) | (J5-72) | (A13-15) | (J5-98) | (A17-9) |
| (J5-21) | (A6-5) | (J5-47) | (A12-1) | (J5-73) | (A13-16) | (J5-99) | (A17-10) |
| (J5-22) | (A6-6) | (J5-48) | (A12-2) | (J5-74) | (A13-17) | (J5-100) | (A17-11) |
| (J5-23) | (A6-7) | (J5-49) | (A12-3) | (J5-75) | (A13-18) | (J5-101) | (A17-12) |
| (J5-24) | (A6-8) | (J5-50) | (A12-4) | (J5-76) | (A13-19) | (J5-102) | (A18-1) |
| (J5-25) | (A6-9) | (J5-51) | (A12-5) | (J5-77) | (A13-20) | (J5-103) | (A18-2) |
| (J5-26) | (A6-10) | (J5-52) | (A12-6) | (J5-78) | (A13-21) | | |

**[Table 6]**

| | | | | | | | |
|---|---|---|---|---|---|---|---|
| 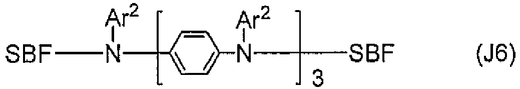 | | | | | | | |

| Compound | Ar² | Compound | Ar² | Compound | Ar² | Compound | Ar² |
|---|---|---|---|---|---|---|---|
| (J6-1) | (A1-1) | (J6-27) | (A6-11) | (J6-53) | (A12-7) | (J6-79) | (A13-22) |
| (J6-2) | (A1-2) | (J6-28) | (A6-12) | (J6-54) | (A12-8) | (J6-80) | (A13-23) |
| (J6-3) | (A2-1) | (J6-29) | (A6-13) | (J6-55) | (A12-9) | (J6-81) | (A13-24) |
| (J6-4) | (A2-2) | (J6-30) | (A6-14) | (J6-56) | (A12-10) | (J6-82) | (A14-1) |
| (J6-5) | (A2-3) | (J6-31) | (A6-15) | (J6-57) | (A12-11) | (J6-83) | (A14-2) |
| (J6-6) | (A2-4) | (J6-32) | (A7-1) | (J6-58) | (A13-1) | (J6-84) | (A14-3) |
| (J6-7) | (A2-5) | (J6-33) | (A7-2) | (J6-59) | (A13-2) | (J6-85) | (A14-4) |
| (J6-8) | (A3-1) | (J6-34) | (A7-3) | (J6-60) | (A13-3) | (J6-86) | (A15-1) |
| (J6-9) | (A3-2) | (J6-35) | (A8-1) | (J6-61) | (A13-4) | (J6-87) | (A15-2) |
| (J6-10) | (A3-3) | (J6-36) | (A8-2) | (J6-62) | (A13-5) | (J6-88) | (A15-3) |
| (J6-11) | (A4-1) | (J6-37) | (A8-3) | (J6-63) | (A13-6) | (J6-89) | (A15-4) |
| (J6-12) | (A4-2) | (J6-38) | (A9-1) | (J6-64) | (A13-7) | (J6-90) | (A17-1) |
| (J6-13) | (A4-3) | (J6-39) | (A9-2) | (J6-65) | (A13-8) | (J6-91) | (A17-2) |
| (J6-14) | (A5-1) | (J6-40) | (A9-3) | (J6-66) | (A13-9) | (J6-92) | (A17-3) |
| (J6-15) | (A5-2) | (J6-41) | (A10-1) | (J6-67) | (A13-10) | (J6-93) | (A17-4) |
| (J6-16) | (A5-3) | (J6-42) | (A10-2) | (J6-68) | (A13-11) | (J6-94) | (A17-5) |
| (J6-17) | (A6-1) | (J6-43) | (A10-3) | (J6-69) | (A13-12) | (J6-95) | (A17-6) |
| (J6-18) | (A6-2) | (J6-44) | (A11-1) | (J6-70) | (A13-13) | (J6-96) | (A17-7) |
| (J6-19) | (A6-3) | (J6-45) | (A11-2) | (J6-71) | (A13-14) | (J6-97) | (A17-8) |
| (J6-20) | (A6-4) | (J6-46) | (A11-3) | (J6-72) | (A13-15) | (J6-98) | (A17-9) |
| (J6-21) | (A6-5) | (J6-47) | (A12-1) | (J6-73) | (A13-16) | (J6-99) | (A17-10) |
| (J6-22) | (A6-6) | (J6-48) | (A12-2) | (J6-74) | (A13-17) | (J6-100) | (A17-11) |
| (J6-23) | (A6-7) | (J6-49) | (A12-3) | (J6-75) | (A13-18) | (J6-101) | (A17-12) |
| (J6-24) | (A6-8) | (J6-50) | (A12-4) | (J6-76) | (A13-19) | (J6-102) | (A18-1) |
| (J6-25) | (A6-9) | (J6-51) | (A12-5) | (J6-77) | (A13-20) | (J6-103) | (A18-2) |
| (J6-26) | (A6-10) | (J6-52) | (A12-6) | (J6-78) | (A13-21) | | |

**[Table 7]**

| | | | | | | | |
|---|---|---|---|---|---|---|---|
| 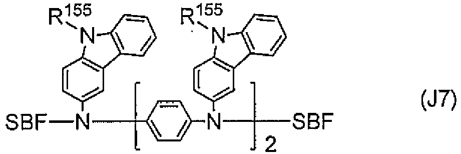 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J7-1) | (N1) | (J7-27) | (N27) | (J7-53) | (N53) | (J7-79) | -H |
| (J7-2) | (N2) | (J7-28) | (N28) | (J7-54) | (N54) | (J7-80) | -Me |
| (J7-3) | (N3) | (J7-29) | (N29) | (J7-55) | (N55) | (J7-81) | -Et |
| (J7-4) | (N4) | (J7-30) | (N30) | (J7-56) | (N56) | (J7-82) | -Prⁿ |
| (J7-5) | (N5) | (J7-31) | (N31) | (J7-57) | (N57) | (J7-83) | -Prⁱ |
| (J7-6) | (N6) | (J7-32) | (N32) | (J7-58) | (N58) | (J7-84) | -Buⁿ |
| (J7-7) | (N7) | (J7-33) | (N33) | (J7-59) | (N59) | (J7-85) | -Buⁱ |
| (J7-8) | (N8) | (J7-34) | (N34) | (J7-60) | (N60) | (J7-86) | -Bu^{s} |
| (J7-9) | (N9) | (J7-35) | (N35) | (J7-61) | (N61) | (J7-87) | -Bu^{t} |
| (J7-10) | (N10) | (J7-36) | (N36) | (J7-62) | (N62) | | |
| (J7-11) | (N11) | (J7-37) | (N37) | (J7-63) | (N63) | | |
| (J7-12) | (N12) | (J7-38) | (N38) | (J7-64) | (N64) | | |
| (J7-13) | (N13) | (J7-39) | (N39) | (J7-65) | (N65) | | |
| (J7-14) | (N14) | (J7-40) | (N40) | (J7-66) | (N66) | | |
| (J7-15) | (N15) | (J7-41) | (N41) | (J7-67) | (N67) | | |
| (J7-16) | (N16) | (J7-42) | (N42) | (J7-68) | (N68) | | |
| (J7-17) | (N17) | (J7-43) | (N43) | (J7-69) | (N69) | | |
| (J7-18) | (N18) | (J7-44) | (N44) | (J7-70) | (N70) | | |
| (J7-19) | (N19) | (J7-45) | (N45) | (J7-71) | (N71) | | |
| (J7-20) | (N20) | (J7-46) | (N46) | (J7-72) | (N72) | | |
| (J7-21) | (N21) | (J7-47) | (N47) | (J7-73) | (N73) | | |
| (J7-22) | (N22) | (J7-48) | (N48) | (J7-74) | (N74) | | |
| (J7-23) | (N23) | (J7-49) | (N49) | (J7-75) | (N75) | | |
| (J7-24) | (N24) | (J7-50) | (N50) | (J7-76) | (N76) | | |
| (J7-25) | (N25) | (J7-51) | (N51) | (J7-77) | (N77) | | |
| (J7-26) | (N26) | (J7-52) | (N52) | (J7-78) | (N78) | | |

**[Table 8]**

| | | | | | | | |
|---|---|---|---|---|---|---|---|
| 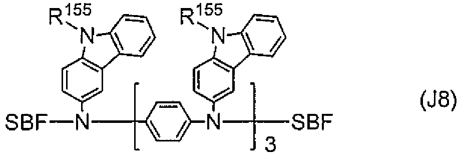 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J8-1) | (N1) | (J8-27) | (N27) | (J8-53) | (N53) | (J8-79) | -H |
| (J8-2) | (N2) | (J8-28) | (N28) | (J8-54) | (N54) | (J8-80) | -Me |
| (J8-3) | (N3) | (J8-29) | (N29) | (J8-55) | (N55) | (J8-81) | -Et |
| (J8-4) | (N4) | (J8-30) | (N30) | (J8-56) | (N56) | (J8-82) | -Prⁿ |
| (J8-5) | (N5) | (J8-31) | (N31) | (J8-57) | (N57) | (J8-83) | -Prⁱ |
| (J8-6) | (N6) | (J8-32) | (N32) | (J8-58) | (N58) | (J8-84) | -Buⁿ |
| (J8-7) | (N7) | (J8-33) | (N33) | (J8-59) | (N59) | (J8-85) | -Buⁱ |
| (J8-8) | (N8) | (J8-34) | (N34) | (J8-60) | (N60) | (J8-86) | -Bu^{s} |
| (J8-9) | (N9) | (J8-35) | (N35) | (J8-61) | (N61) | (J8-87) | -Bu^{t} |
| (J8-10) | (N10) | (J8-36) | (N36) | (J8-62) | (N62) | | |
| (J8-11) | (N11) | (J8-37) | (N37) | (J8-63) | (N63) | | |
| (J8-12) | (N12) | (J8-38) | (N38) | (J8-64) | (N64) | | |
| (J8-13) | (N13) | (J8-39) | (N39) | (J8-65) | (N65) | | |
| (J8-14) | (N14) | (J8-40) | (N40) | (J8-66) | (N66) | | |
| (J8-15) | (N15) | (J8-41) | (N41) | (J8-67) | (N67) | | |
| (J8-16) | (N16) | (J8-42) | (N42) | (J8-68) | (N68) | | |
| (J8-17) | (N17) | (J8-43) | (N43) | (J8-69) | (N69) | | |
| (J8-18) | (N18) | (J8-44) | (N44) | (J8-70) | (N70) | | |
| (J8-19) | (N19) | (J8-45) | (N45) | (J8-71) | (N71) | | |
| (J8-20) | (N20) | (J8-46) | (N46) | (J8-72) | (N72) | | |
| (J8-21) | (N21) | (J8-47) | (N47) | (J8-73) | (N73) | | |
| (J8-22) | (N22) | (J8-48) | (N48) | (J8-74) | (N74) | | |
| (J8-23) | (N23) | (J8-49) | (N49) | (J8-75) | (N75) | | |
| (J8-24) | (N24) | (J8-50) | (N50) | (J8-76) | (N76) | | |
| (J8-25) | (N25) | (J8-51) | (N51) | (J8-77) | (N77) | | |
| (J8-26) | (N26) | (J8-52) | (N52) | (J8-78) | (N78) | | |

**[Table 9]**

| | | | | | | | |
|---|---|---|---|---|---|---|---|
| 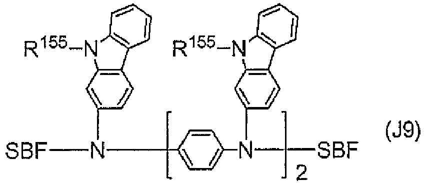 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J9-1) | (N1) | (J9-27) | (N27) | (J9-53) | (N53) | (J9-79) | -H |
| (J9-2) | (N2) | (J9-28) | (N28) | (J9-54) | (N54) | (J9-80) | -Me |
| (J9-3) | (N3) | (J9-29) | (N29) | (J9-55) | (N55) | (J9-81) | -Et |
| (J9-4) | (N4) | (J9-30) | (N30) | (J9-56) | (N56) | (J9-82) | -Prⁿ |
| (J9-5) | (N5) | (J9-31) | (N31) | (J9-57) | (N57) | (J9-83) | -Pr^{l} |
| (J9-6) | (N6) | (J9-32) | (N32) | (J9-58) | (N58) | (J9-84) | -Buⁿ |
| (J9-7) | (N7) | (J9-33) | (N33) | (J9-59) | (N59) | (J9-85) | -Buⁱ |
| (J9-8) | (N8) | (J9-34) | (N34) | (J9-60) | (N60) | (J9-86) | -Bu^{s} |
| (J9-9) | (N9) | (J9-35) | (N35) | (J9-61) | (N61) | (J9-87) | -Bu^{t} |
| (J9-10) | (N10) | (J9-36) | (N36) | (J9-62) | (N62) | | |
| (J9-11) | (N11) | (J9-37) | (N37) | (J9-63) | (N63) | | |
| (J9-12) | (N12) | (J9-38) | (N38) | (J9-64) | (N64) | | |
| (J9-13) | (N13) | (J9-39) | (N39) | (J9-65) | (N65) | | |
| (J9-14) | (N14) | (J9-40) | (N40) | (J9-66) | (N66) | | |
| (J9-15) | (N15) | (J9-41) | (N41) | (J9-67) | (N67) | | |
| (J9-16) | (N16) | (J9-42) | (N42) | (J9-68) | (N68) | | |
| (J9-17) | (N17) | (J9-43) | (N43) | (J9-69) | (N69) | | |
| (J9-18) | (N18) | (J9-44) | (N44) | (J9-70) | (N70) | | |
| (J9-19) | (N19) | (J9-45) | (N45) | (J9-71) | (N71) | | |
| (J9-20) | (N20) | (J9-46) | (N46) | (J9-72) | (N72) | | |
| (J9-21) | (N21) | (J9-47) | (N47) | (J9-73) | (N73) | | |
| (J9-22) | (N22) | (J9-48) | (N48) | (J9-74) | (N74) | | |
| (J9-23) | (N23) | (J9-49) | (N49) | (J9-75) | (N75) | | |
| (J9-24) | (N24) | (J9-50) | (N50) | (J9-76) | (N76) | | |
| (J9-25) | (N25) | (J9-51) | (N51) | (J9-77) | (N77) | | |
| (J9-26) | (N26) | (J9-52) | (N52) | (J9-78) | (N78) | | |

**[Table 10]**

| | | | | | | | |
|---|---|---|---|---|---|---|---|
| 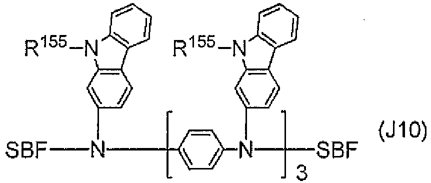 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J10-1) | (N1) | (J10-27) | (N27) | (J10-53) | (N53) | (J10-79) | -H |
| (J10-2) | (N2) | (J10-28) | (N28) | (J10-54) | (N54) | (J10-80) | -Me |
| (J10-3) | (N3) | (J10-29) | (N29) | (J10-55) | (N55) | (J10-81) | -Et |
| (J10-4) | (N4) | (J10-30) | (N30) | (J10-56) | (N56) | (J10-82) | -Prⁿ |
| (J10-5) | (N5) | (J10-31) | (N31) | (J10-57) | (N57) | (J10-83) | -Pr^{l} |
| (J10-6) | (N6) | (J10-32) | (N32) | (J10-58) | (N58) | (J10-84) | -Buⁿ |
| (J10-7) | (N7) | (J10-33) | (N33) | (J10-59) | (N59) | (J10-85) | -Buⁱ |
| (J10-8) | (N8) | (J10-34) | (N34) | (J10-60) | (N60) | (J10-80) | -Bu^{s} |
| (J10-9) | (N9) | (J10-35) | (N35) | (J10-61) | (N61) | (J10-87) | -Bu^{t} |
| (J10-10) | (N10) | (J10-38) | (N36) | (J10-62) | (N62) | | |
| (J10-11) | (N11) | (J10-37) | (N37) | (J10-63) | (N63) | | |
| (J10-12) | (N12) | (J10-38) | (N38) | (J10-64) | (N64) | | |
| (J10-13) | (N13) | (J10-39) | (N39) | (J10-65) | (N65) | | |
| (J10-14) | (N14) | (J10-40) | (N40) | (J10-66) | (N66) | | |
| (J10-15) | (N15) | (J10-41) | (N41) | (J10-67) | (N67) | | |
| (J10-16) | (N16) | (J10-42) | (N42) | (J10-68) | (N68) | | |
| (J10-17) | (N17) | (J10-43) | (N43) | (J10-69) | (N69) | | |
| (J10-18) | (N18) | (J10-44) | (N44) | (J10-70) | (N70) | | |
| (J10-19) | (N19) | (J10-45) | (N45) | (J10-71) | (N71) | | |
| (J10-20) | (N20) | (J10-46) | (N46) | (J10-72) | (N72) | | |
| (J10-21) | (N21) | (J10-47) | (N47) | (J10-73) | (N73) | | |
| (J10-22) | (N22) | (J10-48) | (N48) | (J10-74) | (N74) | | |
| (J10-23) | (N23) | (J10-49) | (N49) | (J10-75) | (N75) | | |
| (J10-24) | (N24) | (J10-50) | (N50) | (J10-76) | (N76) | | |
| (J10-25) | (N25) | (J10-51) | (N51) | (J10-77) | (N77) | | |
| (J10-26) | (N26) | (J10-52) | (N52) | (J10-78) | (N78) | | |

**[Table 11]**

| | | | | | | | |
|---|---|---|---|---|---|---|---|
| 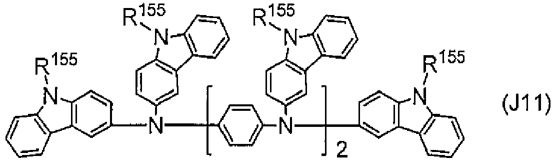 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J11-1) | (N1) | (J11-27) | (N27) | (J11-53) | (N53) | (J11-79) | -H |
| (J11-2) | (N2) | (J11-28) | (N28) | (J11-54) | (N54) | (J11-80) | -Me |
| (J11-3) | (N3) | (J11-29) | (N29) | (J11-55) | (N55) | (J11-81) | -Et |
| (J11-4) | (N4) | (J11-30) | (N30) | (J11-56) | (N56) | (J11-82) | -Prⁿ |
| (J11-5) | (N5) | (J 11-31) | (N31) | (J11-57) | (N57) | (J11-83) | -Prⁱ |
| (J11-6) | (N6) | (J11-32) | (N32) | (J11-58) | (N58) | (J11-84) | -Buⁿ |
| (J11-7) | (N7) | (J11-33) | (N33) | (J11-59) | (N59) | (J11-85) | -Buⁱ |
| (J11-8) | (N8) | (J11-34) | (N34) | (J11-60) | (N60) | (J11-86) | -Bu^{s} |
| (J11-9) | (N9) | (J11-35) | (N35) | (J11-61) | (N61) | (J11-87) | -Bu^{t} |
| (J11-10) | (N10) | (J11-36) | (N36) | (J11-62) | (N62) | | |
| (J11-11) | (N11) | (J11-37) | (N37) | (J11-63) | (N63) | | |
| (J11-12) | (N12) | (J11-38) | (N38) | (J11-64) | (N64) | | |
| (J11-13) | (N13) | (J11-39) | (N39) | (J11-65) | (N65) | | |
| (J11-14) | (N14) | (J11-40) | (N40) | (J11-66) | (N66) | | |
| (J11-15) | (N15) | (J11-41) | (N41) | (J11-67) | (N67) | | |
| (J11-16) | (N16) | (J11-42) | (N42) | (J11-68) | (N68) | | |
| (J11-17) | (N17) | (J11-43) | (N43) | (J11-69) | (N69) | | |
| (J11-18) | (N18) | (J11-44) | (N44) | (J11-70) | (N70) | | |
| (J11-19) | (N19) | (J11-45) | (N45) | (J11-71) | (N71) | | |
| (J11-20) | (N20) | (J11-46) | (N46) | (J11-72) | (N72) | | |
| (J11-21) | (N21) | (J11-47) | (N47) | (J11-73) | (N73) | | |
| (J11-22) | (N22) | (J11-48) | (N48) | (J11-74) | (N74) | | |
| (J11-23) | (N23) | (J11-49) | (N49) | (J11-75) | (N75) | | |
| (J11-24) | (N24) | (J11-50) | (N50) | (J11-76) | (N76) | | |
| (J11-25) | (N25) | (J11-51) | (N51) | (J11-77) | (N77) | | |
| (J11-26) | (N26) | (J11-52) | (N52) | (J11-78) | (N78) | | |

**[Table 12]**

| | | | | | | | |
|---|---|---|---|---|---|---|---|
| 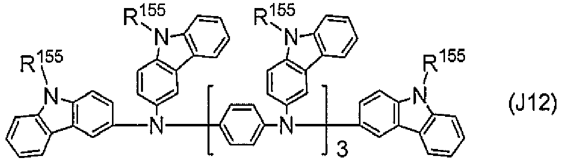 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J12-1) | (N1) | (J12-27) | (N27) | (J12-53) | (N53) | (J12-79) | -H |
| (J12-2) | (N2) | (J12-28) | (N28) | (J 12-54) | (N54) | (J12-80) | -Me |
| (J12-3) | (N3) | (J12-29) | (N29) | (J12-55) | (N55) | (J12-81) | -Et |
| (J12-4) | (N4) | (J12-30) | (N30) | (J12-56) | (N56) | (J12-82) | -Prⁿ |
| (J12-5) | (N5) | (J12-31) | (N31) | (J12-57) | (N57) | (J12-83) | -Prⁱ |
| (J12-6) | (N6) | (J12-32) | (N32) | (J12-58) | (N58) | (J12-84) | -Buⁿ |
| (J12-7) | (N7) | (J12-33) | (N33) | (J12-59) | (N59) | (J12-85) | -Buⁱ |
| (J12-8) | (N8) | (J12-34) | (N34) | (J12-60) | (N60) | (J12-86) | -Bu^{s} |
| (J12-9) | (N9) | (J12-35) | (N35) | (J12-61) | (N61) | (J12-87) | -Bu^{t} |
| (J12-10) | (N10) | (J12-36) | (N36) | (J12-62) | (N62) | | |
| (J12-11) | (N11) | (J12-37) | (N37) | (J12-63) | (N63) | | |
| (J12-12) | (N12) | (J12-38) | (N38) | (J12-64) | (N64) | | |
| (J12-13) | (N13) | (J12-39) | (N39) | (J12-65) | (N65) | | |
| (J12-14) | (N14) | (J12-40) | (N40) | (J12-66) | (N66) | | |
| (J12-15) | (N15) | (J12-41) | (N41) | (J12-67) | (N67) | | |
| (J12-16) | (N16) | (J12-42) | (N42) | (J12-68) | (N68) | | |
| (J12-17) | (N17) | (J12-43) | (N43) | (J12-69) | (N69) | | |
| (J12-18) | (N18) | (J12-44) | (N44) | (J12-70) | (N70) | | |
| (J12-19) | (N19) | (J12-45) | (N45) | (J12-71) | (N71) | | |
| (J12-20) | (N20) | (J12-46) | (N46) | (J12-72) | (N72) | | |
| (J12-21) | (N21) | (J12-47) | (N47) | (J12-73) | (N73) | | |
| (J12-22) | (N22) | (J12-48) | (N48) | (J12-74) | (N74) | | |
| (J12-23) | (N23) | (J12-49) | (N49) | (J12-75) | (N75) | | |
| (J12-24) | (N24) | (J12-50) | (N50) | (J12-76) | (N76) | | |
| (J12-25) | (N25) | (J12-51) | (N51) | (J12-77) | (N77) | | |
| (J12-26) | (N26) | (J12-52) | (N52) | (J12-78) | (N78) | | |

**[Table 13]**

| | | | | | | | |
|---|---|---|---|---|---|---|---|
| 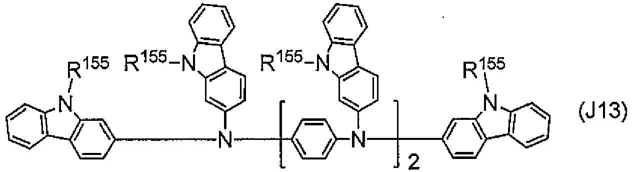 | | | | | | | |

| Compound | R¹⁵⁵ | Compound | R¹⁵⁵ | Compound | R¹⁵⁵ | Compound | R¹⁵⁵ |
|---|---|---|---|---|---|---|---|
| (J13-1) | (N1) | (J13-27) | (N27) | (J13-53) | (N53) | (J13-79) | -H |
| (J13-2) | (N2) | (J13-28) | (N28) | (J13-54) | (N54) | (J13-80) | -Me |
| (J13-3) | (N3) | (J13-29) | (N29) | (J13-55) | (N55) | (J13-81) | -Et |
| (J13-4) | (N4) | (J13-30) | (N30) | (J13-56) | (N56) | (J13-82) | -Prⁿ |
| (J13-5) | (N5) | (J13-31) | (N31) | (J13-57) | (N57) | (J13-83) | -Prⁱ |
| (J13-6) | (N6) | (J13-32) | (N32) | (J13-58) | (N58) | (J13-84) | -Buⁿ |
| (J13-7) | (N7) | (J13-33) | (N33) | (J13-59) | (N59) | (J13-85) | -Buⁱ |
| (J13-8) | (N8) | (J13-34) | (N34) | (J13-60) | (N60) | (J13-86) | -Bu^{s} |
| (J13-9) | (N9) | (J13-35) | (N35) | (J13-61) | (N61) | (J13-87) | -Bu^{t} |
| (J13-10) | (N10) | (J13-36) | (N36) | (J13-62) | (N62) | | |
| (J13-11) | (N11) | (J13-37) | (N37) | (J13-63) | (N63) | | |
| (J13-12) | (N12) | (J13-38) | (N38) | (J13-64) | (N64) | | |
| (J13-13) | (N13) | (J13-39) | (N39) | (J13-65) | (N65) | | |
| (J13-14) | (N14) | (J13-40) | (N40) | (J13-66) | (N66) | | |
| (J13-15) | (N15) | (J13-41) | (N41) | (J13-67) | (N67) | | |
| (J13-16) | (N16) | (J13-42) | (N42) | (J13-68) | (N68) | | |
| (J13-17) | (N17) | (J13-43) | (N43) | (J13-69) | (N69) | | |
| (J13-18) | (N18) | (J13-44) | (N44) | (J13-70) | (N70) | | |
| (J13-19) | (N19) | (J13-45) | (N45) | (J13-71) | (N71) | | |
| (J13-20) | (N20) | (J13-46) | (N46) | (J13-72) | (N72) | | |
| (J13-21) | (N21) | (J13-47) | (N47) | (J13-73) | (N73) | | |
| (J13-22) | (N22) | (J13-48) | (N48) | (J13-74) | (N74) | | |
| (J13-23) | (N23) | (J13-49) | (N49) | (J13-75) | (N75) | | |
| (J13-24) | (N24) | (J13-50) | (N50) | (J13-76) | (N76) | | |
| (J13-25) | (N25) | (J13-51) | (N51) | (J13-77) | (N77) | | |
| (J13-26) | (N26) | (J13-52) | (N52) | (J13-78) | (N78) | | |

**[Table 14]**

| | | | | | | | |
|---|---|---|---|---|---|---|---|
| 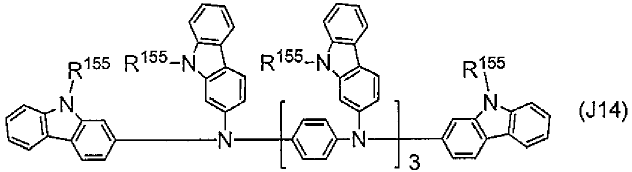 | | | | | | | |

| **Compound** | **R¹⁵⁵** | **Compound** | **R¹⁵⁵** | **Compound** | **R¹⁵⁵** | **Compound** | **R¹⁵⁵** |
|---|---|---|---|---|---|---|---|
| (J14-1) | (N1) | (J14-27) | (N27) | (J14-53) | (N53) | (J14-79) | -H |
| (J14-2) | (N2) | (J14-28) | (N28) | (J14-54) | (N54) | (J 14-80) | -Me |
| (J14-3) | (N3) | (J14-29) | (N29) | (J14-55) | (N55) | (J14-81) | -Et |
| (J14-4) | (N4) | (J14-30) | (N30) | (J14-56) | (N56) | (J14-82) | -Prⁿ |
| (J14-5) | (N5) | (J14-31) | (N31) | (J14-57) | (N57) | (J14-83) | -Prⁱ |
| (J14-6) | (N6) | (J14-32) | (N32) | (J14-58) | (N58) | (J14-84) | -Buⁿ |
| (J14-7) | (N7) | (J14-33) | (N33) | (J14-59) | (N59) | (J14-85) | -Bu^{l} |
| (J14-8) | (N8) | (J14-34) | (N34) | (J14-60) | (N60) | (J14-86) | -Bu^{s} |
| (J14-9) | (N9) | (J14-35) | (N35) | (J14-61) | (N61) | (J14-87) | -Bu^{t} |
| (J14-10) | (N10) | (J14-36) | (N36) | (J14-62) | (N62) | | |
| (J14-11) | (N11) | (J14-37) | (N37) | (J14-63) | (N63) | | |
| (J14-12) | (N12) | (J14-38) | (N38) | (J14-64) | (N64) | | |
| (J14-13) | (N13) | (J14-39) | (N39) | (J14-65) | (N65) | | |
| (J14-14) | (N14) | (J14-40) | (N40) | (J14-66) | (N66) | | |
| (J14-15) | (N15) | (J14-41) | (N41) | (J14-67) | (N67) | | |
| (J14-16) | (N16) | (J14-42) | (N42) | (J14-68) | (N68) | | |
| (J14-17) | (N17) | (J14-43) | (N43) | (J14-69) | (N69) | | |
| (J14-18) | (N18) | (J14-44) | (N44) | (J14-70) | (N70) | | |
| (J14-19) | (N19) | (J14-45) | (N45) | (J14-71) | (N71) | | |
| (J14-20) | (N20) | (J14-46) | (N46) | (J14-72) | (N72) | | |
| (J14-21) | (N21) | (J14-47) | (N47) | (J14-73) | (N73) | | |
| (J14-22) | (N22) | (J14-48) | (N48) | (J14-74) | (N74) | | |
| (J14-23) | (N23) | (J14-49) | (N49) | (J14-75) | (N75) | | |
| (J14-24) | (N24) | (J14-50) | (N50) | (J14-76) | (N76) | | |
| (J14-25) | (N25) | (J14-51) | (N51) | (J14-77) | (N77) | | |
| (J14-26) | (N26) | (J14-52) | (N52) | (J14-78) | (N78) | | |

**[Table 15]**

| | | | | | | | |
|---|---|---|---|---|---|---|---|
| 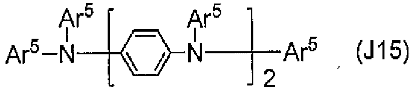 | | | | | | | |

| **Compound** | **Ar⁵** | **Compound** | **Ar⁵** | **Compound** | **Ar⁵** | **Compound** | **Ar⁵** |
|---|---|---|---|---|---|---|---|
| (J15-1) | (A1-1) | (J15-27) | (A6-11) | (J15-53) | (A12-7) | (J15-79) | (A13-22) |
| (J15-2) | (A1-2) | (J15-28) | (A6-12) | (J15-54) | (A12-8) | (J15-80) | (A13-23) |
| (J15-3) | (A2-1) | (J15-29) | (A6-13) | (J15-55) | (A12-9) | (J15-81) | (A13-24) |
| (J15-4) | (A2-2) | (J15-30) | (A6-14) | (J15-56) | (A12-10) | (J15-82) | (A14-1) |
| (J15-5) | (A2-3) | (J15-31) | (A6-15) | (J15-57) | (A12-11) | (J15-83) | (A14-2) |
| (J15-6) | (A2-4) | (J15-32) | (A7-1) | (J15-58) | (A13-1) | (J 15-84) | (A14-3) |
| (J15-7) | (A2-5) | (J15-33) | (A7-2) | (J15-59) | (A13-2) | (J15-85) | (A14-4) |
| (J15-8) | (A3-1) | (J15-34) | (A7-3) | (J15-60) | (A13-3) | (J15-86) | (A15-1) |
| (J15-9) | (A3-2) | (J15-35) | (A8-1) | (J15-61) | (A13-4) | (J15-87) | (A15-2) |
| (J15-10) | (A3-3) | (J15-36) | (A8-2) | (J15-62) | (A13-5) | (J15-88) | (A15-3) |
| (J15-11) | (A4-1) | (J15-37) | (A8-3) | (J15-63) | (A13-6) | (J15-89) | (A15-4) |
| (J15-12) | (A4-2) | (J15-38) | (A9-1) | (J15-64) | (A13-7) | (J15-90) | (A17-1) |
| (J15-13) | (A4-3) | (J15-39) | (A9-2) | (J15-65) | (A13-8) | (J15-91) | (A17-2) |
| (J15-14) | (A5-1) | (J15-40) | (A9-3) | (J15-66) | (A13-9) | (J15-92) | (A17-3) |
| (J15-15) | (A5-2) | (J15-41) | (A10-1) | (J15-67) | (A13-10) | (J15-93) | (A17-4) |
| (J15-16) | (A5-3) | (J15-42) | (A10-2) | (J15-68) | (A13-11) | (J15-94) | (A17-5) |
| (J15-17) | (A6-1) | (J15-43) | (A10-3) | (J15-69) | (A13-12) | (J15-95) | (A17-6) |
| (J15-18) | (A6-2) | (J15-44) | (A11-1) | (J15-70) | (A13-13) | (J15-96) | (A17-7) |
| (J15-19) | (A6-3) | (J15-45) | (A11-2) | (J15-71) | (A13-14) | (J15-97) | (A17-8) |
| (J15-20) | (A6-4) | (J15-46) | (A11-3) | (J15-72) | (A13-15) | (J15-98) | (A17-9) |
| (J15-21) | (A6-5) | (J15-47) | (A12-1) | (J15-73) | (A13-16) | (J15-99) | (A17-10) |
| (J15-22) | (A6-6) | (J15-48) | (A12-2) | (J15-74) | (A13-17) | (J15-100) | (A17-11) |
| (J15-23) | (A6-7) | (J15-49) | (A12-3) | (J15-75) | (A13-18) | (J15-101) | (A17-12) |
| (J15-24) | (A6-8) | (J15-50) | (A12-4) | (J15-76) | (A13-19) | (J15-102) | (A18-1) |
| (J16-25) | (A6-9) | (J15-51) | (A12-5) | (J15-77) | (A13-20) | (J15-103) | (A18-2) |
| (J15-26) | (A6-10) | (J15-52) | (A12-6) | (J15-78) | (A13-21) | | |

**[Table 16]**

| | | | | | | | |
|---|---|---|---|---|---|---|---|
| 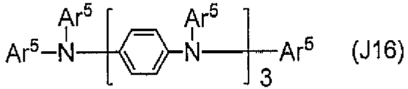 | | | | | | | |

| **Compound** | **Ar⁵** | **Compound** | **Ar⁵** | **Compound** | **Ar⁵** | **Compound** | **Ar⁵** |
|---|---|---|---|---|---|---|---|
| (J16-1) | (A1-1) | (J16-27) | (A6-11) | (J16-53) | (A12-7) | (J16-79) | (A13-22) |
| (J16-2) | (A1-2) | (J16-28) | (A6-12) | (J16-54) | (A12-8) | (J16-80) | (A13-23) |
| (J16-3) | (A2-1) | (J16-29) | (A6-13) | (J16-55) | (A12-9) | (J16-81) | (A13-24) |
| (J16-4) | (A2-2) | (J16-30) | (A6-14) | (J16-56) | (A12-10) | (J16-82) | (A14-1) |
| (J16-5) | (A2-3) | (J16-31) | (A6-15) | (J16-57) | (A12-11) | (J16-83) | (A14-2) |
| (J16-6) | (A2-4) | (J16-32) | (A7-1) | (J16-58) | (A13-1) | (J16-84) | (A14-3) |
| (J16-7) | (A2-5) | (J16-33) | (A7-2) | (J16-59) | (A13-2) | (J16-85) | (A14-4) |
| (J16-8) | (A3-1) | (J16-34) | (A7-3) | (J16-60) | (A13-3) | (J16-86) | (A15-1) |
| (J16-9) | (A3-2) | (J16-35) | (A8-1) | (J16-61) | (A13-4) | (J16-87) | (A15-2) |
| (J16-10) | (A3-3) | (J16-36) | (A8-2) | (J16-62) | (A13-5) | (J16-88) | (A15-3) |
| (J16-11) | (A4-1) | (J16-37) | (A8-3) | (J16-63) | (A13-6) | (J16-89) | (A15-4) |
| (J16-12) | (A4-2) | (J16-38) | (A9-1) | (J16-64) | (A13-7) | (J16-90) | (A17-1) |
| (J16-13) | (A4-3) | (J16-39) | (A9-2) | (J16-65) | (A13-8) | (J16-91) | (A17-2) |
| (J16-14) | (A5-1) | (J16-40) | (A9-3) | (J16-66) | (A13-9) | (J16-92) | (A17-3) |
| (J16-15) | (A5-2) | (J16-41) | (A10-1) | (J16-67) | (A13-10) | (J16-93) | (A17-4) |
| (J16-16) | (A5-3) | (J16-42) | (A10-2) | (J16-68) | (A13-11) | (J16-94) | (A17-5) |
| (J16-17) | (A6-1) | (J16-43) | (A10-3) | (J16-69) | (A13-12) | (J16-95) | (A17-6) |
| (J16-18) | (A6-2) | (J16-44) | (A11-1) | (J16-70) | (A13-13) | (J16-96) | (A17-7) |
| (J16-19) | (A6-3) | (J16-45) | (A11-2) | (J16-71) | (A13-14) | (J16-97) | (A17-8) |
| (J16-20) | (A6-4) | (J16-46) | (A11-3) | (J16-72) | (A13-15) | (J16-98). | (A17-9) |
| (J16-21) | (A6-5) | (J16-47) | (A12-1) | (J16-73) | (A13-16) | (J16-99) | (A17-10) |
| (J16-22) | (A6-6) | (J16-48) | (A12-2) | (J16-74) | (A13-17) | (J16-100) | (A17-11) |
| (J16-23) | (A6-7) | (J16-49) | (A12-3) | (J16-75) | (A13-18) | (J16-101) | (A17-12) |
| (J16-24) | (A6-8) | (J16-50) | (A12-4) | (J16-76) | (A13-19) | (J16-102) | (A18-1) |
| (J16-25) | (A6-9) | (J16-51) | (A12-5) | (J16-77) | (A13-20) | (J16-103) | (A18-2) |
| (J16-26) | (A6-10) | (J16-52) | (A12-6) | (J16-78) | (A13-21) | | |

**[Table 17]**

| | | | | | | | |
|---|---|---|---|---|---|---|---|
| 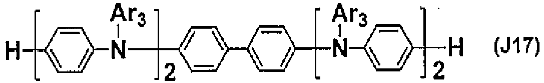 | | | | | | | |

| **Compound** | **Ar³** | **Compound** | **Ar³** | **Compound** | **Ar³** | **Compound** | **Ar³** |
|---|---|---|---|---|---|---|---|
| (J17-1) | (C1') | (J17-3) | (C3') | (J17-5) | (C5') | (J17-7) | (C7') |
| (J17-2) | (C2') | (J17-4) | (C4') | (J17-6) | (C6') | (J17-8) | (C8') |

**[Table 18]**

| | | | | | | | |
|---|---|---|---|---|---|---|---|
| 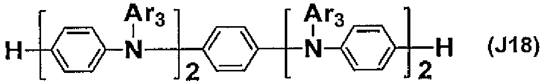 | | | | | | | |

| **Compound** | **Ar³** | **Compound** | **Ar³** | **Compound** | **Ar³** | **Compound** | **Ar³** |
|---|---|---|---|---|---|---|---|
| (J18-1) | (C1') | (J18-3) | (C3') | (J18-5) | (C5') | (J18-7) | (C7') |
| (J18-2) | (C2') | (J18-4) | (C4') | (J18-6) | (C6') | (J18-8) | (C8') |

In this invention, the molar ratio between the onium borate salt and the charge-transporting substance (charge-transporting substance : onium borate salt) may be set to from about 1:0.1 to about 1:10.

The organic solvent used when preparing the charge-transporting varnish may be a high-solvency solvent that is capable of dissolving well the charge-transporting substance and the onium borate salt.

Examples of such high-solvency solvents include, but are not limited to, organic solvents such as cyclohexanone, N,N-dimethylformamide, N,N-dimethylacetamide, N-methylpyrrolidone, 1,3-dimethyl-2-imidazolidinone and diethylene glycol monomethyl ether. These solvents may be used singly or two or more may be used in admixture. The amount of use may be set to from 5 to 100 wt% with respect to all of the solvent used in the varnish.

In the present invention, at least one type of high-viscosity organic solvent having a viscosity at 25°C of from 10 to 200 mPa·s, especially from 35 to 150 mPa·s, and a boiling point at standard pressure (atmospheric pressure) of from 50 to 300°C, especially from 150 to 250°C, may be included in the varnish. Including such a solvent makes the viscosity of the varnish easy to adjust, as a result of which a varnish which reproducibly gives thin films of high flatness and is suitable for the method of application can be prepared.

Examples of high-viscosity organic solvents include, but are not limited to, cyclohexanol, ethylene glycol, ethylene glycol diglycidyl ether, 1,3-octylene glycol, diethylene glycol, dipropylene glycol, triethylene glycol, tripropylene glycol, 1,3-butanediol, 2,3-butanediol, 1,4-butanediol, propylene glycol and hexylene glycol. These solvents may be used singly, or two or more may be used in admixture.

The addition ratio of the high-viscosity organic solvent with respect to the overall solvent used in the varnish of the invention is preferably in a range within which the deposition of solids does not occur. An addition ratio of from 5 to 90 wt% is preferred, so long as solids do not deposit out.

In addition, another solvent may also be admixed in a ratio with respect to the overall solvent used in the varnish of from 1 to 90 wt%, and preferably from 1 to 50 wt%, for such purposes as to increase the wettability on a substrate and adjust the surface tension, polarity and boiling point of the solvent.

Examples of such solvents include, but are not limited to, propylene glycol monomethyl ether, ethylene glycol monobutyl ether, diethylene glycol diethyl ether, diethylene glycol dimethyl ether, diethylene glycol monoethyl ether acetate, diethylene glycol monobutyl ether acetate, dipropylene glycol monomethyl ether, propylene glycol monomethyl ether acetate, diethylene glycol monoethyl ether, diacetone alcohol, γ-butyrolactone, ethyl lactate and n-hexyl acetate. These solvents may be used singly or two or more may be used in admixture.

The charge-transporting varnish of the invention may include an organosilane compound. In cases where a thin film obtained from the varnish is used as a hole-injecting layer in an organic EL device, including an organosilane compound makes it possible to increase the ability to inject holes into a layer, such as a hole-transporting layer or a light-emitting layer, that is deposited on the opposite side from the anode so as to be in contact with the hole-injecting layer.

Examples of such organosilane compounds include dialkoxysilane compounds, trialkoxysilane compounds and tetraalkoxysilane compounds. These may be used singly, or two or more may be used in combination.

In this invention, the organosilane compound preferably includes one type selected from among dialkoxysilane compounds and trialkoxysilane compounds, more preferably includes a trialkoxysilane compound, and even more preferably includes a fluorine atom-containing trialkoxysilane compound.

These alkoxysilane compounds are exemplified by the compounds of formulas (S1) to (S3) below.

Si(OR)₄ (S1)

SiR'(OR)₃ (S2)

Si(R')₂(OR)₂ (S3)

In the formulas, each R is independently an alkyl group of 1 to 20 carbon atoms which may be substituted with Z⁶, an alkenyl group of 2 to 20 carbon atoms which may be substituted with Z⁶, an alkynyl group of 2 to 20 carbon atoms which may be substituted with Z⁶, an aryl group of 6 to 20 carbon atoms which may be substituted with Z⁷ or a heteroaryl group of 2 to 20 carbon atoms which may be substituted with Z⁷; and each R' is independently an alkyl group of 1 to 20 carbon atoms which may be substituted with Z⁸, an alkenyl group of 2 to 20 carbon atoms which may be substituted with Z⁸, an alkynyl group of 2 to 20 carbon atoms which may be substituted with Z⁸, an aryl group of 6 to 20 carbon atoms which may be substituted with Z⁹, or a heteroaryl group of 2 to 20 carbon atoms which may be substituted with Z⁹.

Z⁶ is a halogen atom, an aryl group of 6 to 20 carbon atoms which may be substituted with Z¹⁰, or a heteroaryl group of 2 to 20 carbon atoms which may be substituted with Z¹⁰. Z⁷ is a halogen atom, an alkyl group of 1 to 20 carbon atoms which may be substituted with Z¹⁰, an alkenyl group of 2 to 20 carbon atoms which may be substituted with Z¹⁰, or an alkynyl group of 2 to 20 carbon atoms which may be substituted with Z¹⁰.

Z⁸ is a halogen atom, an aryl group of 6 to 20 carbon atoms which may be substituted with Z¹⁰, a heteroaryl group of 2 to 20 carbon atoms which may be substituted with Z¹⁰, an epoxycyclohexyl group, a glycidoxy group, a methacryloxy group, an acryloxy group, a ureido group (-NHCONH₂), a thiol group, an isocyanate group (-NCO), an amino group, a -NHY¹ group, or a -NY²Y³ group. Z⁹ is a halogen atom, an alkyl group of 1 to 20 carbon atoms which may be substituted with Z¹⁰, an alkenyl group of 2 to 20 carbon atoms which may be substituted with Z¹⁰, an alkynyl group of 2 to 20 carbon atoms which may be substituted with Z¹⁰, an epoxycyclohexyl group, a glycidoxy group, a methacryloxy group, an acryloxy group, a ureido group (-NHCONH₂), a thiol group, an isocyanate group (-NCO), an amino group, a -NHY¹ group, or a -NY²Y³ group. Y¹ to Y³ are each independently an alkyl group of 1 to 20 carbon atoms which may be substituted with Z¹⁰, an alkenyl group of 2 to 20 carbon atoms which may be substituted with Z¹⁰, an alkynyl group of 2 to 20 carbon atoms which may be substituted with Z¹⁰, an aryl group of 6 to 20 carbon atoms which may be substituted with Z¹⁰, or a heteroaryl group of 2 to 20 carbon atoms which may be substituted with Z¹⁰.

Z¹⁰ is a halogen atom, an amino group, a nitro group, a cyano group or a thiol group.

The halogen atoms, alkyl groups of 1 to 20 carbon atoms, alkenyl groups of 2 to 20 carbon atoms, alkynyl groups of 2 to 20 carbon atoms, aryl groups of 6 to 20 carbon atoms and heteroaryl groups of 2 to 20 carbon atoms in formulas (S1) to (S3) are exemplified in the same way as above.

The number of carbon atoms on the alkyl groups, alkenyl groups and alkynyl groups in R and R' is preferably 10 or less, more preferably 6 or less, and even more preferably 4 or less.

The number of carbon atoms on the aryl groups and heteroaryl groups is preferably 14 or less, more preferably 10 or less, and even more preferably 6 or less.

R is preferably an alkyl group of 1 to 20 carbon atoms or alkenyl group of 2 to 20 carbon atoms which may be substituted with Z⁶, or an aryl group of 6 to 20 carbon atoms which may be substituted with Z⁷; more preferably an alkyl group of 1 to 6 carbon atoms or alkenyl group of 2 to 6 carbon atoms which may be substituted with Z⁶, or a phenyl group which may be substituted with Z⁷; even more preferably an alkyl group of 1 to 4 carbon atoms which may be substituted with Z⁶ or a phenyl group which may be substituted with Z⁷; and still more preferably a methyl group or ethyl group which may be substituted with Z⁶.

R' is preferably an alkyl group of 1 to 20 carbon atoms which may be substituted with Z⁸ or an aryl group of 6 to 20 carbon atoms which may be substituted with Z⁹; more preferably an alkyl group of 1 to 10 carbon atoms which may be substituted with Z⁸ or an aryl group of 6 to 14 carbon atoms which may be substituted with Z⁹; even more preferably an alkyl group of 1 to 6 carbon atoms which may be substituted with Z⁸ or an aryl group of 6 to 10 carbon atoms which may be substituted with Z⁹, and still more preferably an alkyl group of 1 to 4 carbon atoms which may be substituted with Z⁸ or a phenyl group which may be substituted with Z⁹.

When there are a plurality of R groups, they may all be the same or may differ. When there are a plurality of R' groups, they may all be the same or may differ.

Z⁶ is preferably a halogen atom or an aryl group of 6 to 20 carbon atoms which may be substituted with Z¹⁰, more preferably a fluorine atom or a phenyl group which may be substituted with Z¹⁰, and most preferably does not exist (i.e., is non-substituting).

Z⁷ is preferably a halogen atom or an alkyl group of 6 to 20 carbon atoms which may be substituted with Z¹⁰, more preferably a fluorine atom or an alkyl group of 1 to 10 carbon atoms which may be substituted with Z¹⁰, and most preferably does not exist (i.e., is non-substituting).

Z⁸ is preferably a halogen atom, a phenyl group which may be substituted with Z¹⁰, a furanyl group which may be substituted with Z¹⁰, an epoxycyclohexyl group, a glycidoxy group, a methacryloxy group, an acryloxy group, a ureido group, a thiol group, an isocyanate group, an amino group, a phenylamino group which may be substituted with Z¹⁰, or a diphenylamino group which may be substituted with Z¹⁰; more preferably a halogen atom; and even more preferably a fluorine atom or does not exist (i.e., is non-substituting).

Z⁹ is preferably a halogen atom, an alkyl group of 1 to 20 carbon atoms which may be substituted with Z¹⁰, a furanyl group which may be substituted with Z¹⁰, an epoxycyclohexyl group, a glycidoxy group, a methacryloxy group, an acryloxy group, a ureido group, a thiol group, an isocyanate group, an amino group, a phenylamino group which may be substituted with Z¹⁰, or a diphenylamino group which may be substituted with Z¹⁰; more preferably a halogen atom; and even more preferably a fluorine atom or does not exist (i.e., is non-substituting).

Z¹⁰ is preferably a halogen atom, and more preferably a fluorine atom or does not exist (i.e., is non-substituting).

Examples of organosilane compounds that may be used in this invention include, but are not limited to, the following.

Specific examples of dialkoxysilane compounds include dimethyldimethoxysilane, dimethyldiethoxysilane, methylethyldimethoxysilane, diethyldimethoxysilane, diethyldiethoxysilane, methylpropyldimethoxysilane, methylpropyldiethoxysilane, diisopropyldimethoxysilane, phenylmethyldimethoxysilane, vinylmethyldimethoxysilane, 3-glycidoxypropylmethyldimethoxysilane, 3-glycidoxypropylmethyldiethoxysilane, 3-(3,4-epoxycyclohexyl)ethylmethyldimethoxysilane, 3-methacryloxypropylmethyldimethoxysilane, 3-methacryloxypropylmethyldiethoxysilane, 3-mercaptopropylmethyldimethoxysilane, γ-aminopropylmethyldiethoxysilane, N-(2-aminoethyl)aminopropylmethyldimethoxysilane and 3,3,3-trifluoropropylmethyldimethoxysilane.

Specific examples of trialkoxysilane compounds include methyltrimethoxysilane, methyltriethoxysilane, ethyltrimethoxysilane, ethyltriethoxysilane, propyltrimethoxysilane, propyltriethoxysilane, butyltrimethoxysilane, butyltriethoxysilane, pentyltrimethoxysilane, pentyltriethoxysilane, heptyltrimethoxysilane, heptyltriethoxysilane, octyltrimethoxysilane, octyltriethoxysilane, dodecyltrimethoxysilane, dodecyltriethoxysilane, hexadecyltrimethoxysilane, hexadecyltriethoxysilane, octadecyltrimethoxysilane, octadecyltriethoxysilane, phenyltrimethoxysilane, phenyltriethoxysilane, vinyltrimethoxysilane, vinyltriethoxysilane, γ-aminopropyltrimethoxysilane, 3 -aminopropyltriethoxysilane, γ-glycidoxypropyltrimethoxysilane, 3-glycidoxypropyltriethoxysilane, γ-methacryloxypropyltrimethoxysilane, γ-methacryloxypropyltriethoxysilane, triethoxy(4-trifluoromethyl)phenyl)silane, dodecyltriethoxysilane, 3,3,3-trifluoropropyltrimethoxysilane, (triethoxysilyl)cyclohexane, perfluorooctylethyltriethoxysilane, triethoxyfluorosilane, tridecafluoro-1,1,2,2-tetrahydrooctyltriethoxysilane, pentafluorophenyltrimethoxysilane, pentafluorophenyltriethoxysilane,3-(heptafluoroisopropoxy)propyltriethoxysilane, heptadecafluoro-1,1,2,2-tetrahydrodecyltriethoxysilane, triethoxy-2-thienylsilane and 3-(triethoxysilyl)furan.

Specific examples of tetraalkoxysilane compounds include tetraethoxysilane, tetramethoxysilane and tetrapropoxysilane,

Of these, 3,3,3-trifluoropropylmethyldimethoxysilane, triethoxy(4-(trifluoromethyl)phenyl)silane, 3,3,3-trifluoropropyltrimethoxysilane, perfluorooctylethyltriethoxysilane, pentafluorophenyltrimethoxysilane and pentafluorophenyltriethoxysilane are preferred.

When the charge-transporting varnish of the invention includes an organosilane compound, the content thereof, based on the weight of the charge-transporting substance (in cases where a dopant substance is included, the combined weight of the charge-transporting substance and the dopant substance), is generally from about 0.1 to about 50 wt%. However, to suppress a decrease in charge transportability of the resulting thin film and also increase the ability to inject holes into a layer that is deposited on the above-described cathode side so as to be in contact with, e.g., the hole-injecting layer consisting of the thin film obtained from this varnish, the content is preferably from about 0.5 to about 40 wt%, more preferably from about 0.8 to about 30 wt%, and even more preferably from about 1 to about 20 wt%.

The viscosity of the inventive varnish, which is set as appropriate for the thickness and other properties of the thin film to be produced and the solids concentration, is generally from 1 to 50 mPa·s at 25°C. The surface tension is generally from 20 to 50 mN/m.

The solids concentration of the charge-transporting varnish, which is set as appropriate based on such considerations as the viscosity and surface tension of the varnish and the thickness of the thin film to be produced, is generally from about 0.1 to about 10.0 wt%. To improve the coating properties of the varnish, the solids concentration is preferably from about 0.5 to about 5.0 wt%, and more preferably from about 1.0 to about 3.0 wt%.

The method of preparing the varnish is not particularly limited. Examples include the method of first dissolving the onium borate salt in a solvent and then adding thereto the charge-transporting substance, and the method of dissolving a mixture of the onium borate salt and charge-transporting substance in a solvent.

Alternatively, in cases where there are a plurality of organic solvents, first the onium borate salt and the charge-transporting substance may be dissolved in a solvent that dissolves these well and the other solvents may be added thereto, or the onium borate salt and the charge-transporting substance may be dissolved successively in a mixed solvent of the plurality of organic solvents or may be dissolved therein at the same time.

In this invention, from the standpoint of reproducibly obtaining thin films having a high flatness, it is desirable for the charge-transporting varnish to be obtained by dissolving the onium borate salt, the charge-transporting substance and other ingredients in the organic solvent and subsequently filtering the solution using a submicron-order filter or the like.

The charge-transporting thin film of the invention can be formed on a substrate by applying the above-described charge-transporting varnish of the invention onto the substrate and then baking the applied varnish.

Examples of the method for applying the varnish include, but are not particularly limited to, dipping, spin coating, transfer printing, roll coating, brush coating, inkjet coating, spraying and slit coating. It is preferable to adjust the viscosity and surface tension of the varnish according to the method of application.

When using the varnish of the invention, the baking atmosphere is not particularly limited. A thin film having a uniform film surface and high charge transportability can be obtained not only in an open-air atmosphere, but even in an inert gas such as nitrogen or in a vacuum. However, depending on the type of charge-transporting compound, etc., a method that involves baking the varnish in an open-air atmosphere sometimes enables thin films having a higher charge transportability to be reproducibly obtained.

The baking temperature is suitably set in the range of about 100 to 260°C while taking into account such factors as the intended use of the resulting thin film, the degree of charge transportability to be imparted to the thin film, and the type and boiling point of the solvent. When the thin film thus obtained is to be used as a hole-injecting layer in an organic EL device, the baking temperature is preferably between about 140°C and about 250°C, and more preferably between about 145°C and about 240°C.

During baking, a temperature change in two or more steps may be applied for such purposes as to achieve more uniform film formability or to induce the reaction to proceed on the substrate. Heating may be carried out using a suitable apparatus such as a hot plate or an oven.

The thickness of the charge-transporting thin film is not particularly limited. However, when the thin film is to be used as a hole-injecting layer, hole-transporting layer or hole injecting-and-transporting layer in an organic EL device, a film thickness of from 5 to 200 nm is preferred. Methods for changing the film thickness include, for example, changing the solids concentration in the varnish and changing the amount of solution on the substrate during coating.

The organic EL device of the invention has a pair of electrodes and additionally has, between these electrodes, the above-described charge-transporting thin film of the invention.

Typical organic EL device configurations include, but are not limited to, configurations (a) to (f) below. In these configurations, where necessary, an electron-blocking layer or the like may be provided between the light-emitting layer and the anode, and a hole-blocking layer or the like may be provided between the light-emitting layer and the cathode. Alternatively, the hole-injecting layer, hole-transporting layer or hole-injecting-and-transporting layer may also have the function of, for example, an electron-blocking layer; and the electron-injecting layer, electron-transporting layer or electron-injecting-and-transporting layer may also have the function of, for example, a hole-blocking layer.
(a) anode/hole-injecting layer/hole-transporting layer/light-emitting layer/electron-transporting layer/electron-injecting layer/cathode
(b) anode/hole-injecting layer/hole-transporting layer/light-emitting layer/electron-inj ecting-and-transporting layer/cathode
(c) anode/hole-injecting-and-transporting layer/light-emitting layer/electron-transporting layer/electron-inj ecting layer/cathode
(d) anode/hole-injecting-and-transporting layer/light-emitting layer/electron-injecting-and-transporting layer/cathode
(e) anode/hole-injecting layer/hole-transporting layer/light-emitting layer/cathode
(f) anode/hole-injecting-and-transporting layer/light-emitting layer/cathode

As used herein, "hole-injecting layer," "hole-transporting layer" and "hole-injecting-and-transporting layer" refer to layers which are formed between the light-emitting layer and the anode and which have the function of transporting holes from the anode to the light-emitting layer. When only one layer of hole-transporting material is provided between the light-emitting layer and the anode, this is a "hole-injecting-and-transporting layer"; when two or more layers of hole-transporting material are provided between the light-emitting layer and the anode, the layer that is closer to the anode is a "hole-injecting layer". and the other layer is a "hole-transporting layer." In particular, a thin film having not only an excellent ability to accept holes from the anode but also an excellent ability to inject holes into the hole-transporting (light-emitting) layer may be used as the hole-injecting (transporting) layer.

In addition, "electron-injecting layer," "electron-transporting layer" and "electron-injecting-and-transporting layer" refer to layers which are formed between the light-emitting layer and the cathode and which have the function of transporting electrons from the cathode to the light-emitting layer. When only one layer of electron-transporting material is provided between the light-emitting layer and the cathode, this is an "electron-injecting-and-transporting layer"; when two or more layers of electron-transporting material are provided between the light-emitting layer and the cathode, the layer that is closer to the cathode is an "electron-injecting layer" and the other layer is an "electron-transporting layer."

The "light-emitting layer" is an organic layer having a light-emitting function. When a doping system is used, this layer includes a host material and a dopant material. The function of the host material is primarily to promote the recombination of electrons and holes and to confine the resulting excitons within the light-emitting layer. The function of the dopant material is to cause the excitons obtained by recombination to efficiently luminesce. In the case of phosphorescent devices, the host material functions primarily to confine within the light-emitting layer the excitons generated by the dopant.

The charge-transporting thin film of the invention can be suitably used as the hole-injecting layer, hole-transporting layer or hole injecting-and-transporting layer in an organic EL device, and can be more suitably used as the hole-injecting layer.

The materials and method employed to fabricate an organic EL device using the charge-transporting varnish of the invention are exemplified by, but not limited to, those described below.

The electrode substrate to be used is preferably cleaned beforehand by liquid washing with, for example, a cleaning agent, alcohol or pure water. For example, when the substrate is an anode substrate, it is preferably subjected to surface treatment such as UV/ozone treatment or oxygen-plasma treatment just prior to use. However, surface treatment need not be carried out in cases where the anode material is composed primarily of organic substances.

An example of a method for producing an organic EL device in which a thin-film obtained from the charge-transporting varnish of the invention serves as the hole-injecting layer is described below.

Using the above-described method, a hole-injecting layer is formed on an electrode by applying the charge-transporting varnish of the invention onto an anode substrate and then baking the applied composition.

A hole-transporting layer, light-emitting layer, electron-transporting layer, electron-injecting layer and cathode are provided in this order on the hole-injecting layer. The hole-transporting layer, light-emitting layer, electron-transporting layer and electron-injecting layer may be formed by either a vapor deposition process or a coating process (wet process), depending on the properties of the material used.

Illustrative examples of anode materials include transparent electrodes such as indium-tin oxide (ITO) and indium-zinc oxide (IZO), and metal anodes made of a metal such as aluminum or an alloy of such a metal. An anode material on which planarizing treatment has been carried out is preferred. Use can also be made of polythiophene derivatives and polyaniline derivatives having a high charge transportability.

Examples of other metals that may make up the metal anode include, but are not limited to, scandium, titanium, vanadium, chromium, manganese, iron, cobalt, nickel, copper, zinc, gallium, yttrium, zirconium, niobium, molybdenum, ruthenium, rhodium, palladium, cadmium, indium, lanthanum, cerium, praseodymium, neodymium, promethium, samarium, europium, gadolinium, terbium, dysprosium, holmium, erbium, thulium, ytterbium, hafnium, thallium, tungsten, rhenium, osmium, iridium, platinum, gold, titanium, lead, bismuth, and alloys thereof.

Specific examples of hole-transporting layer-forming materials include the following hole-transporting low-molecular-weight materials: triarylamines such as (triphenylamine) dimer derivatives, [(triphenylamine) dimer] spirodimer, N,N'-bis(naphthalen-1-yl)-N,N'-bis(phenyl)benzidine (α-NPD), N,N'-bis(naphthalen-2-yl)-N,N'-bis(phenyl)benzidine, N,N'-bis(3-methylphenyl)-N,N'-bis(phenyl)benzidine, N,N'-bis(3-methylphenyl)-N,N'-bis(phenyl)-9,9-spirobifluorene, N,N'-bis(naphthalen-1-yl)-N,N'-bis(phenyl)-9,9-spirobifluorene, N,N'-bis(3-methylphenyl)-N,N'-bis(phenyl)-9,9-dimethylfluorene, N,N'-bis(naphthalen-1-yl)-N,N'-bis(phenyl)-9,9-dimethylfluorene, N,N'-bis(3-methylphenyl)-N,N'-bis(phenyl)-9,9-diphenylfluorene, N,N'-bis(naphthalen-1-yl)-N,N'-bis(phenyl)-9,9-diphenylfluorene, N,N'-bis(naphthalen-1-yl)-N,N'-bis(phenyl)-2,2'-dimethylbenzidine, 2,2',7,7'-tetrakis(N,N-diphenylamino)-9,9-spirobifluorene, 9,9-bis[4-(N,N-bis-biphenyl-4-ylamino)phenyl]-9H-fluorene, 9,9-bis[4-(N,N-bisnaphthalen-2-ylamino)phenyl]-9H-fluorene, 9,9-bis[4-(N-naphthalen-1-yl-N-phenylamino)phenyl]-9H-fluorene, 2,2',7,7'-tetrakis[N-naphthalenyl(phenyl)amino]-9,9-spirobifluorene, N,N'-bis(phenanthren-9-yl)-N,N'-bis(phenyl)benzidine, 2,2'-bis[N,N-bis(biphenyl-4-yl)amino]-9,9-spirobifluorene, 2,2'-bis(N,N-diphenylamino)-9,9-spirobifluorene, di[4-(N,N-di(p-tolyl)amino)phenyl]cyclohexane, 2,2',7,7'-tetra(N,N-di(p-tolyl))amino-9,9-spirobifluorene, N,N,N',N'-tetra-naphthalen-2-yl-benzidine,
N,N,N',N'-tetra(3-methylphenyl)-3,3'-dimethylbenzidine, N,N'-di(naphthalenyl)-N,N'-di(naphthalen-2-yl)benzidine, N,N,N',N'-tetra(naphthalenyl)benzidine,
N,N'-di(naphthalen-2-yl)-N,N'-diphenylbenzidine-1-4-diamine, N¹,N⁴-diphenyl-N¹,N⁴-di(m-tolyl)benzene-1,4-diamine, N²N²,N⁶,N⁶-tetraphenylnaphthalene-2,6-diamine, tris(4-(quinolin-8-yl)phenyl)amine, 2,2'-bis(3-(N,N-di(p-tolyl)amino)phenyl)biphenyl,
4,4',4"-tris[3-methylphenyl(phenyl)amino]triphenylamine (m-MTDATA) and 4,4',4"-tris[1-naphthyl(phenyl)amino]triphenylamine (1-TNATA); and oligothiophenes such as 5,5"-bis-{4-[bis(4-methylphenyl)amino]phenyl}-2,2':5',2"-terthiophene (BMA-3T).

Specific examples of light-emitting layer-forming materials include tris(8-quinolinolate) aluminum(III) (Alq₃), bis(8-quinolinolate) zinc(II) (Znq₂), bis(2-methyl-8-quinolinolate)-4-(p-phenylphenolate) aluminum(III) (BAlq), 4,4'-bis(2,2-diphenylvinyl)biphenyl, 9,10-di(naphthalen-2-yl)anthracene, 2-t-butyl-9,10-di(naphthalen-2-yl)anthracene,
2,7-bis[9,9-di(4-mcthylphenyl)-fluoren-2-yl]-9,9-di(4-methylphenyl)fluorene, 2-methyl-9,10-bis(naphthalen-2-yl)anthracene, 2-(9,9-spirobifluoren-2-yl)-9,9-spirobifluorene, 2,7-bis(9,9-spirobifluoren-2-yl)-9,9-spirobifluorene,
2-[9,9-di(4-methylphenyl)-fluoren-2-yl]-9,9-di(4-methylphenyl)fluorene, 2,2'-dipyrenyl-9,9-spirobifluorene, 1,3,5-tris(pyren-1-yl)benzene, 9,9-bis[4-(pyrenyl)phenyl]-9H-fluorene, 2,2'-bi(9,10-diphenylanthracene), 2,7-dipyrenyl-9,9-spirobifluorene, 1,4-di(pyren-1-yl)benzene, 1,3-di(pyren-1-yl)benzene, 6,13-di(biphenyl-4-yl)pentacene, 3,9-di(naphthalen-2-yl)perylene, 3,10-di(naphthalen-2-yl)perylene, tris[4-(pyrenyl)-phenyl]amine, 10,10'-di(biphenyl-4-yl)-9,9'-bianthracene,
N,N'-di(naphthalen-1-yl)-N,N'-diphenyl[1,1':4',1":4",1"'-quaterphenyl]-4,4"'-diamine, 4,4'-di[10-(naphthalen-1-yl)anthracen-9-yl]biphenyl,
dibenzo{[f,f']-4,4',7,7'-tetraphenyl}diindeno[1,2,3-cd:1',2',3'-lm]perylene, 1-(7-(9,9'-bianthracen-10-yl)-9,9-dimethyl-9H-fluoren-2-yl)pyrene, 1-(7-(9,9'-bianthracen-10-yl)-9,9-dihexyl-9H-fluoren-2-yl)pyrene, 1,3-bis(carbazol-9-yl)benzene, 1,3,5-tris(carbazol-9-yl)benzene, 4,4',4"-tris(carbazol-9-yl)triphenylamine, 4,4'-bis(carbazol-9-yl)biphenyl (CBP), 4,4'-bis(carbazol-9-yl)-2,2'-dimethylbiphenyl, 2,7-bis(carbazol-9-yl)-9,9-dimethylfluorene, 2,2',7,7'-tetrakis(carbazol-9-yl)-9,9-spirobifluorene,
2,7-bis(carbazol-9-yl)-9,9-di(p-tolyl)fluorene, 9,9-bis[4-(carbazol-9-yl)-phenyl]fluorene, 2,7-bis(carbazol-9-yl)-9,9-spirobifluorene, 1,4-bis(triphenylsilyl)benzene, 1,3-bis(triphenylsilyl)benzene,
bis(4-N,N-diethylamino-2-methylphenyl)-4-methylphenylmethane, 2,7-bis(carbazol-9-yl)-9,9-dioctylfluorene, 4,4"-di(triphenylsilyl)-p-terphenyl, 4,4'-di(triphenylsilyl)biphenyl, 9-(4-t-butylphenyl)-3,6-bis(triphenylsilyl)-9H-carbazole, 9-(4-t-butylphenyl)-3,6-ditrityl-9H-carbazole, 9-(4-t-butylphenyl)-3,6-bis(9-(4-methoxyphenyl)-9H-fluoren-9-yl)-9H-carbazole, 2,6-bis(3-(9H-carbazol-9-yl)phenyl)pyridine, triphenyl(4-(9-phenyl-9H-fluoren-9-yl)phenyl)silane, 9,9-dimethyl-N,N-diphenyl-7-(4-(1-phenyl-1H-benzo[d]imidazol-2-yl)phenyl-9H-fluoren-2-amine,
3,5-bis(3-(9H-carbazol-9-yl)phenyl)pyridine, 9,9-spirobifluoren-2-yl-diphenyl-phosphine oxide, 9,9'-(5-triphenylsilyl)-1,3-phenylene)bis(9H-carbazole), 3-(2,7-bis(diphenylphosphoryl)-9-phenyl-9H-fluoren-9-yl)-9-phenyl-9H-carbazole, 4,4,8,8,12,12-hexa(p-tolyl)-4H-8H-12H-12C-azadibenzo[cd,nm]pyrene, 4,7-di(9H-carbazol-9-yl)-1,10-phenanthroline, 2,2'-bis(4-(carbazol-9-yl)phenyl)biphenyl, 2,8-bis(diphenylphosphoryl)dibenzo[b,d]thiophene, bis(2-methylphenyl)diphenylsilane, bis[3,5-di(9H-carbazol-9-yl)phenyl]diphenylsilane,
3,6-bis(carbazol-9-yl)-9-(2-ethylhexyl)-9H-carbazole,
3-(diphenylphosphoryl)-9-(4-(diphenylphosphoryl)phenyl)-9H-carbazole and 3,6-bis[(3,5-diphenyl)phenyl]-9-phenylcarbazole. The light-emitting layer may be formed by co-vapor deposition with a light-emitting dopant.

Specific examples of light-emitting dopants include 3-(2-benzothiazolyl)-7-(diethylamino)coumarin,
2,3,6,7-tetrahydro-1,1,7,7-tetramethyl-1H,5H,11H-10-(2-benzothiazolyl)quinolidino-[9,9a,1gh]coumarin,
quinacridone, N,N'-dimethylquinacridone, tris(2-phenylpyridine) iridium(III) (Ir(ppy)₃), bis(2-phenylpyridine)(acetylacetonate) iridium(III) (Ir(ppy)₂(acac)), tris[2-(p-tolyl]pyridine) iridium(III) (Ir(mppy)₃), 9,10-bis[N,N-di(p-tolyl)amino]anthracene, 9,10-bis[phenyl(m-tolyl)amino]anthracene, bis[2-(2-hydroxyphenyl)benzothiazolate] zinc(II), N¹⁰,N¹⁰,N^{10'},N^{10'}-tetra(p-tolyl)-9,9'-bianthracene-10,10'-diamine, N¹⁰,N¹⁰,N^{10'},N^{10'}-tetraphenyl-9,9'-bianthracene-10,10'-diamine, N¹⁰,N^{10'}-diphenyl-N¹⁰,N^{10'}-dinaphthalenyl-9,9'-bianthracene-10,10'-diamine, 4,4'-bis(9-ethyl-3-carbazovinylene)-1,1'-biphenyl, perylene, 2,5,8,11-tetra-t-butylperylene, 1,4-bis[2-(3-N-ethylcarbazolyl)vinyl]benzene,4,4'-bis[4-(di-p-totylamino)styryl]biphenyl, 4-(di-p-tolylamino)-4'-[(di-p-tolylamino)styryl]stilbene, bis[3,5-difluoro-2-(2-pyridyl)phenyl-(2-carboxypyridyl)] iridium(III), 4,4'-bis[4-(diphenylamino)styryl]biphenyl, bis(2,4-difluorophenylpyridinato)tetrakis(1-pyrazolyl)borate iridium(III), N,N'-bis(naphthalen-2-yl)-N,N'-bis(phenyl)-tris(9,9-dimethylfluorenylene), 2,7-bis{2-[phenyl(m-tolyl)amino]-9,9-dimethylfluoren-7-yl}-9,9-dimethylfluorene, N-(4-((E)-2-(6((E)-4-(diphenylamino)styryl)naphthalen-2-yl)vinyl)phenyl)-N-phenylbenzenamine,
fac-iridium(III) tris(1-phenyl-3-methylbenzimidazolin-2-ylidene-C,C^{2'}), mer-iridium(III) tris(1-phenyl-3-methylbenzimidazolin-2-ylidene-C,C^{2'}), 2,7-bis[4-(diphenylamino)styryl]-9,9-spirobifluorene, 6-methyl-2-(4-(9-(4-(6-methylbenzo[d]thiazol-2-yl)phenyl)anthracen-10-yl)phenyl)-benzo[d]thiazole,
1,4-di[4-(N,N-diphenyl)amino]styrylbenzene, 1,4-bis(4-(9H-carbazol-9-yl)styryl)benzene, (E)-6-(4-(diphenylamino)styryl)-N,N-diphenylnaphthalen-2-amine, bis(2,4-difluorophenylpyridinato)(5-(pyridin-2-yl)-1H-tetrazolate) iridium(III), bis(3-trifluoromethyl-5-(2-pyridyl)pyrazole)((2,4-difluorobenzyl)diphenylphosphinate) iridium(III),
bis(3-trifluoromethyl-5-(2-pyridyl)pyrazolate)(benzyldiphenylphosphinate) iridium(III), bis(1-(2,4-difluorobenzyl)-3-methylbenzimidazolium)(3-(trifluoromethyl)-5-(2-pyridyl)-1,2,4-triazolate) iridium(III),
bis(3-trifluoromethyl-5-(2-pyridyl)pyrazolate)(4',6'-difluorophenylpyridinate) iridium(III), bis(4',6'-difluorophenylpyridinato)(3,5-bis(trifluoromethyl)-2-(2'-pyridyl)pyrrolate) iridium(III),
bis(4',6'-difluorophenylpyridinato)(3-(trifluoromethyl)-5-(2-pyridyl)-1,2,4-triazolate) iridium (III), (Z)-6-mesityl-N-(6-mesitylquinolin-2(1H)-ylidene)quinoline-2-amine-BF₂, (E)-2-(2-(4-(dimethylamino)styryl)-6-methyl-4H-pyran-4-ylidene)malononitrile, 4-(dicyanomethylene)-2-methyl-6-julolidyl-9-enyl-4H-pyran, 4-(dicyanomethylene)-2-methyl-6-(1,1,7,7-tetramethyljulolidyl-9-enyl)-4H-pyran, 4-(dicyanomethylene)-2-t-butyl-6-(1,1,7,7-tetramethyljulolidin-4-ylvinyl)-4H-pyran, tris(dibenzoylmethane)phenanthroline europium(III), 5,6,11,12-tetraphenylnaphthacene, bis(2-benzo[b]thiophen-2-yl-pyridine)(acetylacetonate) iridium(III), tris(1-phenylisoquinoline) iridium(III),
bis(1-phenylisoquinoline)(acetylacetonate) iridium(III), bis[1-(9,9-dimethyl-9H-fluoren-2-yl)isoquinoline](acetylacetonate) iridium(III), bis[2-(9,9-dimethyl-9H-fluoren-2-yl)quinoline](acetylacetonate) iridium(III), tris[4,4'-di-t-butyl-(2,2')-bipyridine]ruthenium(III)·bis(hexafluorophosphate), tris(2-phenylquinoline) iridium(III), bis(2-phenylquinoline)(acetylacetonate) iridium(III), 2,8-di-t-butyl-5,11-bis(4-t-butylphenyl)-6,12-diphenyltetracene, bis(2-phenylbenzothiazolate)(acetylacetonate) iridium(III), platinum 5,10,15,20-tetraphenyltetrabenzoporphyrin,
osmium(II) bis(3-trifluoromethyl-5-(2-pyridine)pyrazolate)dimethylphenylphosphine, osmium(II) bis(3-trifluoromethyl)-5-(4-t-butylpyridyl)-1,2,4-triazolate)diphenylmethyl-phosphine,

osmium(II) bis(3-(trifluoromethyl)-5-(2-pyridyl)-1,2,4-triazole)dimethylphenylphosphine, osmium(II) bis(3-(trifluoromethyl)-5-(4-t-butylpyridyl)-1,2,4-triazolate)dimethylphenyl-phosphine,
bis[2-(4-n-hexylphenyl)quinoline](acetylacetonate) iridium(III), tris[2-(4-n-hexylphenyl)quinoline] iridium(III), tris[2-phenyl-4-methylquinoline] iridium(III), bis(2-phenylquinoline)(2-(3-methylphenyl)pyridinate) iridium(III), bis(2-(9,9-diethylfluoren-2-yl)-1-phenyl-1H-benzo[d]imidazolato)(acetylacetonate) iridium(III),
bis(2-phenylpyridine)(3-(pyridin-2-yl)-2H-chromen-9-onate) iridium(III), bis(2-phenylquinoline)(2,2,6,6-tetramethylheptane-3,5-dionate) iridium(III), bis(phenylisoquinoline)(2,2,6,6-tetramethylheptane-3,5-dionate) iridium(III), iridium(III) bis(4-phenylthieno[3,2-c]pyridinato-N,C^{2'})acetylacetonate, (E)-2-(2-t-butyl-6-(2-(2,6,6-trimethyl-2,4,5,6-tetrahydro-1H-pyrrolo[3,2,1-ij]quinolin-8-yl)vinyl)-4H-pyran-4-ylidene)malononitrile,
bis(3-trifluoromethyl-5-(1-isoquinolyl)pyrazolate)(methyldiphenylphosphine)ruthenium, bis[(4-n-hexylphenyl)isoquinoline](acetylacetonate) iridium(III), platinum(II) octaethylporphin,
bis(2-methyldibenzo[f,h]quinoxaline)(acetylacetonate) iridium(III) and tris[(4-n-hexylphenyl)isoquinoline] iridium(III).

Specific examples of electron-transporting layer-forming materials include lithium 8-hydroxyquinolinate,
2,2',2"-(1,3,5-benzinetriyl)-tris(1-phenyl-1-H-benzimidazole), 2-(4-biphenyl)-5-(4-t-butylphenyl)-1,3,4-oxadiazole, 2,9-dimethyl-4,7-diphenyl-1,10-phenanthroline, 4,7-diphenyl-1,10-phenanthroline, bis(2-methyl-8-quinolinolate)-4-(phenylphenolato)aluminum, 1,3-bis[2-(2,2'-bipyridin-6-yl)-1,3,4-oxadiazo-5-yl]benzene, 6,6'-bis[5-(biphenyl-4-yl)-1,3,4-oxadiazo-2-yl]-2,2'-bipyridine, 3-(4-biphenyl)-4-phenyl-5-t-butylphenyl-1,2,4-triazole, 4-(naphthalen-1-yl)-3,5-diphenyl-4H-1,2,4-triazole,
2,9-bis(naphthalen-2-yl)-4,7-diphenyl-1,10-phenanthroline, 2,7-bis[2-(2,2'-bipyridin-6-yl)-1,3,4-oxadiazo-5-yl]-9,9-dimethylfluorene, 1,3-bis[2-(4-t-butylphenyl)-1,3,4-oxadiazo-5-yl]benzene, tris(2,4,6-trimethyl-3-(pyridin-3-yl)phenyl)borane,
1-methyl-2-(4-(naphthalen-2-yl)phenyl)-1H-imidazo[4,5f][1,10]phenanthroline, 2-(naphthalen-2-yl)-4,7-diphenyl-1,10-phenanthroline, phenyldipyrenylphosphine oxide, 3,3' ,5,5 '-tetra[(m-pyridyl)-phen-3-yl]biphenyl, 1,3 ,5-tris[(3-pyridyl)-phen-3-yl]benzene, 4,4'-bis(4,6-diphenyl-1,3,5-triazin-2-yl)biphenyl, 1,3-bis[3,5-di(pyridin-3-yl)phenyl]benzene, bis(10-hydroxybenzo[h]quinolinato)beryllium, diphenylbis(4-(pyridin-3-yl)phenyl)silane and 3,5-di(pyren-1-yl)pyridine.

Examples of electron-injecting layer-forming materials include lithium oxide (Li₂O), magnesium oxide (MgO), alumina (Al₂O₃), lithium fluoride (LiF), sodium fluoride (NaF), magnesium fluoride (MgF₂), cesium fluoride (CsF), strontium fluoride (SrF₂), molybdenum trioxide (MoO₃), aluminum, Li(acac), lithium acetate and lithium benzoate.

Examples of cathode materials include aluminum, magnesium-silver alloys, aluminum-lithium alloys, lithium, sodium, potassium and cesium.

Another example is described below of a method for producing an organic EL device having a hole-injecting layer made of a thin film obtained from the charge-transporting varnish of the invention.

An organic EL device having a charge-transporting thin film formed with the charge-transporting varnish of the invention can be produced by, in the EL device production method described above, successively forming a hole-transporting layer (referred to below as a "hole-transporting polymer layer") and a light-emitting layer (referred to below as a "light-emitting polymer layer") instead of carrying out vacuum evaporation operations for a hole-transporting layer, a light-emitting layer, an electron-transporting layer and an electron-injecting layer.

Specifically, the charge-transporting varnish of the invention is applied onto an anode substrate, and a hole-injecting layer is formed by the above-described method. A hole-transporting polymer layer and a light-emitting polymer layer are then successively formed thereon, following which a cathode material is vapor-deposited on top, thereby giving an organic EL device.

The cathode and anode materials used here may be similar to those described above, and similar cleaning treatment and surface treatment may be carried out.

The method of forming the hole-transporting polymer layer and the light-emitting polymer layer is exemplified by a film-forming method that involves adding a solvent to a hole-transporting polymer material or a light-emitting polymer material, or to the material obtained by adding a dopant substance to either of these, thereby dissolving or uniformly dispersing the material, and then applying the solution or dispersion onto the hole-injecting layer or the hole-transporting polymer layer and subsequently baking each.

Examples of hole-transporting polymer materials include poly[(9,9-dihexylfluorenyl-2,7-diyl)-co-(N,N'-bis{p-butylphenyl}-1,4-diaminophenylene)], poly[(9,9-dioctylfluorenyl-2,7-diyl)-co-(N,N'-bis{p-butylphenyl}-1,1'-biphenylene-4,4-diamine)],
poly[(9,9-bis{1'-penten-5'-yl}fluorenyl-2,7-diyl)-co-(N,N'-bis{p-butylphenyl}-1,4-diaminophenylene)],
poly[N,N'-bis(4-butylphenyl)-N,N'-bis(phenyl)-benzidine] end-capped with polysilsesquioxane and
poly[(9,9-dioctylfluorenyl-2,7-diyl)-co-(4,4'-(N-(p-butylphenyl))diphenylamine)].

Examples of light-emitting polymer materials include polyfluorene derivatives such as poly(9,9-dialkylfluorene) (PDAF), poly(phenylene vinylene) derivatives such as poly(2-methoxy-5-(2'-ethylhexoxy)-1,4-phenylene vinylene) (MEH-PPV), polythiophene derivatives such as poly(3-alkylthiophene) (PAT), and polyvinylcarbazole (PVCz).

Examples of the solvent include toluene, xylene and chloroform. Examples of the method of dissolution or uniform dispersion include stirring, stirring under applied heat, and ultrasonic dispersion.

Examples of the method of application include, but are not particularly limited to, inkjet coating, spraying, dipping, spin coating, transfer printing, roll coating and brush coating. Application is preferably carried out in an inert gas atmosphere such as nitrogen or argon.

Examples of the baking method include methods that involve heating in an oven or on a hot plate, either within an inert gas atmosphere or in a vacuum.

An example is described below of a method for producing an EL device having a hole-transporting layer made of a thin film obtained from the charge-transporting varnish of the invention.

A hole-injecting layer is formed on an anode substrate. The hole-transporting layer is produced according to the above-described method by applying the charge-transporting varnish of the invention onto this layer, and then baking the applied layer.

A light-emitting layer, an electron-transporting layer, an electron-injecting layer and a cathode are provided in this order on the hole-transporting layer. Methods of forming the light-emitting layer, electron-transporting layer and electron-injecting layer, and specific examples of each, include the same as those mentioned above. The hole-injecting layer may be formed by a vapor deposition process or by a coating process (wet process), in accordance with the properties, etc. of the material used.

Examples of the material that forms the hole-injecting layer include copper phthalocyanine, titanium oxide phthalocyanine, platinum phthalocyanine, pyrazino[2,3-f][1,10]phenanthroline-2,3-dicarbonitrile, N,N,N' ,N' -tetrakis(4-methoxyphenyl)benzidine,
2,7-bis[N,N-bis(4-methoxyphenyl)amino]-9,9-spirobifluorene, 2,2'-bis[N,N-bis(4-methoxyphenyl)amino]-9,9-spirobifluorene, N,N'-diphenyl-N,N'-di[4-(N,N-ditolylamino)phenyl]benzidine, N,N'-diphenyl-N,N'-di[4-(N,N-diphenylamino)phenyl]benzidine, N⁴,N^{4'}-(biphenyl-4,4'-diyl)bis(N⁴,N^{4'},N^{4'}-triphenylbiphenyl-4,4'-diamine), N¹,N^{1'}-(biphenyl-4,4'-diyl)bis(N¹-phenyl-N⁴,N^{4'}-di-m-tolylbenzene-1,4-diamine), and the charge-transporting materials mentioned in WO 2004/043117, WO 2004/105446, WO 2005/000832, WO 2005/043962, WO 2005/042621, WO 2005/107335, WO 2006/006459, WO 2006/025342, WO 2006/137473, WO 2007/049631, WO 2007/099808, WO 2008/010474, WO 2008/032617, WO 2008/032616, WO 2008/129947, WO 2009/096352, WO 2010/041701, WO 2010/058777, WO 2010/058776, WO 2013/042623, WO 2013/129249, WO 2014/115865, WO 2014/132917, WO 2014/141998, and WO 2014/132834.

The anode material, the light-emitting layer, the light-emitting dopant, the materials which form the electron-transporting layer and the electron-blocking layer, and the cathode material are exemplified in the same way as above.

An example is described below of a method for producing an organic EL device having a hole-injecting-and-transporting layer made of a thin-film obtained from the charge-transporting varnish of the invention.

A hole injecting-and-transporting layer is formed on an anode substrate, and a light-emitting layer, an electron-transporting layer, an electron-injecting layer and a cathode are provided in this order on the hole injecting-and-transporting layer. Methods of forming the light-emitting layer, electron-transporting layer and electron-injecting layer, and specific examples of each, include the same as those mentioned above.

The anode material, the light-emitting layer, the light-emitting dopant, the materials which form the electron-transporting layer and the electron-blocking layer, and the cathode material are exemplified in the same way as above.

A hole-blocking layer, an electron-blocking layer or the like may be optionally provided between the electrodes and any of the above layers. By way of illustration, an example of a material that forms an electron-blocking layer is tris(phenylpyrazole)iridium.

The materials which make up the anode, the cathode and the layers formed therebetween differ according to whether a device provided with a bottom emission structure or a top emission structure is to be fabricated, and so are suitably selected while taking this into account.

Typically, in a device having a bottom emission structure, a transparent anode is used on the substrate side and light is extracted from the substrate side, whereas in a device having a top emission structure, a reflective anode made of metal is used and light is extracted from the transparent electrode (cathode) side in the opposite direction from the substrate. For example, with regard to the anode material, when fabricating a device having a bottom emission structure, a transparent anode of ITO or the like is used, and when fabricating a device having a top emission structure, a reflective anode of Al/Nd or the like is used.

To prevent deterioration of the device characteristics, the organic EL device of the invention may be sealed in the usual manner with, if necessary, a desiccant or the like.

### EXAMPLES

Working Examples and Comparative Examples are given below to more concretely illustrate the invention, although the invention is not limited by these Examples. The equipment used was as follows.
(1) ¹H-NMR and ¹⁹F-NMR:
   AL-300 nuclear magnetic resonance system, from JEOL Ltd.
(2) Substrate Cleaning:
   Substrate cleaning machine (reduced-pressure plasma system), from Choshu Industry Co., Ltd.
(3) Varnish Coating:
   MS-A100 Spin Coater, from Mikasa Co., Ltd.
(4) Film Thickness Measurement:
   Surfcorder ET-4000 microfigure measuring instrument, from Kosaka Laboratory, Ltd.
(5) Film Surface Examination:
   1LM21D Confocal Laser Microscope/Real Time Scanning Laser Microscope, from Lasertec Corporation
(6) EL Device Fabrication:
   C-E2L1G1-N Multifunction Vapor Deposition System, from Choshu Industry Co., Ltd.
(7) Measurement of EL Device Brightness:
   I-V-L Measurement System from Tech World, Inc.
(8) Measurement of EL Device Lifetime (Measurement of Brightness Half-Life):
   PEL-105S Organic EL Brightness Life Evaluation System, from EHC K.K.

### [1] Synthesis of Onium Borate Salt

### [Synthesis Example 1]

### Synthesis of (4-Phenylthiophenyl)diphenylsulfonium n-Butyltris(pentafluorophenyl)borate

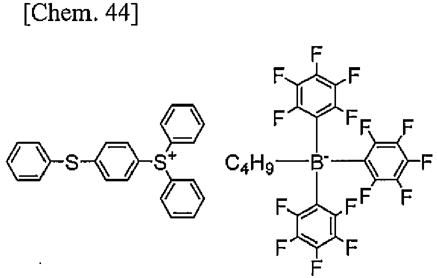

A reactor was charged with 38.1 parts by weight of tris(pentafluorophenyl)borane (Tokyo Chemical Industry Co., Ltd.) and 1,200 parts by weight of pentane, following which 38.8 parts by weight of a hexane solution (1.6M) of n-butyllithium was added dropwise under stirring and at room temperature and the reaction was effected at room temperature for 3 hours, giving a reaction mixture in the form of a slurry.

The crystals obtained by filtration of the reaction mixture were washed by pouring pentane over them and then dried in vacuo at 60°C, giving 38.1 parts by weight (yield, 89%) of lithium n-butyltris(pentafluorophenyl)borate as the intermediate.

Next, an aqueous solution of 30 parts by weight of the resulting borate dissolved in 400 parts by weight of deionized water was added to a solution of 22.5 parts by weight of (4-phenylthiophenyl)diphenylsulfonium hexafluorophosphate (San-Apro Ltd.) dissolved in 530 parts by weight of dichloromethane, and mixture was carried out for one hour under stirring. Following mixture, the system was left at rest, the aqueous layer was removed, and the dichloromethane solution was washed five times with 400 parts by weight of deionized water. The washed dichloromethane solution was desolvated under reduced pressure, thereby giving 40 parts by weight of the target substance (4-phenylthiophenyl)diphenylsulfonium n-butyltris(pentafluorophenyl)borate as a light-yellow solid (yield, 97%). The target substance thus obtained was identified by ¹H-NMR and ¹⁹F-NMR spectroscopy.

| | |
|---|---|
| ¹H-NMR (DMSO-d6) δ [ppm]: | 7.6-7.8 (12H, m), 7.4-7.5 (5H, m), 7.3 (2H, d), 1.0-1.2 (4H, m), 0.6-0.8 (5H, m) |
| ¹⁹F-NMR (DMSO-d6) δ [ppm]: | -132 (6F, d), -159.5 (3F, t), -163 (6F, t) |

### [2] Preparation of Charge-Transporting Varnish

### [Working Example 1-1]

A charge-transporting varnish was obtained by adding 5 g of xylene to a mixture of 158 mg of PCZ5 of the formula shown below synthesized according to the method described in Production Example 18 of WO 2015/050253 and 105 mg of the (4-phenylthiophenyl)diphenylsulfonium n-butyltris(pentafluorophenyl)borate obtained in Synthesis Example 1, and then stirring and dissolving at room temperature under ultrasonic irradiation so give a solution, and filtering the solution with a syringe filter having a pore size of 0.2 µm.

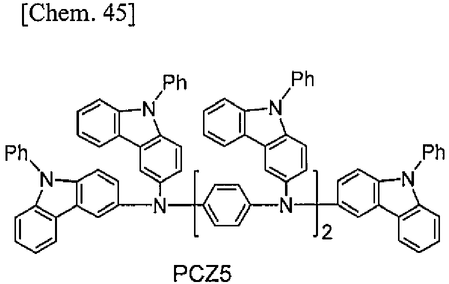

### [3] Production of Organic EL Device and Evaluation of Device Characteristics

### [Working Example 2-1]

The varnish obtained in Working Example 1-1 was coated onto an ITO substrate using a spin coater, following which it was dried for 1 minute at 80°C and also baked for 10 minutes at 150°C in an open-air atmosphere, thereby forming a uniform 100 nm thin film on the ITO substrate. A glass substrate with dimensions of 25 mm × 25 mm × 0.7 mm (t) and having indium-tin oxide (ITO) patterned on the surface to a film thickness of 150 nm was used as the ITO substrate. Prior to use, impurities on the surface were removed with an O₂ plasma cleaning system (150 W, 30 seconds).

Next, using a vapor deposition system (degree of vacuum, 1.0×10⁻⁵ Pa), 30 nm of α-NPD (N,N'-di(1-naphthyl)-N,N'-diphenylbenzidine) was deposited at a rate of 0.2 nm/s onto the ITO substrate where the thin film was formed, following which CBP and Ir(PPy)₃ were co-deposited. Co-deposition was carried out to a thickness of 40 nm while controlling the rate of deposition such that the concentration of Ir(PPy)₃ becomes 6%. Thin films of BAlq, lithium fluoride and aluminum were then successively deposited, thereby giving an organic EL device. At this time, vapor deposition was carried out at a rate of 0.2 nm/s for BAlq and aluminum, and at a rate of 0.02 nm/s for lithium fluoride. The film thicknesses were set to, respectively, 20 nm, 0.5 nm and 120 nm.

To prevent the device characteristics from deteriorating due to the influence of oxygen, moisture and the like in air, the organic EL device was sealed with sealing substrates, following which the characteristics were evaluated. Sealing was carried out by the following procedure. In a nitrogen atmosphere having an oxygen concentration of not more than 2 ppm and a dew point of not more than -85°C, the organic EL device was placed between sealing substrates and the sealing substrates were laminated together using an adhesive (XNR5516Z-B1, from Nagase ChemteX Corporation). At this time, a desiccant (HD-071010W-40, from Dynic Corporation) was placed, together with the organic EL device, within the sealing substrates. The laminated sealing substrates were irradiated with UV light (wavelength, 365 nm; dosage, 6,000 mJ/cm²), and then annealed at 80°C for 1 hour to cure the adhesive.

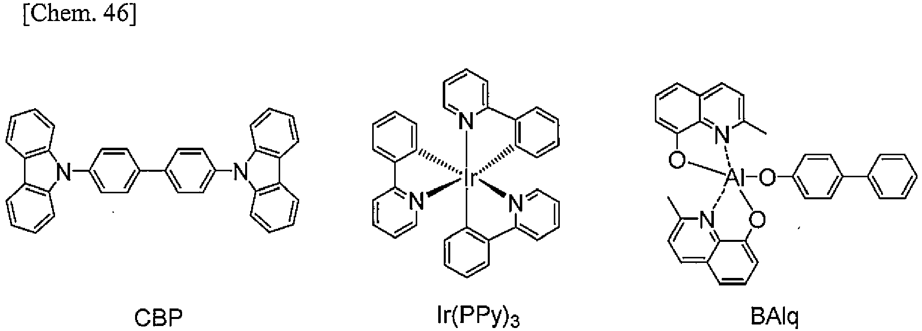

The driving voltage, current density, emission efficiency and brightness half-life (time required for the initial brightness of 5,000 cd/m² to reach one-half of this level) when the device of Working Example 2-1 was driven at a brightness of 5,000 cd/m² were measured. The results are shown in Table 19.

**[Table 19]**

| Working Example | Driving voltage (V) | Current density (mA/cm²) | Current efficiency | Half-life (hours) |
|---|---|---|---|---|
| 2-1 | 9.6 | 16.5 | 30.4 | 242 |

As is apparent from the results in Table 19, an EL device equipped with the charge-transporting thin film of the invention had good drive characteristics. The longevity characteristics were also excellent.

## Claims

1. A charge-transporting varnish comprising a charge-transporting substance, an onium borate salt and an organic solvent, **characterized in that** the onium borate salt includes an onium borate salt consisting of an anion of formula (a1) and a counter cation 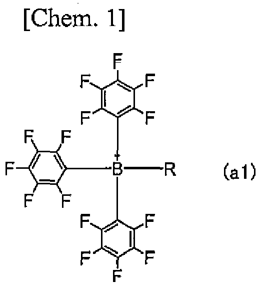 wherein R is an alkyl group of 1 to 10 carbon atoms, a fluoroalkyl group of 1 to 10 carbon atoms, an aralkyl group of 7 to 10 carbon atoms or a fluoroaralkyl group of 7 to 10 carbon atoms.

2. The charge-transporting varnish of claim 1, wherein the charge-transporting substance is at least one compound selected from the group consisting of aniline derivatives and thiophene derivatives.

3. The charge-transporting varnish of claim 2, wherein the charge-transporting substance is an aniline derivative.

4. A charge-transporting thin film produced using the charge-transporting varnish of any one of claims 1 to 3.

5. An organic electroluminescent device comprising the charge-transporting thin film of claim 4.

6. A method for producing a charge-transporting thin film, comprising the steps of applying the charge-transporting varnish of any one of claims 1 to 3 onto a substrate, and evaporating off the solvent.

## Patentansprüche

1. Ladungstransportanstrich, umfassend eine Ladungstransportsubstanz, ein Oniumboratsalz und ein organisches Lösungsmittel, **dadurch gekennzeichnet, dass** das Oniumboratsalz ein Oniumboratsalz umfasst, das aus einem Anion der Formel (a1) und einem Gegenkation besteht: 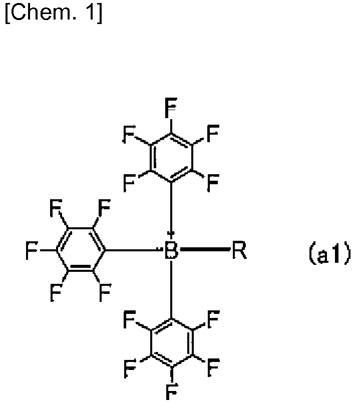 worin R eine Alkylgruppe mit 1 bis 10 Kohlenstoffatomen, eine Fluoralkylgruppe mit 1 bis 10 Kohlenstoffatomen, eine Aralkylgruppe mit 7 bis 10 Kohlenstoffatomen oder eine Fluoraralkylgruppe mit 7 bis 10 Kohlenstoffatomen ist.

2. Ladungstransportanstrich nach Anspruch 1, wobei die Ladungstransportsubstanz zumindest eine aus der aus Anilin-Derivaten und Thiophen-Derivaten bestehenden Gruppe ausgewählte Verbindung ist.

3. Ladungstransportanstrich nach Anspruch 2, wobei die Ladungstransportsubstanz ein Anilin-Derivat ist.

4. Ladungstransportdünnfilm, der unter Verwendung eines Ladungstransportanstrichs nach einem der Ansprüche 1 bis 3 hergestellt wird.

5. Organische elektrolumineszierende Vorrichtung, umfassend einen Ladungstransportdünnfilm nach Anspruch 4.

6. Verfahren zur Herstellung eines Ladungstransportdünnfilms, umfassend die Schritte des Auftragens eines Ladungstransportanstrichs nach einem der Ansprüche 1 bis 3 auf ein Substrat und des Abdampfens des Lösungsmittels.

## Revendications

1. Vernis de transport de charge comprenant une substance de transport de charge, un sel de borate d'onium et un solvant organique, **caractérisé en ce que** le sel de borate d'onium comprend un sel de borate d'onium constitué d'un anion de formule (a1) et d'un contre-cation 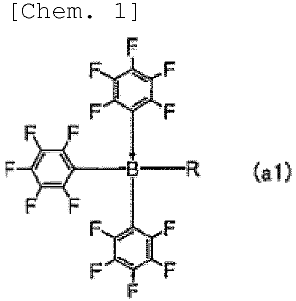 dans lequel
R est un groupe alkyle de 1 à 10 atomes de carbone, un groupe fluoroalkyle de 1 à 10 atomes de carbone, un groupe aralkyle de 7 à 10 atomes de carbone ou un groupe fluoroaralkyle de 7 à 10 atomes de carbone.

2. Vernis de transport de charge selon la revendication 1, dans lequel la substance de transport de charge est au moins un composé choisi dans le groupe constitué de dérivés d'aniline et de dérivés de thiophène.

3. Vernis de transport de charge selon la revendication 2, dans lequel la substance de transport de charge est un dérivé d'aniline.

4. Film mince de transport de charge produit en utilisant le vernis de transport de charge selon l'une quelconque des revendications 1 à 3.

5. Dispositif électroluminescent organique comprenant le film mince de transport de charge de la revendication 4.

6. Procédé de production d'un film mince de transport de charge, comprenant les étapes consistant à appliquer le vernis de transport de charge de l'une quelconque des revendications 1 à 3 sur un substrat, et à évaporer le solvant.
